# EUROPEAN PATENT SPECIFICATION

(11) **EP 4 458 835 B1**
(45) Date of publication and mention of the grant of the patent: **03.09.2025**
(21) Application number: 24158729.4
(22) Date of filing: 20.02.2024
(51) Int. Cl.: C07F 15/00, C09K 11/06, H10K 85/30

(54) **CENTRAL CHIRALITY INDUCED HELICAL CHIRAL TETRADEMTATE CYCLOMETALATED PLATINUM (II) COMPLEX, ELECTRONIC DEVICE AND APPLICATION THEREOF**
DURCH ZENTRALCHIRALITÄT INDUZIERTER HELIXFÖRMIGER CHIRALER TETRADENMTAT-CYCLOMETALLIERTER PLATIN(II)-KOMPLEX, ELEKTRONISCHE VORRICHTUNG UND ANWENDUNG DAVON
COMPLEXE DE PLATINE (II) CYCLOMÉTALLÉ À CHIRALITÉ HÉLICOÏDALE INDUITE PAR CHIRALITÉ CENTRALE, DISPOSITIF ÉLECTRONIQUE ET APPLICATION ASSOCIÉE

(30) Priority: 23.02.2023 CN 202310189267
(43) Date of publication of application: 06.11.2024
(73) Proprietor: Zhejiang University of Technology, Hangzhou, Zhejiang 310014 (CN); Zhejiang Huaxian Photoelectricity Technology Co., Ltd, Jiaxing, Zhejiang 314107 (CN)
(72) Inventor: Li, Guijie, Hangzhou, 310014 (CN); Xu, Kewei, Hangzhou, 310014 (CN); Zheng, Jianbing, Hangzhou, 310014 (CN); She, Yuanbin, Hangzhou, 310014 (CN); Huang, Disheng, Hangzhou, 310014 (CN)
(74) Representative: Loo, Chi Ching

(56) References cited:
- CN-A- 114 349 798

## Description

### TECHNICAL FIELD

The disclosure relates to the technical field of preparation of circularly polarized luminescence materials, in particular to a central chirality induced helical chiral tetradentate cyclometalated platinum (II) complex, an electronic device and application thereof.

### BACKGROUND ART

Circularly polarized luminescence (CPL) is a phenomenon that chiral luminescence materials are excited and emit left-handed or right-handed circularly polarized light. Therefore, design and development of chiral luminescence materials are the key to this field. With in-depth researches by researchers, circularly polarized luminescence materials exhibit important applications in 3D display, data storage, quantum computing, optical anti-counterfeiting, biological imaging and asymmetric synthesis so far.

A cyclometalated platinum (II) complex-based phosphorescent material can fully utilize all of singlet and triplet excitons generated by electroexcitation due to its heavy atom effect, so that its maximum theoretical quantum efficiency can be up to 100%, which is an ideal luminescence material. Bidentate cyclometalated platinum (II) complexe has relatively low rigidity, and its luminescent quantum efficiency is reduced due to a fact that two bidentate ligands are easy to twist and vibrate so that energy of material molecule with an excited state is consumed in a non-radiation mode. Although tridentate ligand-based cyclometalated platinum (II) complexes can be with improved luminescence quantum efficiency due to enhanced molecular rigidity, a second unidentate ligand (such as Cl⁻, phenoxy negative ions, alkyne negative ions, carbene and the like) contained greatly reduces chemical stability and thermal stability of the complexes, which is difficult to sublimate and purify for preparation of OLED devices. Therefore, bidentate or tridentate ligand cyclometalated complexe-based luminescence materials are not conducive to their application in stable and efficient OLED devices.

Central metal ions of divalent cyclometalated platinum (II) complexes are all dsp² hybridized, and are easy to coordinate with the tetradentate ligand to form stable and rigid molecules with a planar quadrilateral configuration, with high molecular rigidity which can inhibit nonradiative relaxation caused by molecular vibration and rotation, and reduce energy loss of material molecules with the excited state, thereby facilitating improving of the luminescent quantum efficiency of the material molecules. Due to steric hindrance of two aryl groups at an end of a tetradentate cyclometalated platinum (II) complex, material molecules exhibit a distorted quadrilateral configuration, which theoretically has a helicalchiral property. However, the molecules are easily racemized by up and down vibration of the two aryl groups at the end of the ligand in a solution or in a heating and sublimation process, and enantiomers cannot be separated. It is extremely difficult to obtain optically pure cyclometalated platinum (II) complex material molecules so that they do not have circularly polarized luminescence property. Therefore, it is of great significance and great practical value for its application in circularly polarized light-emitting OLED devices (CP-OLED) and also an urgent problem to be solved in the CP-OLED field, to design and develop the optically pure cyclometalated platinum (II) and palladium (II) complex material molecules with high chemical stability and thermal stability and with circularly polarized luminescence property. Examples of metal complexes known in the art for use in OLED devices can be found in for example CN114349798.

### SUMMARY

In view of defects of related art, a central chirality induced helical chiral tetradentate cyclometalated platinum (II) complex, an electronic device and application thereof are provided in this disclosure. The tetradentate cyclometalated platinum (II) complex according to the disclosure can autonomously induce a whole tetradentate ligand to coordinate with metal ions in a less sterically hindered manner by means of a central chiral fragment L^{a} in the tetradentate ligand, to form an optically pure helical chiral metal complex, which is a circularly polarized luminescence material, without need for chiral resolution. Moreover, the material has high chemical stability and has important applications in circularly polarized luminescence elements.

In order to achieve objects of the disclosure, technical schemes of the disclosure are as follows.

The central chirality induced helical chiral tetradentate cyclometalated platinum (II) complex is selected from following platinum (II) complexes or their enantiomers:

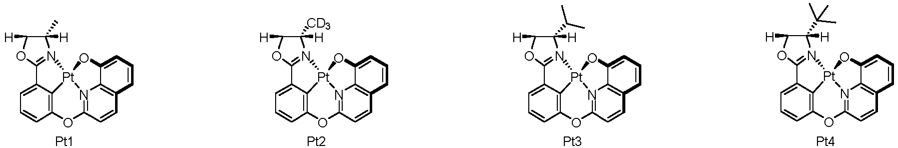

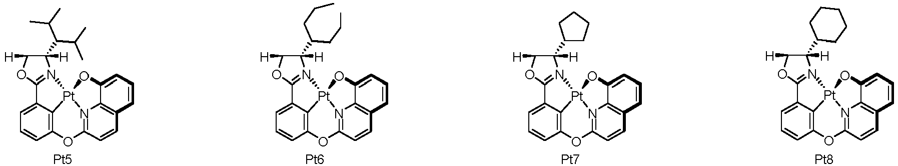

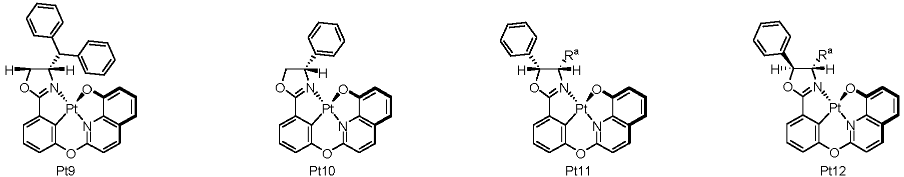

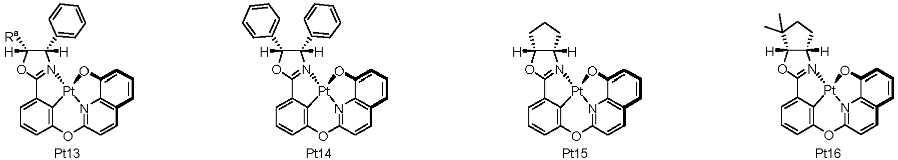

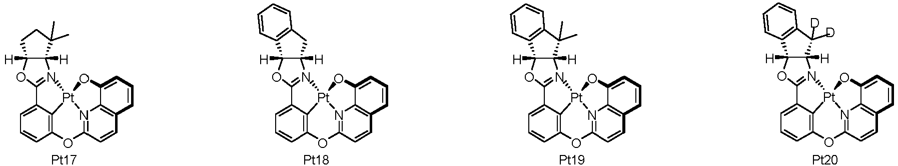

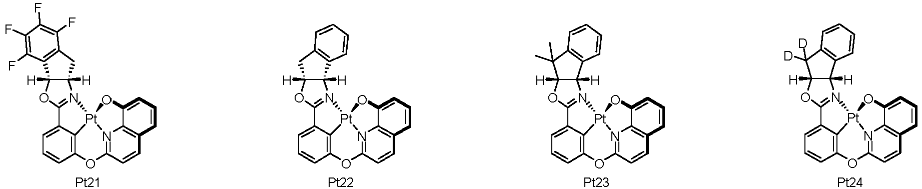

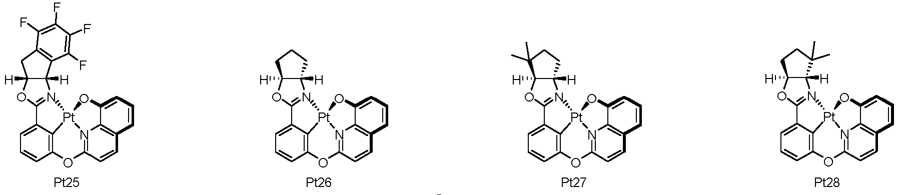

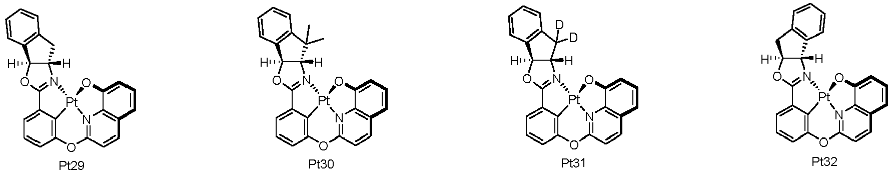

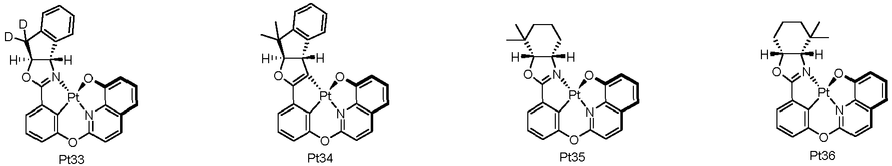

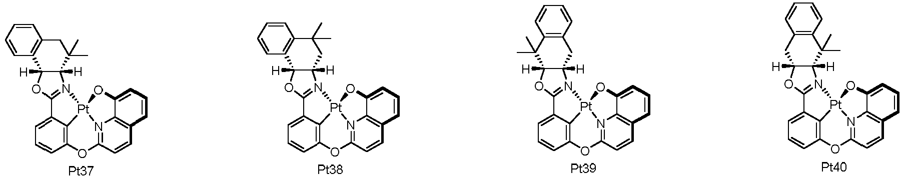

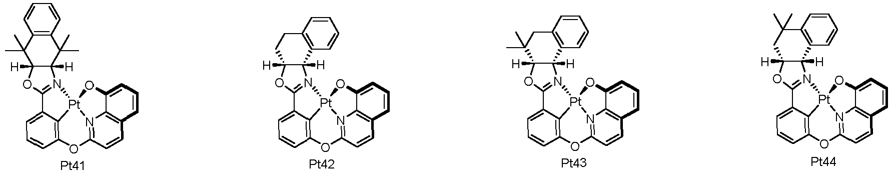

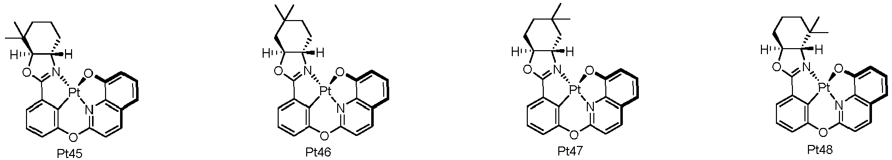

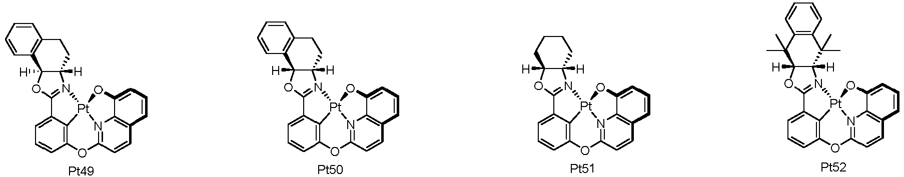

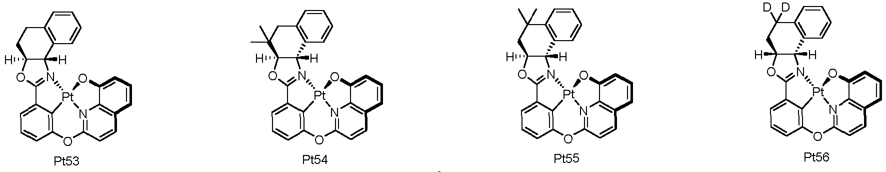

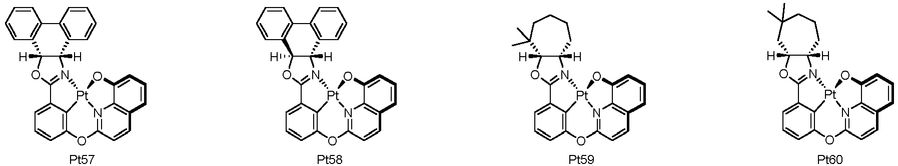

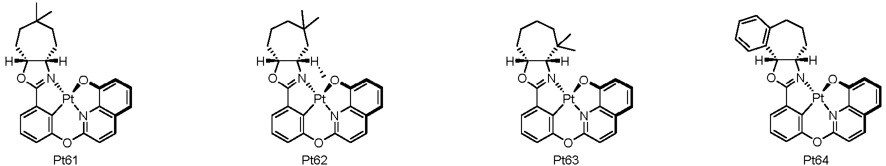

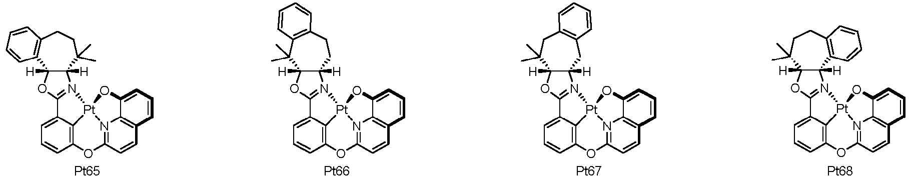

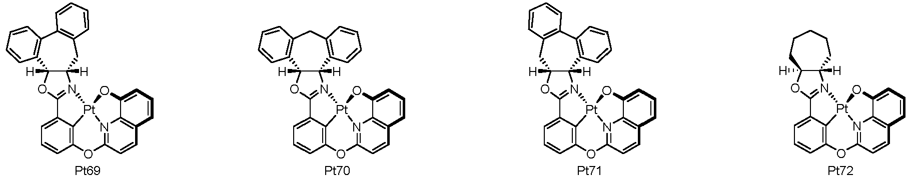

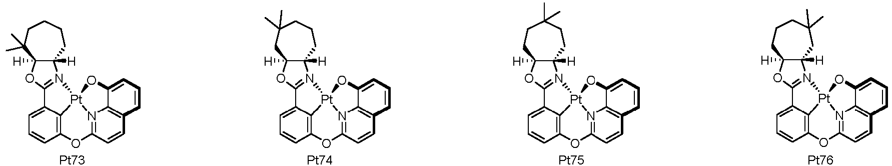

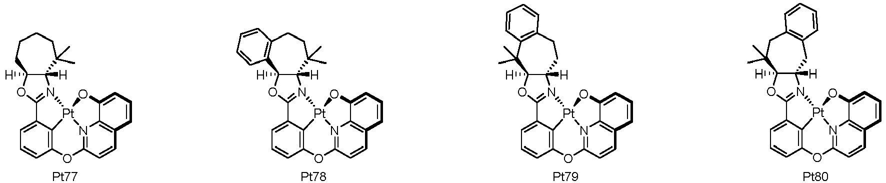

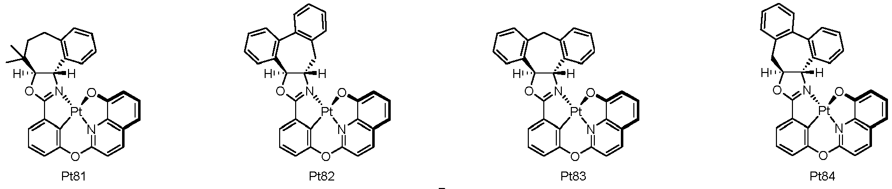

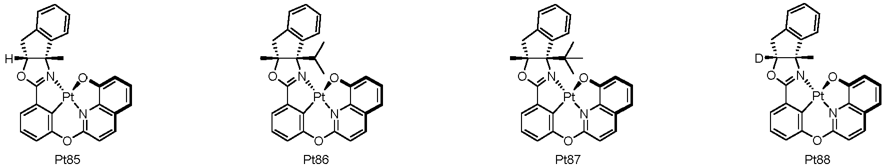

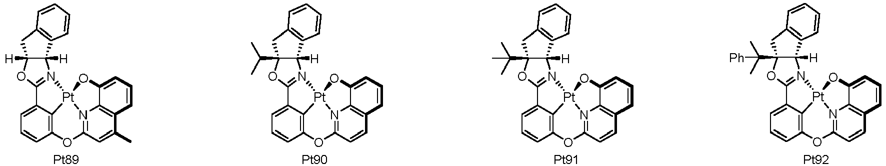

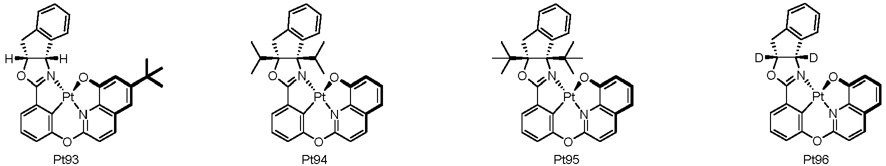

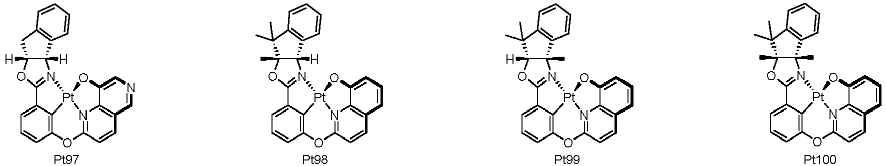

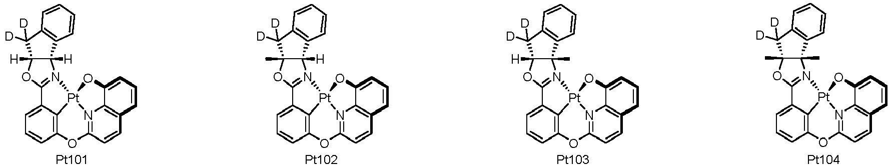

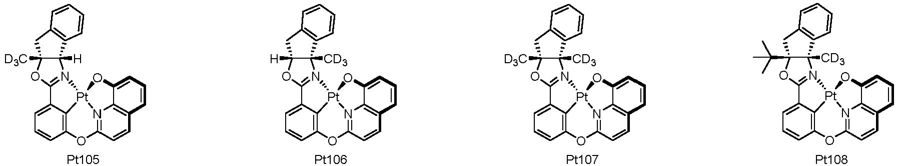

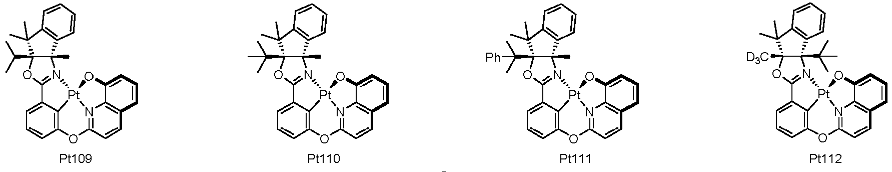

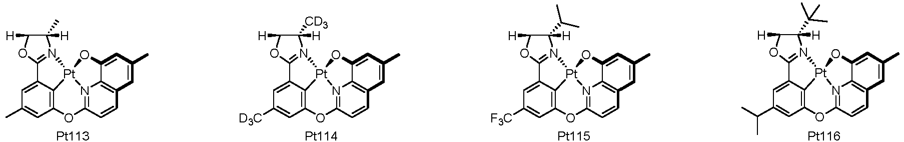

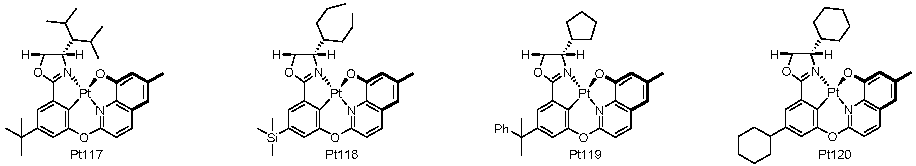

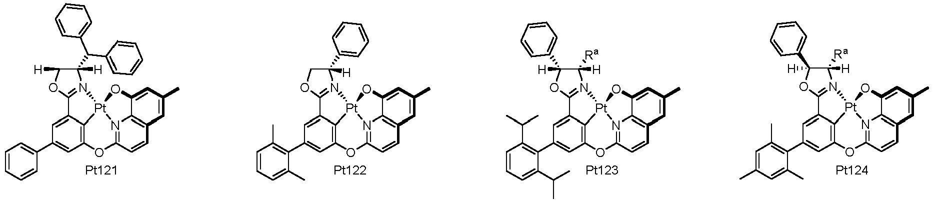

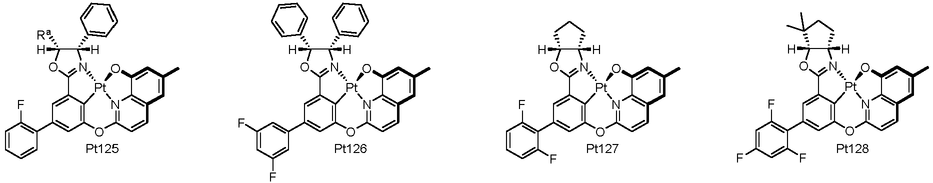

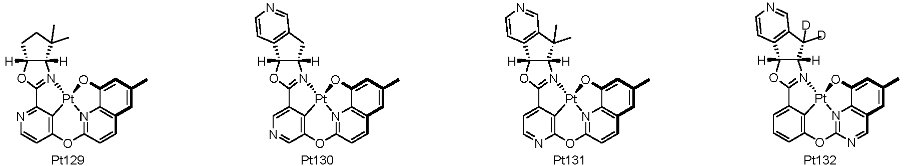

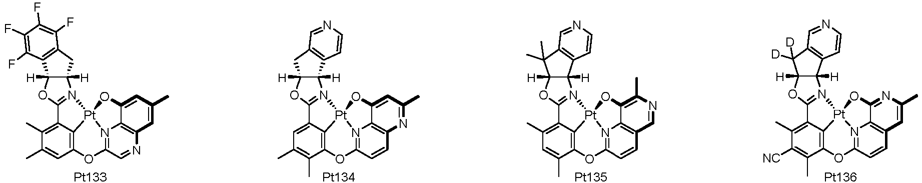

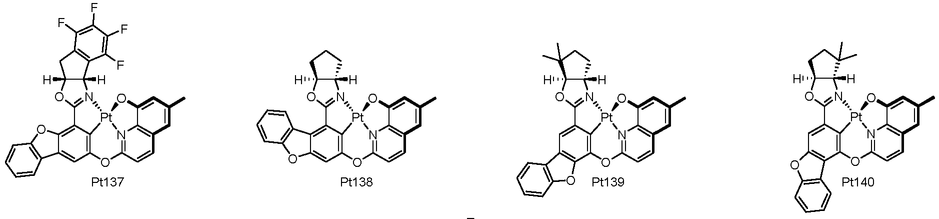

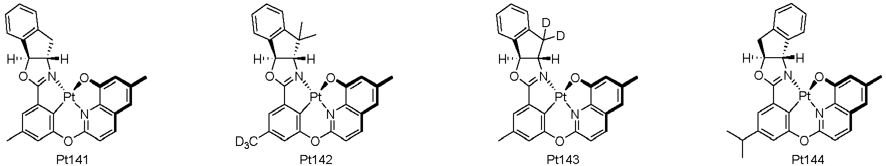

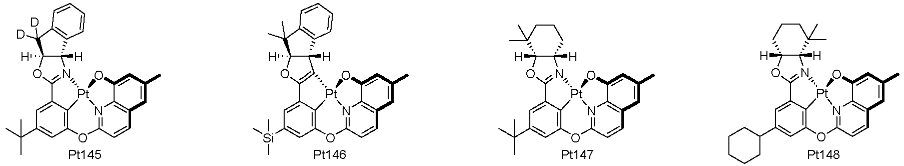

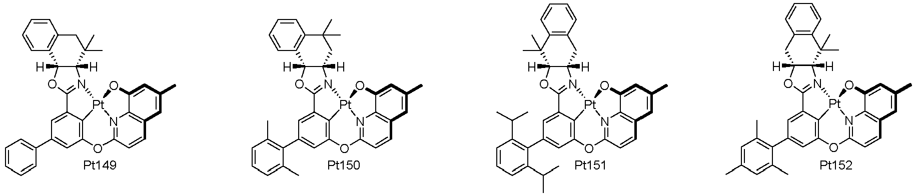

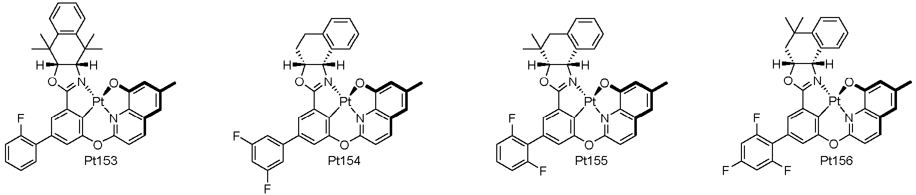

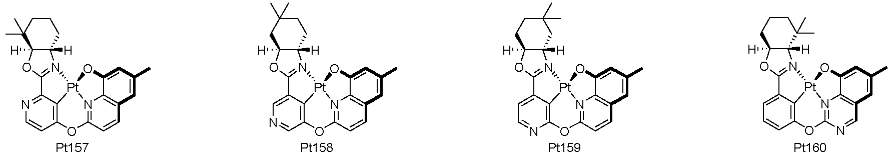

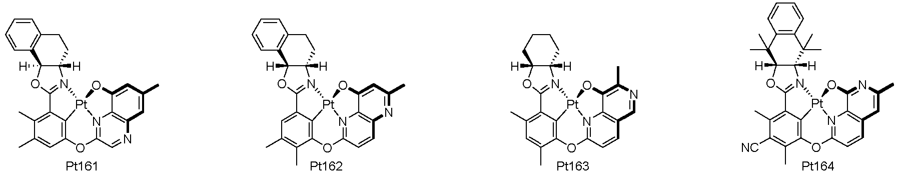

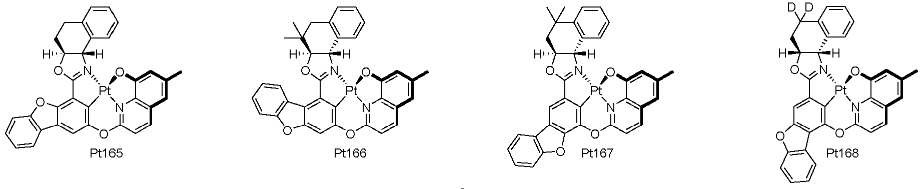

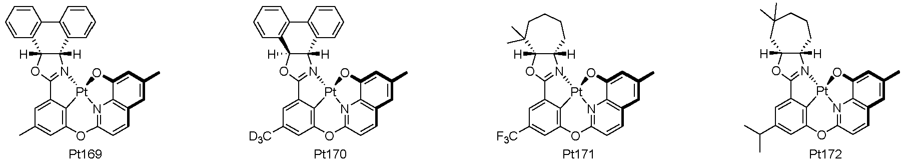

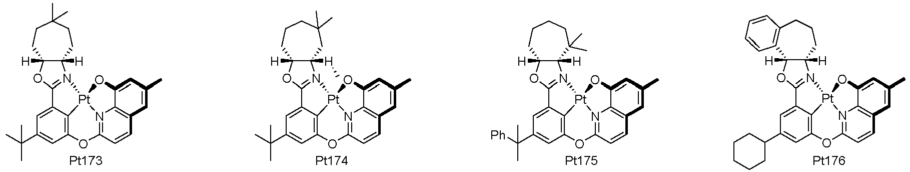

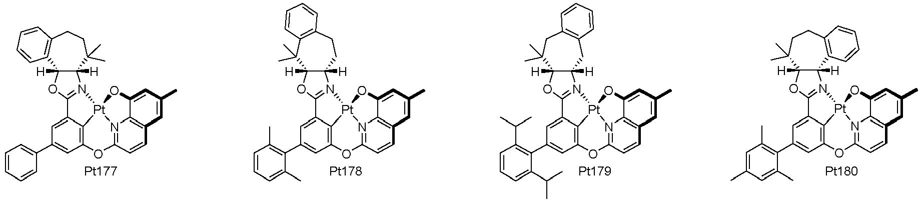

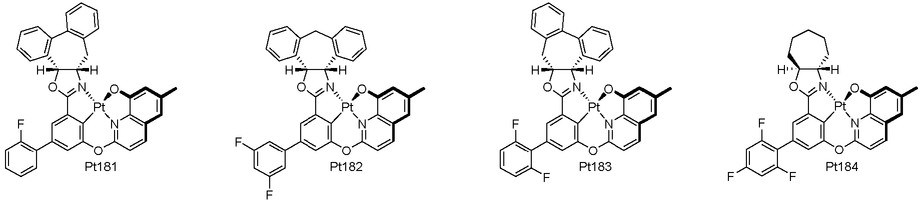

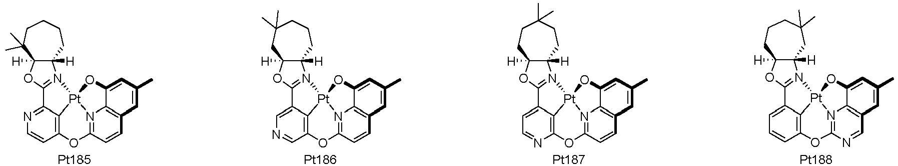

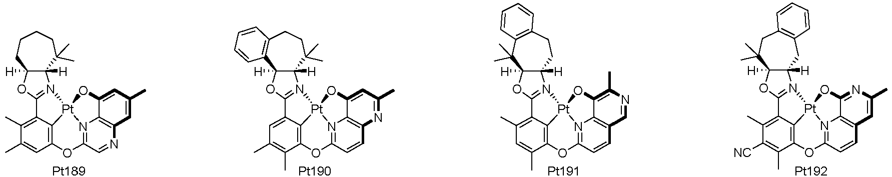

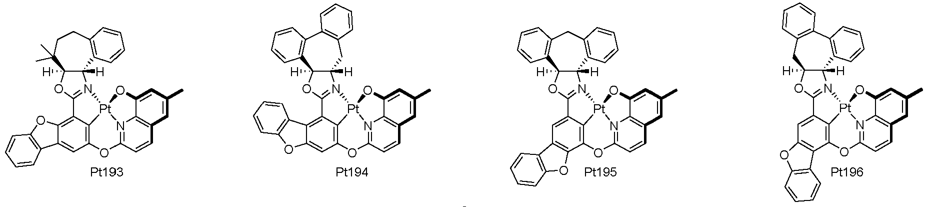

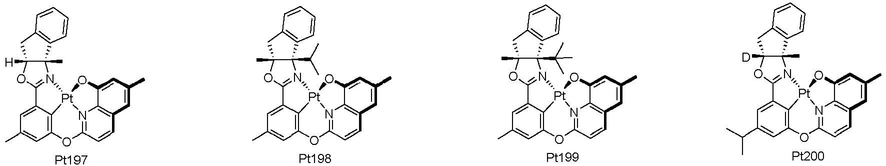

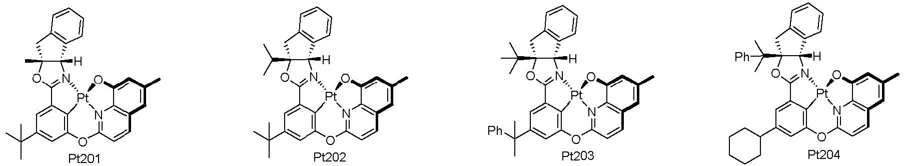

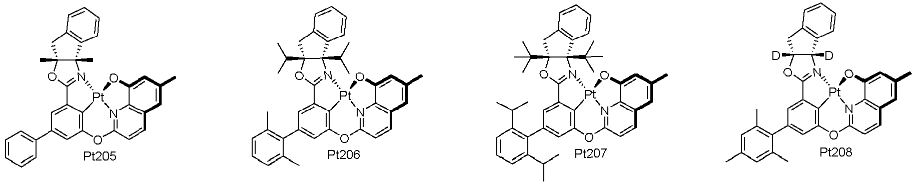

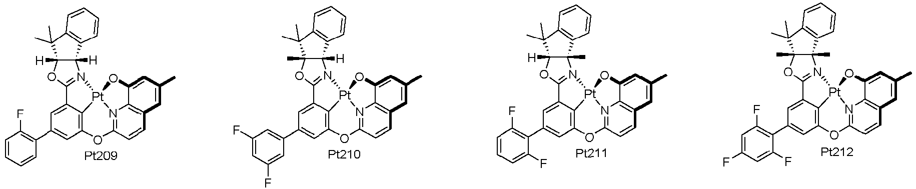

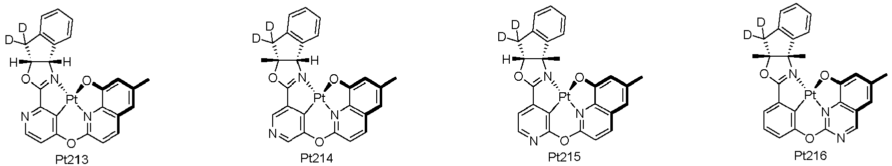

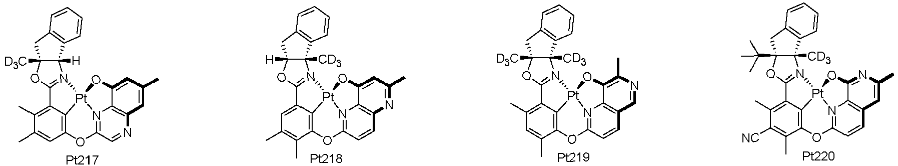

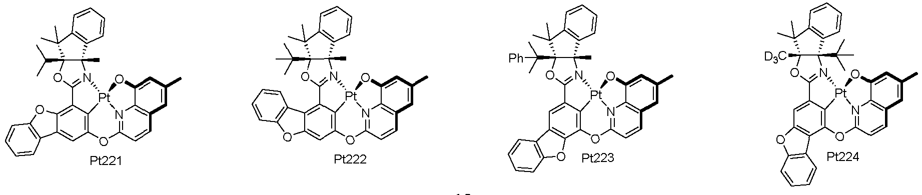

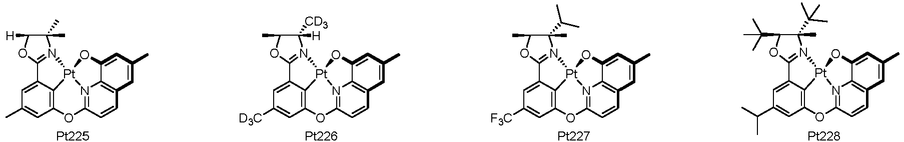

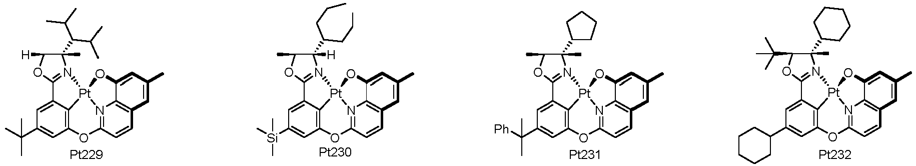

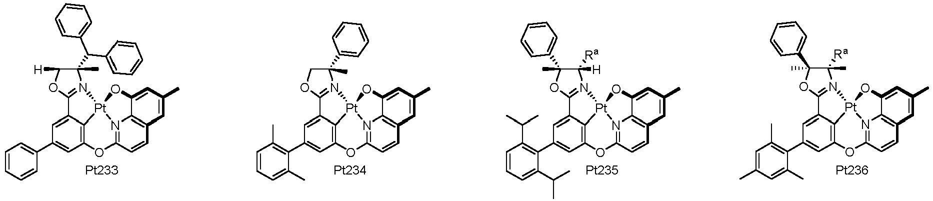

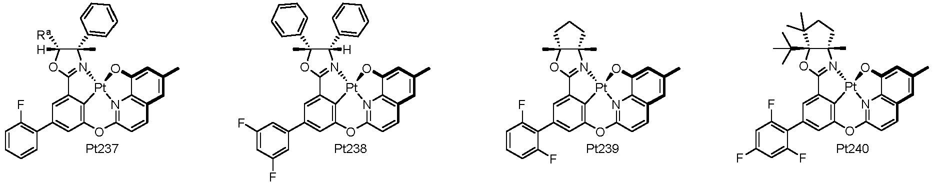

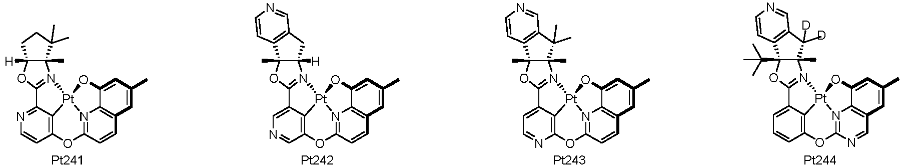

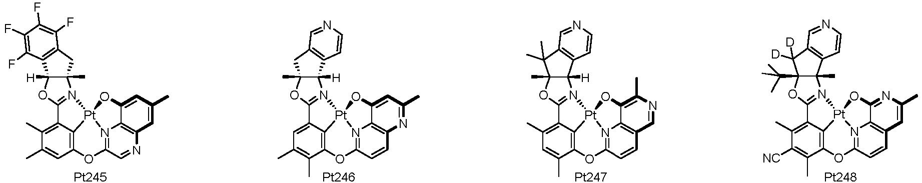

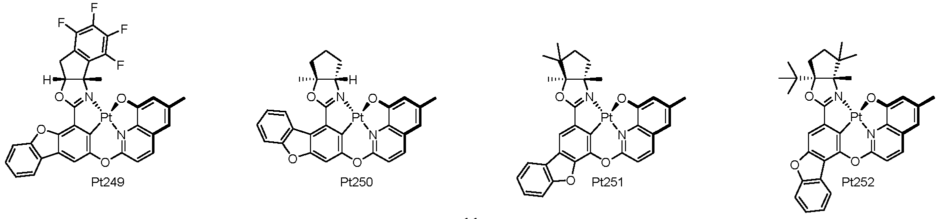

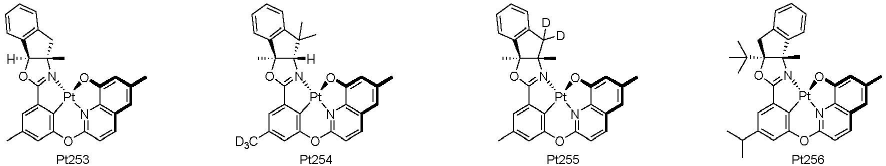

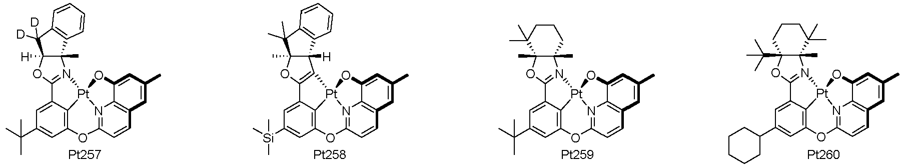

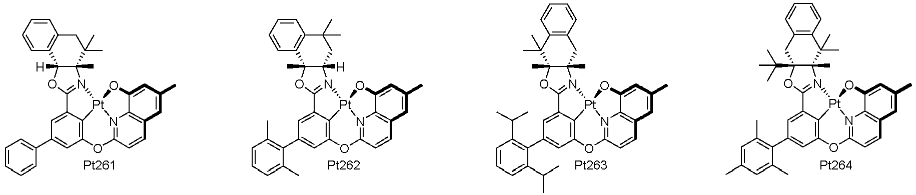

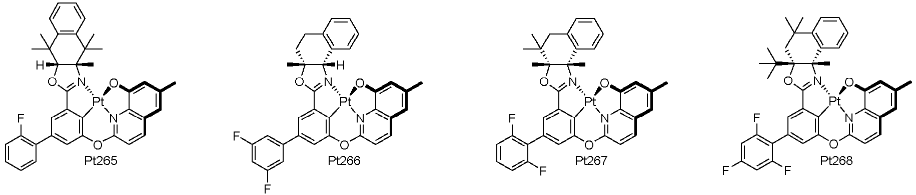

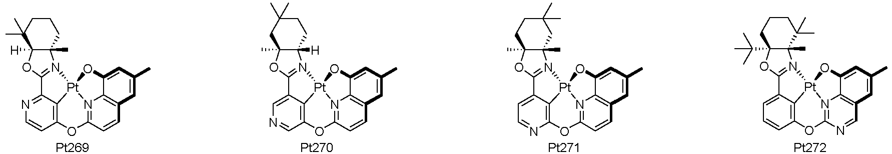

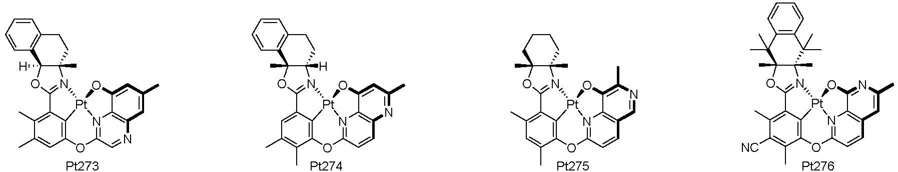

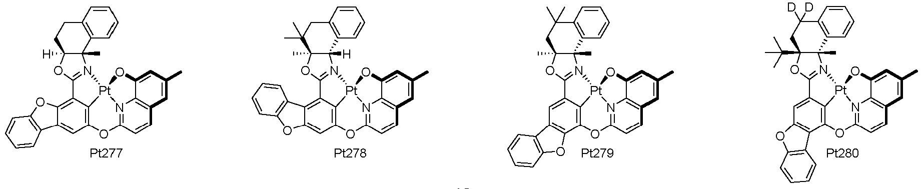

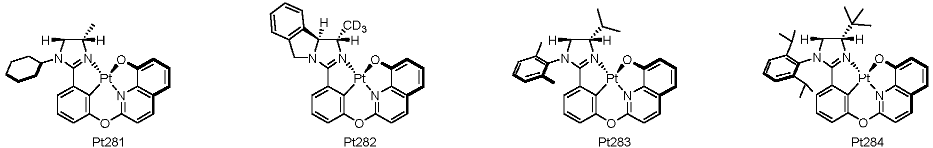

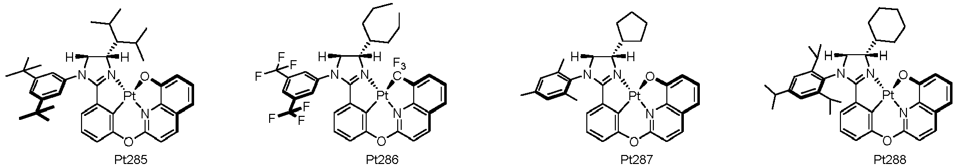

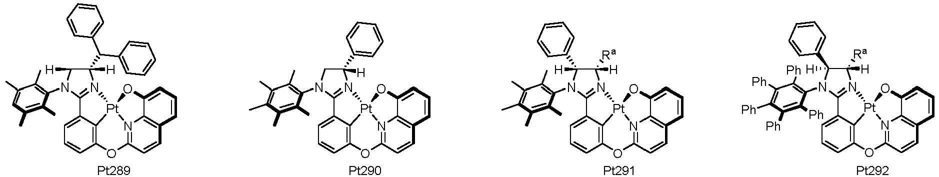

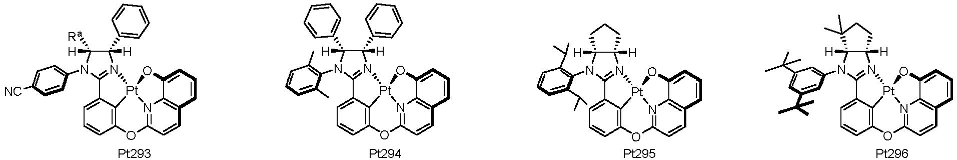

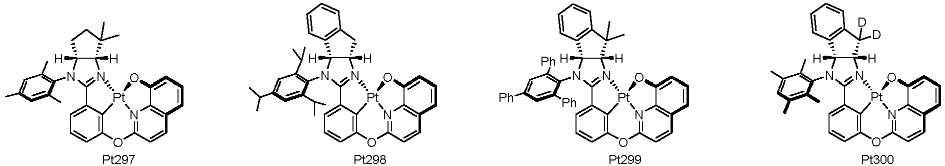

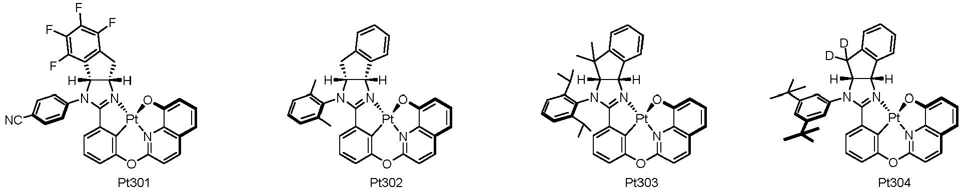

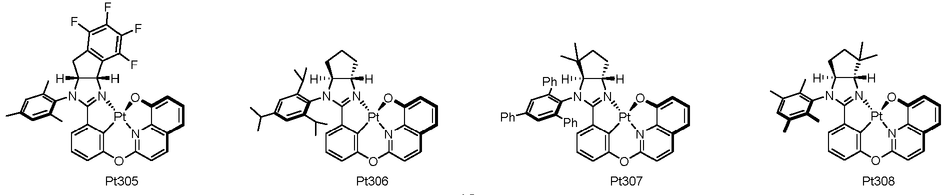

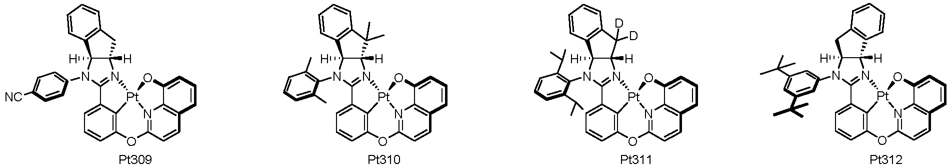

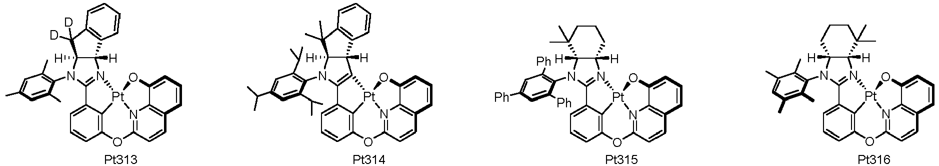

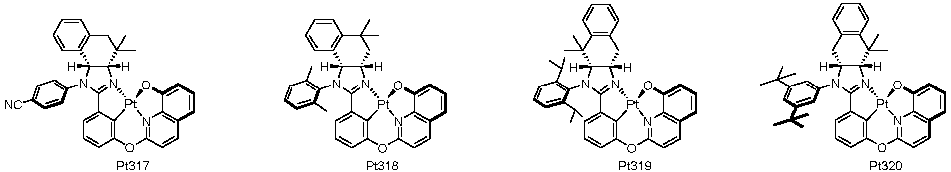

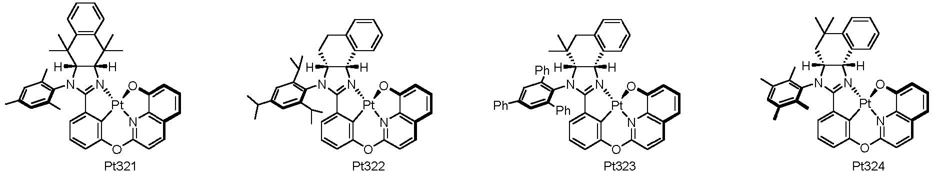

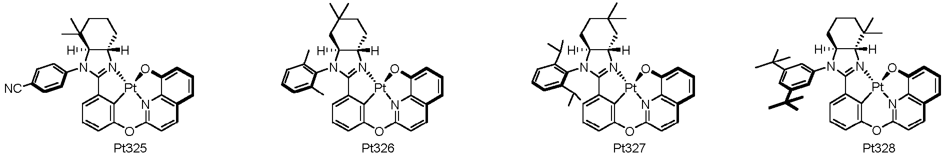

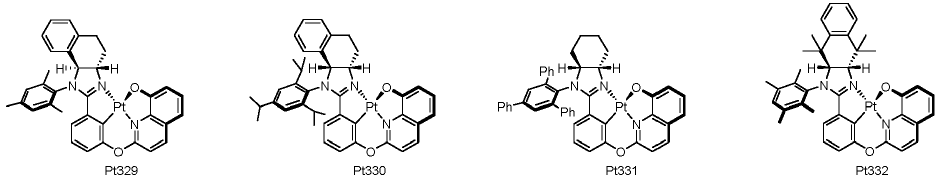

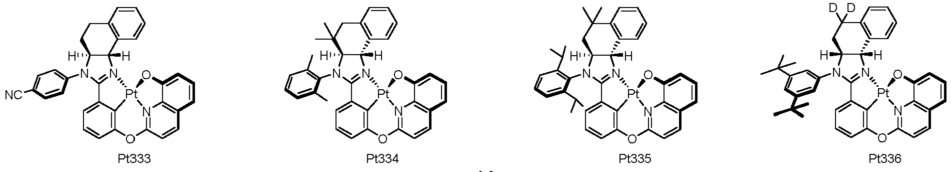

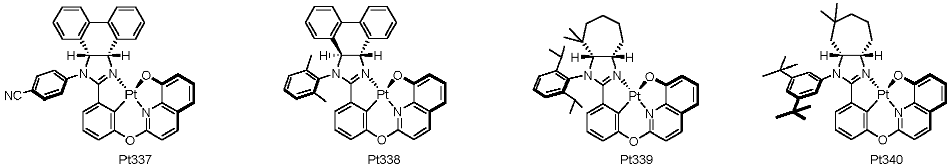

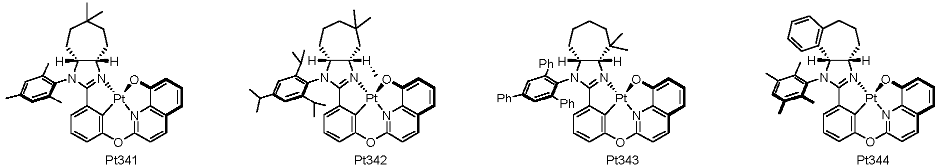

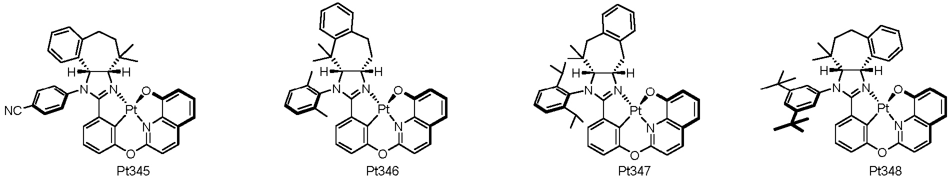

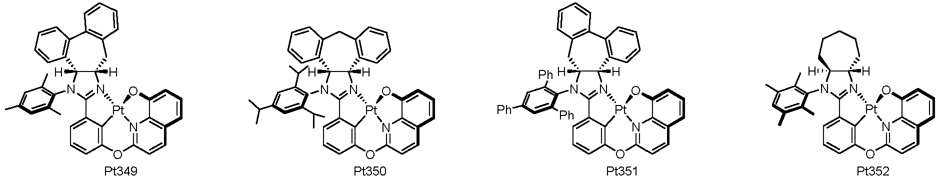

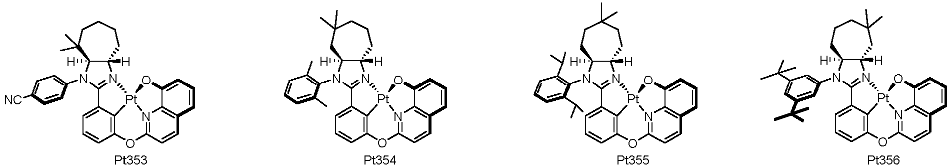

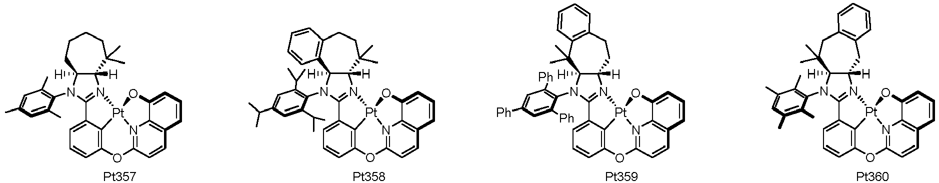

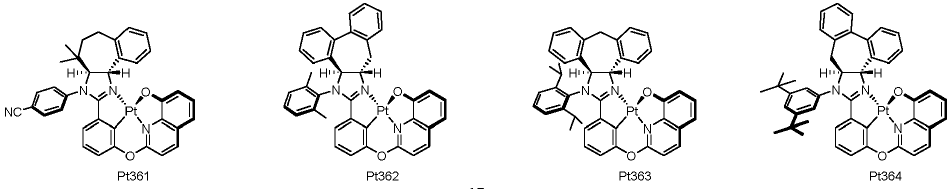

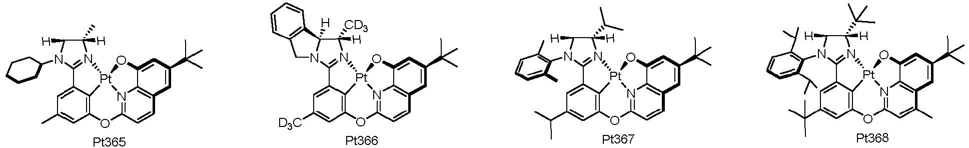

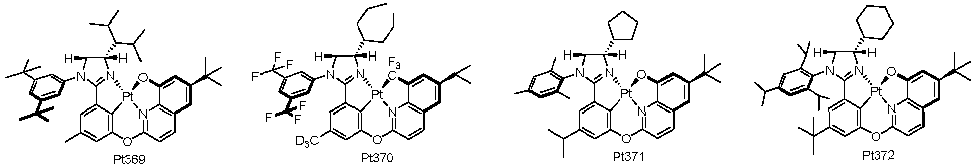

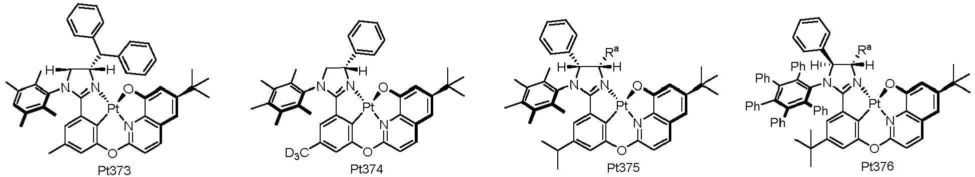

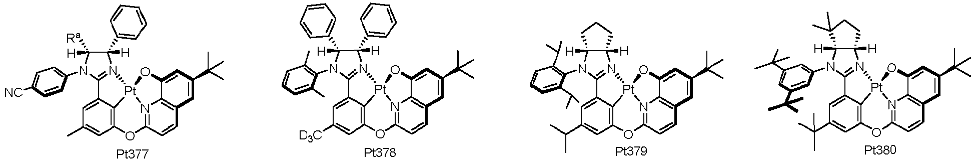

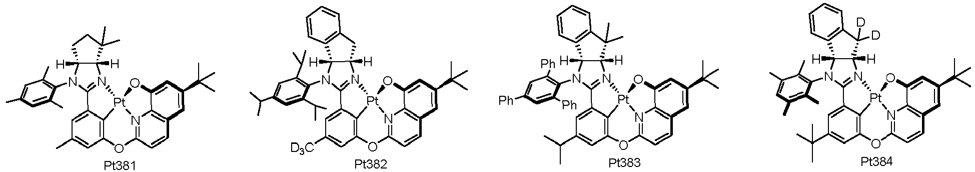

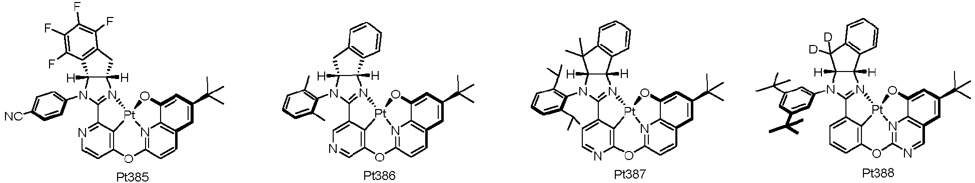

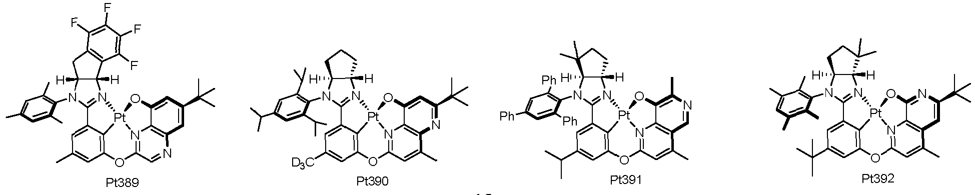

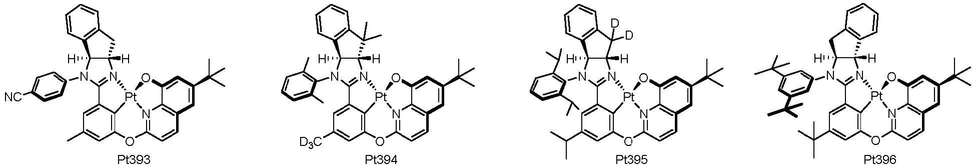

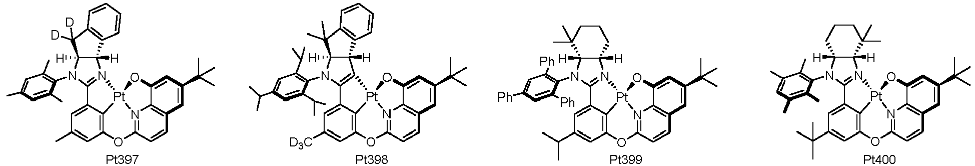

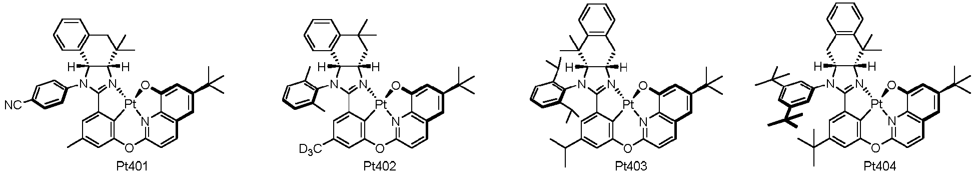

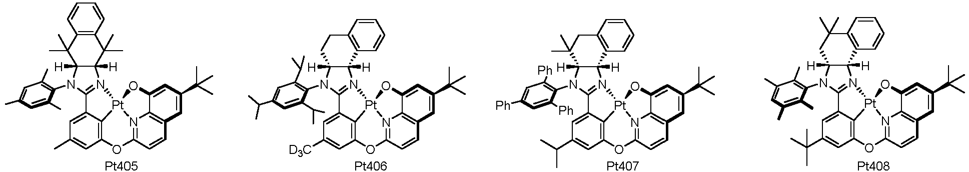

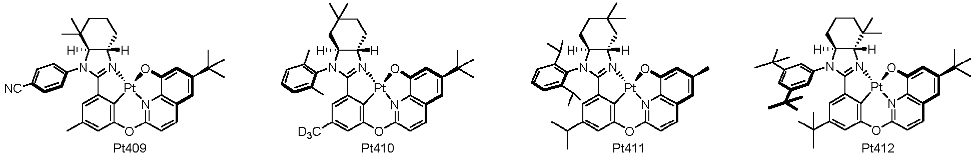

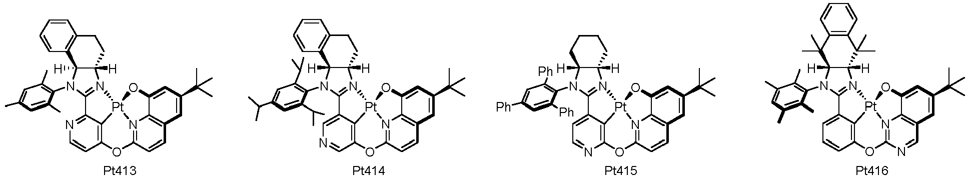

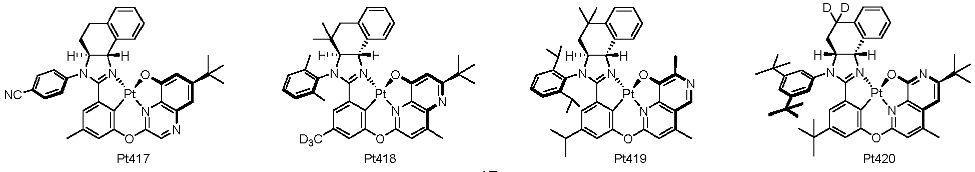

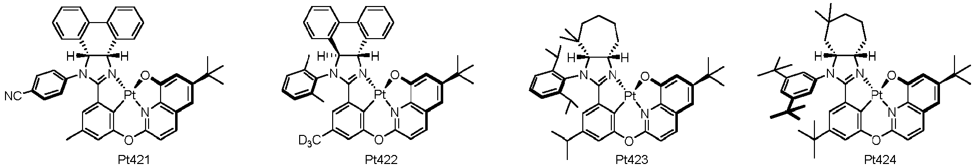

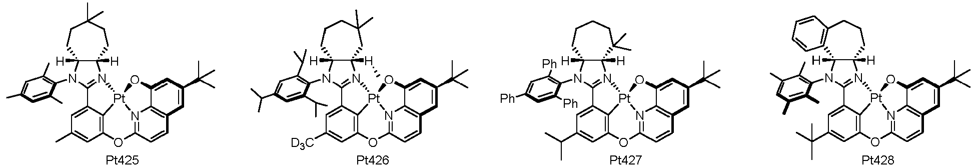

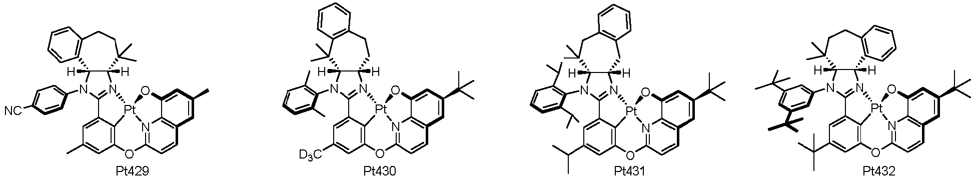

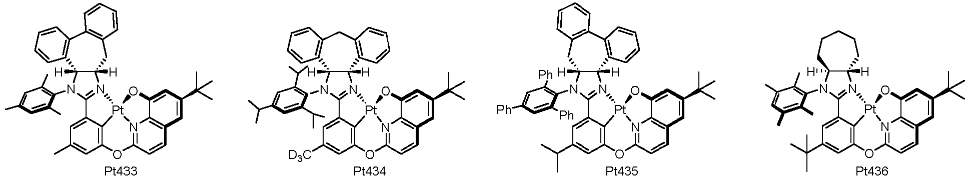

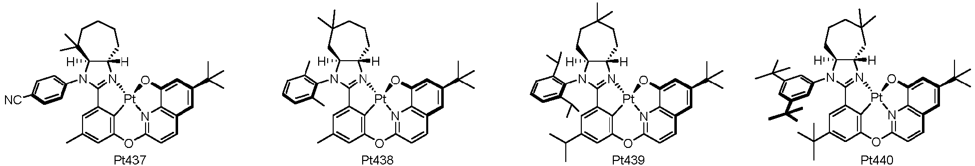

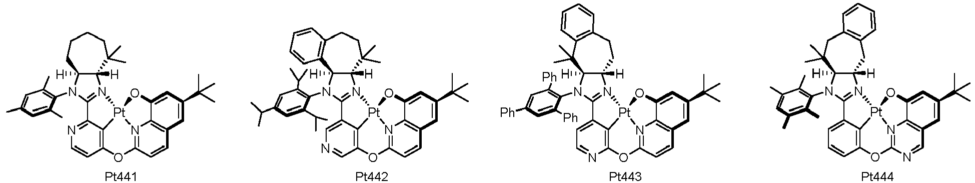

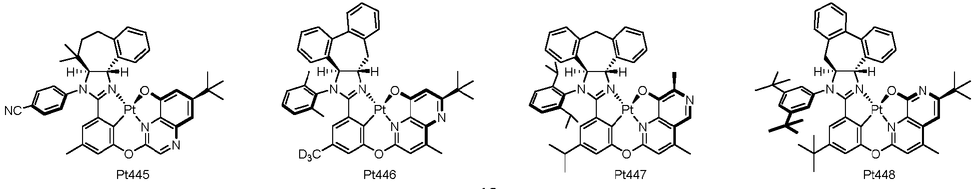

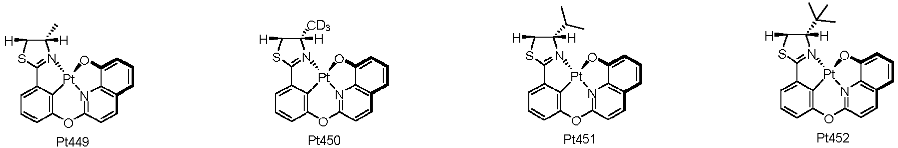

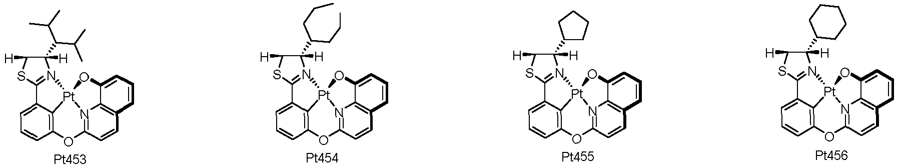

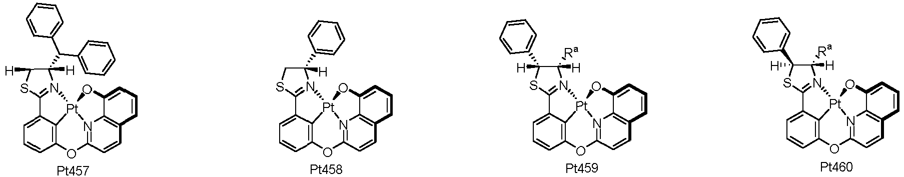

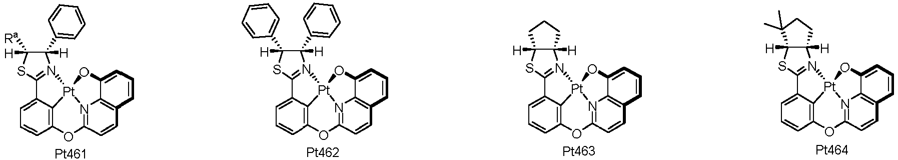

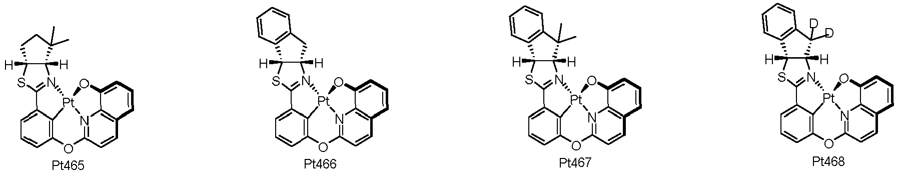

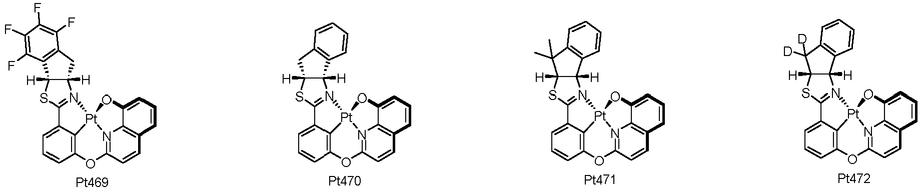

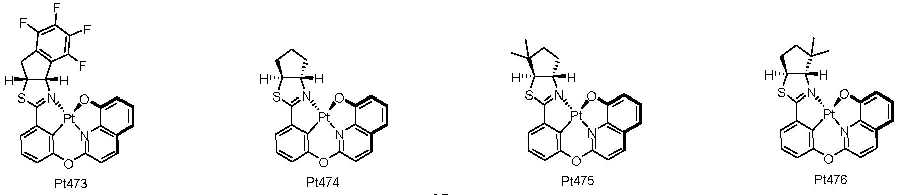

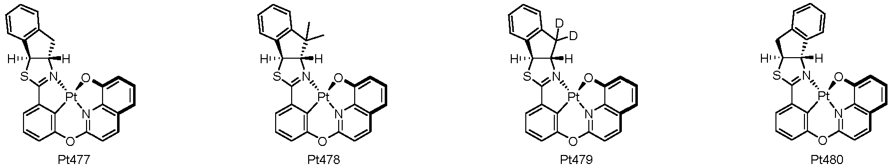

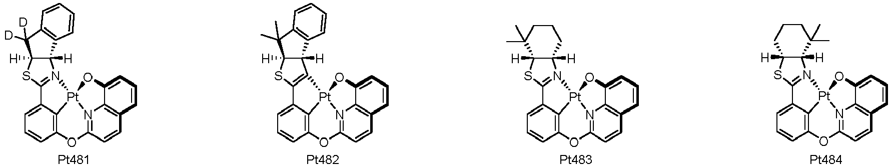

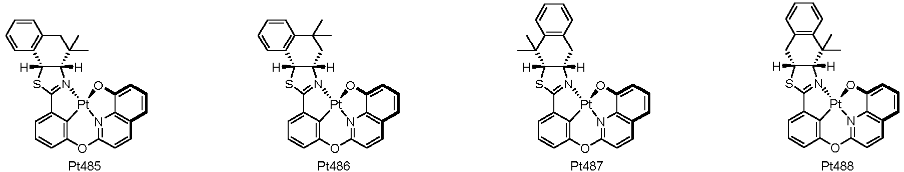

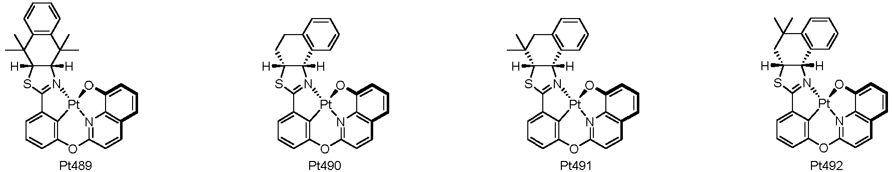

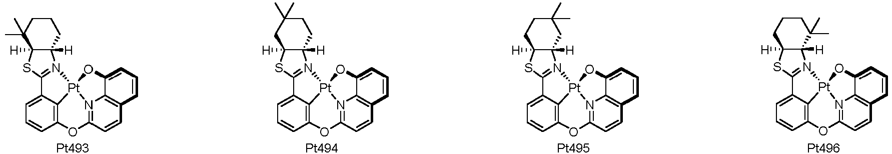

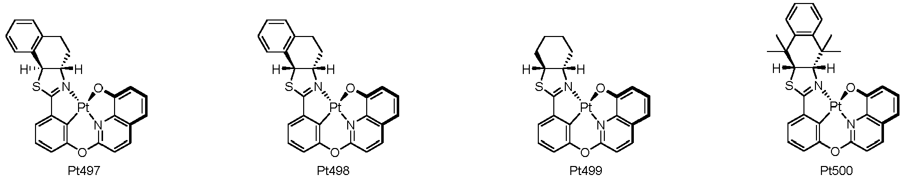

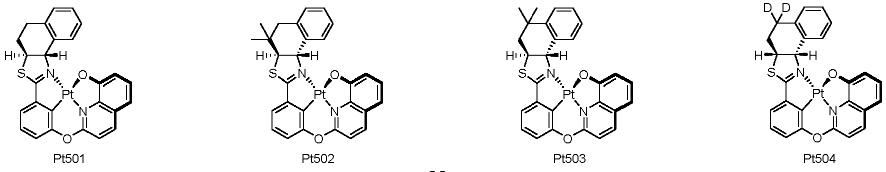

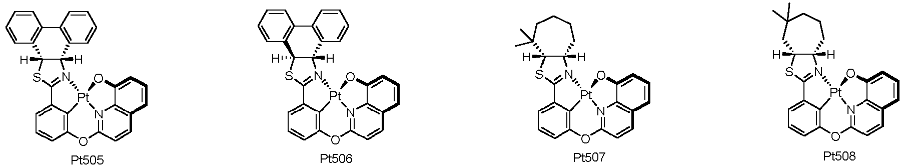

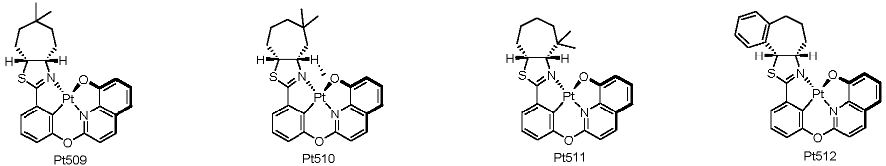

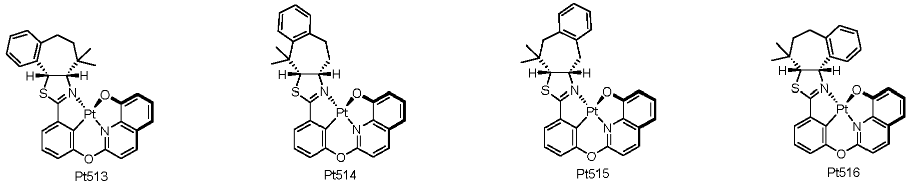

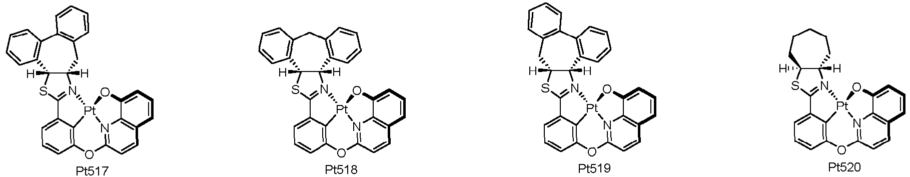

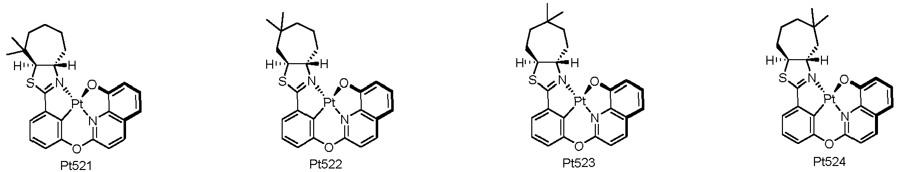

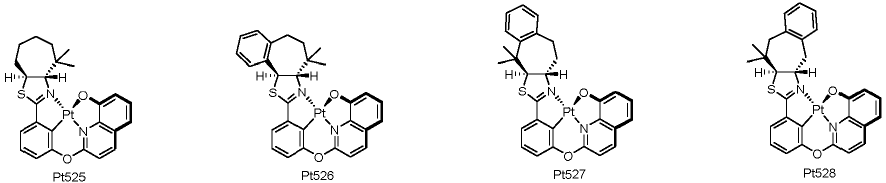

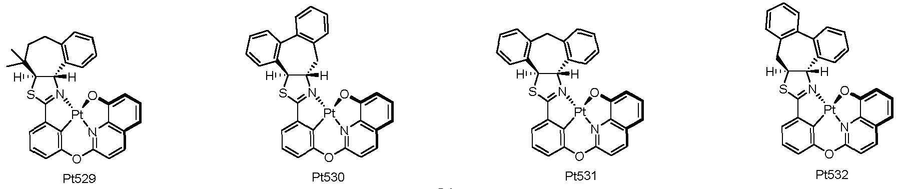

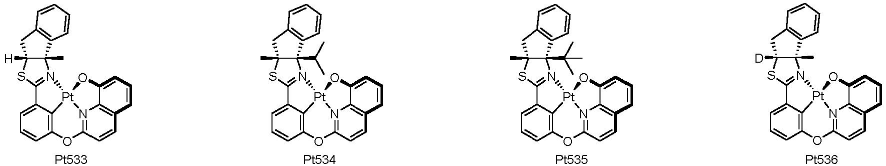

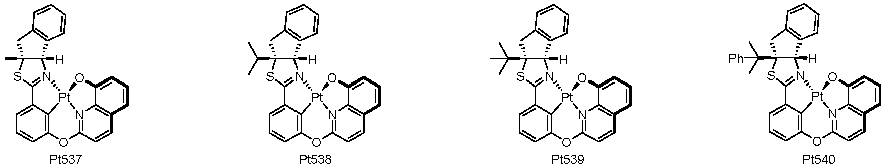

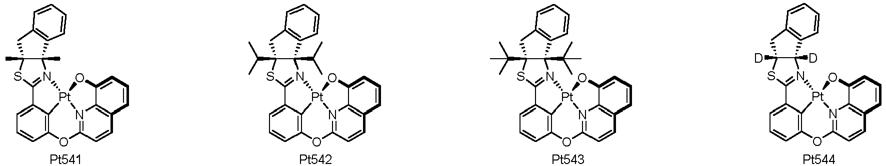

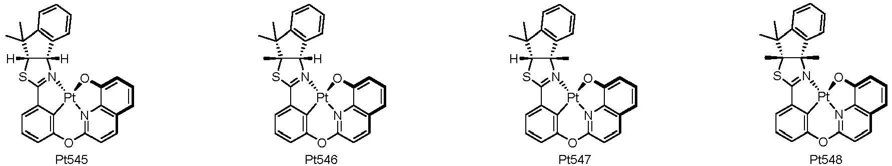

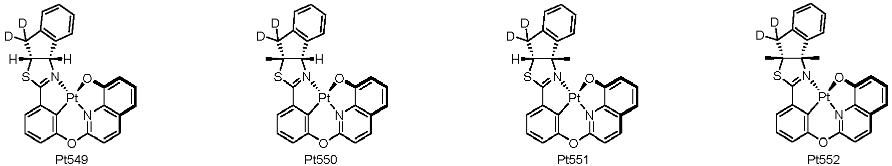

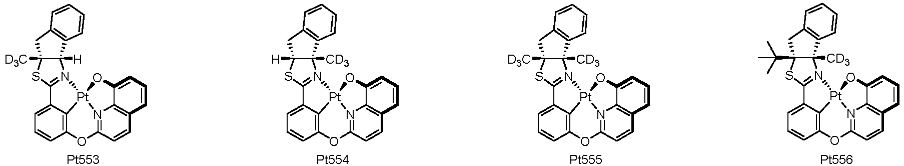

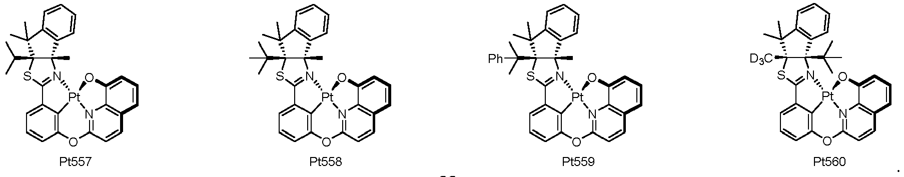

Furthermore, the central chirality induced helical chiral tetradentate cyclometalated platinum (II) complex is selected from one of following structures:

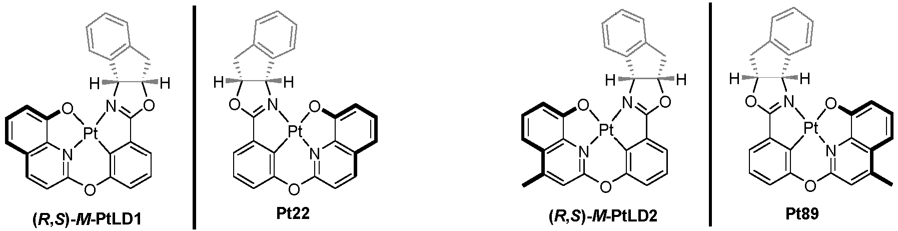

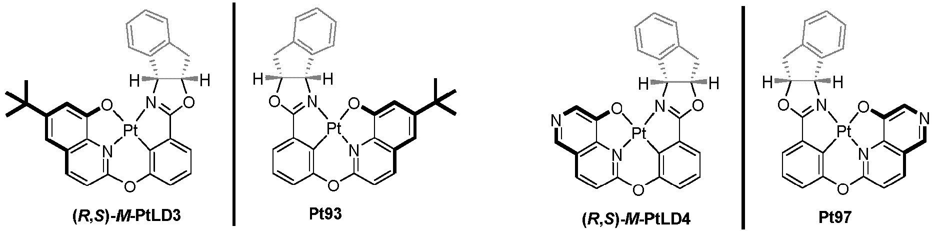

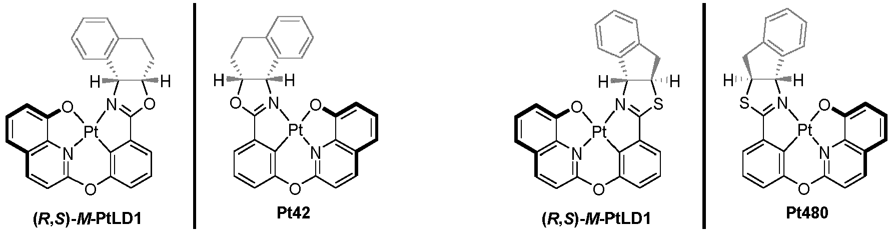

Application of the central chirality induced helical chiral tetradentate cyclometalated platinum (II) complex with a structure as shown above in an electronic device is provided in the disclosure.

The electronic device includes an organic light-emitting device (OLED), an organic integrated circuit (O-IC), an organic field effect transistor (O-FET), an organic thin film transistor (O-TFT), an organic light emitting transistor (O-LET), an organic solar cell (O-SC), an organic optical detector, an organic field quenching device (O-FQD), a light-emitting electrochemical cell (LEC) or an organic laser diode (O-laser).

Further, an electronic device containing the central chirality induced helical chiral tetradentate cyclometalated platinum (II) complex with a structure shown above is further provided in the disclosure.

The electronic device is preferably an organic light-emitting device, an organic integrated circuit, an organic field effect transistor, an organic thin film transistor, an organic light emitting transistor, an organic solar cell, an organic optical detector, an organic field quenching device, a light-emitting electrochemical cell or an organic laser diode

Preferably, the electronic device includes at least one cathode, at least one anode, and an organic layer between the at least one anode and the at least one cathode. The organic layer includes a light-emitting layer, which may be composed only of a light-emitting layer or may have more than one other organic layer besides the light-emitting layer. At least one layer in the organic layer contains the central chirality induced helical chiral tetradentate cyclometalated platinum (II) complex with a structure shown above.

The electronic device is an organic electroluminescent device, with a light-emitting layer containing the central chirality induced helical chiral tetradentate cyclometalated platinum (II) complex with a general structure as shown and a corresponding host material, with a mass percentage of the complex of 1% to 50% and no limitation on a mass percentage of the host material.

A composition includes the central chirality induced helical chiral tetradentate cyclometalated platinum (II) complex with a structure as shown above in an electronic device is provided in the dislcosure.

A preparation is further provided in the disclosure, which includes at least one central chirality induced helical chiral tetradentate cyclometalated platinum (II) complex with a structure as shown above or at least one composition as described above and at least one solvent.

A display or lighting apparatus is further provided in the disclosure, which includes one or more of electronic devices as described above.

### Compared with related art, the disclosure has following beneficial effects:

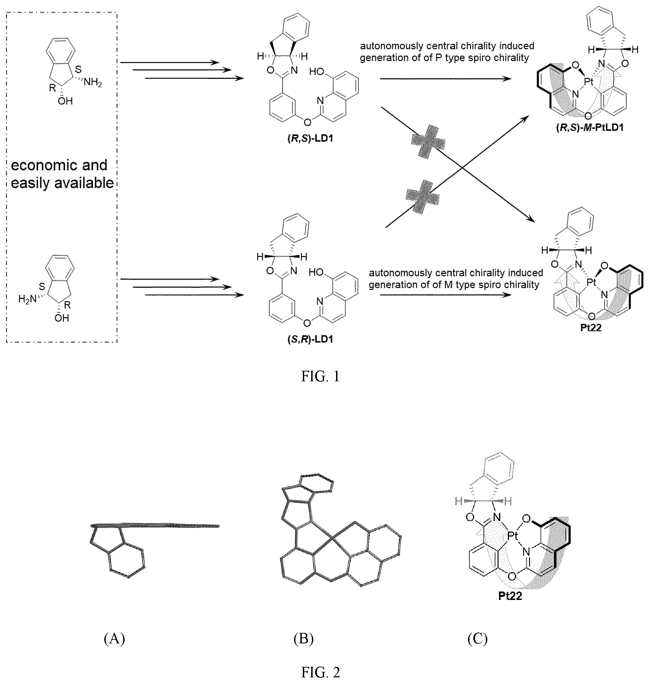

(1) According to a design idea of a helical chiral tetradentate cyclometalated metal complex with metal ion as a center shown in FIG. 1, an optically pure helical chiral tetradentate cyclometalated platinum (II) complex-based circularly polarized luminescence material with metal ion as a center was successfully prepared. Generation of central chirality autonomously induced helical chirality. By designing and developing a tetradentate ligand with central chiral L^{a}, a whole tetradentate cyclometalated platinum (II) complex molecule can be in a twisted quadrilateral configuration by using steric hindrance effect between the tetradentate ligand and a ligand at another end. Meanwhile, the central chiral L^{a} can autonomously induce the whole tetradentate ligand to coordinate with metal ion in a less sterically hindered manner so as to form the optically pure helical chiral tetradentate cyclometalated platinum (II) complex circularly polarized luminescence material with the metal ion as the center,
(2) Corresponding optically pure chiral isomers required by preparation in the disclosure are all commercially economical and available compounds, which facilitates mass preparation; and a preparation process of a corresponding isomer-based circularly polarized luminescence material does not need chiral column separation and purification, thereby greatly reduce preparation cost of the material.
(3) The designed and developed tetradentate ligand in the disclosure can well coordinate with dsp² hybridized platinum (II) metal ions to form molecules in a stable and rigid quadrilateral configuration, with high chemical stability; meanwhile, since large steric hindrance effect exists between the designed central chiral ligand L^{a} and the ligand at another end, the metal complex molecule as a whole can form a stable helical chiral tetradentate cyclometalated metal complex, so that the helical chiral tetradentate cyclometalated metal complex can not be racemized and lose circularly polarized luminescence property in a solution, with high chemical stability.

### BRIEF DESCRIPTION OF THE DRAWINGS

FIG. 1 shows a design idea of a helical chiral tetradentate cyclometalated metal complex with metal ion as a center according to the disclosure;
FIG. 2 shows a molecular structure of the tetradentate cyclometalated platinum (II) complex optimized by density functional theory (DFT) calculation, in which (A) is a top view, (B) is a front view, and (C) is a structural view;
FIG. 3 is emission spectra of (R,S)-M-PtLD1 and Pt22 in a dichloromethane solution according to the disclosure;
FIG. 4 is emission spectra of Pt22 and (*R*,*S*)-*M*-PtLD1 in a dichloromethane solution according to the disclosure;
FIG. 5 is circularly polarized luminescence spectra of Pt22 and (*R*,*S*)-*M*-PtLD1 in a dichloromethane solution according to the disclosure;
FIG. 6 shows high performance liquid chromatography spectra of a mixture of (*R*,*S*)-*M*-PtLED1 and Pt22 with a ratio of 1: 1, optically pure (*R*,*S*)-*M*-PtLD1, and Pt22.

### DETAILED DESCRIPTION

Contents of the present disclosure are described in detail below. Following description of constituent elements described below is sometimes based on representative embodiments or specific examples of the present disclosure, but the present disclosure is not limited to such embodiments or specific examples.

A specific example of a circularly polarized luminescence material of the present disclosure represented by above general formulas is illustrated below, however, it is not to be construed as limiting of the present disclosure.

The present disclosure may be more readily understood by reference to the following detailed description and examples included therein. Before compounds, devices, and/or methods of the present disclosure are disclosed and described, it should be understood that they are not limited to specific synthetic methods or specific reagents unless otherwise specified, as those may vary. It should also be understood that terminologies used in the present disclosure is for a purpose of describing particular aspects only but is not intended to be limiting. While any method and material similar or equivalent to those described herein may be used in this practice or test, example methods and materials are now described.

As used in the specification and appended claims, terms "a," "an," and "the" involves plural referents unless the context clearly dictates otherwise. Thus, for example, reference to a "component" includes a mixture of two or more components.

A term "optional" or "optionally" as used herein means that a subsequently described event or condition may or may not occur, and that such description includes both instances in which the described event or condition occurs and instances in which it does not.

Components useful in preparing compositions of the present disclosure are disclosed, as well as the compositions themselves to be used in the methods disclosed in the present disclosure. These and other materials are disclosed, and it is to be understood that combinations, subsets, interactions, groups, etc. of these materials are disclosed, and that while specific references to each of various individual and general combinations and permutations of these compounds are not specifically disclosed, each of them is specifically contemplated and described. For example, if a particular compound is disclosed and discussed and many modifications that can be made to many molecules comprising the compound are discussed, each combination and permutation of the compound and possible modifications are specifically contemplated unless specifically indicated to the contrary. Thus, if a class of molecules A, B and C are disclosed as well as a class of molecules D, E and F and an example of a combination molecule A-D, then even if each is not individually recited, it is contemplated that they are individually and collectively disclosed, namely, A-E, A-F, B-D, B-E, B-F, C-D, C-E and C-F. Likewise, any subset or combination of these are also disclosed. For example, subgroups such as A-E, B-F, and C-E are also disclosed. This concept applies to all aspects of the present disclosure, including, but not limited to, steps in methods of making and using the composition. Thus, if there are various additional steps that can be performed, it should be understood that each of these additional steps can each be performed in a particular implementation of the method or a combination of implementations thereof.

A linking atom used in the present disclosure is capable of linking two groups, for example, linking N and C. The linking atom can optionally (if valence bonds allow) be attached to other chemical groups. For example, an oxygen atom will not have any other chemical group attachment since once two atoms (e. g ., N or C) are bonded, the valence bonds are already fully used. In contrast, when the linking atom is carbon, two additional chemical groups can be attached to the carbon atom. Suitable chemical groups include, but are not limited to, hydrogen, hydroxyl, alkyl, alkoxy, =O, halogen, nitro, amine, amide, mercapto, aryl, heteroaryl, cycloalkyl, and heterocyclyl.

A term "substituted" or the like as used herein includes all permissible substituents of an organic compound. Broadly, permissible substituents include cyclic and acyclic, branched and unbranched, carbocyclic and heterocyclic, aromatic and non-aromatic substituents of organic compounds. For example, exemplary substituents include following content. For suitable organic compounds, the permissible substituents may be one or more, the same or different. For a purposes of the present disclosure, heteroatom (e. g., nitrogen) can have a hydrogen substituent and/or any permissible substituent of the organic compound of the present disclosure satisfying valence bonds of the heteroatom. The present disclosure is not intended to be limiting in any way with the permissible substituents of the organic compound. As such, a term "substituted" or "substituted with" encompasses an implicit condition that such a substitution conforms to permissible valence bonds of a substituted atom and the substituent, and that the substitution results in stable compounds (e. g., compounds that do not spontaneously undergo conversion (e. g., by rearrangement, cyclization, elimination, etc.)). In certain aspects, individual substituents can be further optionally substituted (i.e., further substituted or unsubstituted) unless explicitly stated to the contrary.

In defining various terms, "R¹", "R²" and "R³" are used in the present disclosure as general symbols to represent various specific substituents. These symbols can be any substituent, not limited to those disclosed herein, which, when defined in an example as certain substituents, can also be defined in another example as some other substituents.

A term "alkyl" as used herein is a branched or unbranched saturated hydrocarbon group of 1 to 30 carbon atoms such as methyl, ethyl, n-propyl, isopropyl, n-butyl, isobutyl, sec-butyl, tert-butyl, n-pentyl, isopentyl, sec-pentyl, neopentyl, hexyl, heptyl, octyl, nonyl, decyl, dodecyl, tetradecyl, hexadecyl, eicosyl, tetracosyl and the like. The alkyl may be cyclic or acyclic. The alkyl may be branched or unbranched. The alkyl may also be substituted or unsubstituted. For example, the alkyl may be substituted with one or more group including, but not limit to, optionally substituted alkyl, cycloalkyl, alkoxy, amino, ether, halogen, hydroxy, nitro, silyl, sulfo-oxo and thiol as described herein.

Throughout this specification, "alkyl" generally refer to both unsubstituted and substituted alkyl. However, substituted alkyl is also specifically mentioned in this present disclosure by determining specific substituents on the alkyl. For example, a term "halogenated alkyl" or "haloalkyl" specifically refers to an alkyl substituted with one or more halogens (e.g., fluorine, chlorine, bromine, or iodine). A term "alkylamino" specifically refers to an alkyl substituted with one or more amino, as described below or the like. When "alkyl" is used in one case and specific terms such as "alkyl alcohol" are used in another case, it is not intended to imply that the term "alkyl" does not simultaneously refer to specific terms such as "alkyl alcohol" or the like.

This practice is also applicable for other groups described herein. That is, when terms such as "cycloalkyl" refer to both unsubstituted and substituted cycloalkane moieties, the substituted moiety may additionally be specifically determined in the present disclosure. For example, a specifically substituted cycloalkyl may be referred to as, for example, "alkyl cycloalkyl". Similarly, a substituted alkoxy may be specifically referred to as, for example, "haloalkoxy" and a specific substituted alkenyl may be, for example, "enol" or the like. Likewise, use of general terms such as "cycloalkyl" and specific terms such as "alkylcycloalkyl" does not imply that the general terms do not include the specific term at the same time.

The term "cycloalkyl" as used herein is a non-aromatic carbon-based ring of 3 to 30 carbon atoms consisting of at least three carbon atoms. Examples of cycloalkyl include, but are not limited to, cyclopropyl, cyclobutyl, cyclopentyl, cyclohexyl, cyclononyl, and the like. A term "heterocycloalkyl" is a type of cycloalkyl as defined above and is included in meaning of the term "cycloalkyl" in which at least one ring carbon atom is substituted by a heteroatom such as, but not limited to, a nitrogen, oxygen, sulfur or phosphorus atom. The cycloalkyl and heterocycloalkyl may be substituted or unsubstituted. The cycloalkyl and heterocycloalkyl may be substituted with one or more groups including, but not limited to, alkyl, cycloalkyl, alkoxy, amino, ether, halogen, hydroxy, nitro, silyl, sulfo-oxo and thiol as described herein.

A term "polyolefin group" as used herein refers to a group containing two or more CH₂ groups attached to each other. The "polyolefin group" may be express as -(CH2)ₐ-, where "a" is an integer between 2 and 500.

Terms "alkoxy" and "alkoxy group" as used herein refer to an alkyl or cycloalkyl of 1 to 30 carbon atoms bonded by ether bonds. That is, "alkoxy" may be defined as -OR¹, where R¹ is the alkyl or cycloalkyl as defined above. "Alkoxy" further includes alkoxy polymers just described. That is, the alkoxy may be a polyether such as -OR¹-OR² or -OR¹-(OR²)ₐ-OR³, where "a" is an integer between 1 to 500, and R¹, R² and R³ are each independently an alkyl, a cycloalkyl, or a combination thereof.

A term "alkenyl" as used herein is a hydrocarbon of 2 to 30 carbon atoms with a structural formula containing at least one carbon-carbon double bond. An asymmetric structure such as (R¹R²)C=C(R³) contains E and Z isomers. This can be inferred in a structural formula of the present disclosure in which an asymmetric olefin is present, or it can be explicitly expressed by a bond symbol C=C. The alkenyl may be substituted with one or more groups including, but not limited to, alkyl, cycloalkyl, alkoxy, alkenyl, cycloalkenyl, alkynyl, cycloalkynyl, aryl, heteroaryl, aldehyde, amino, carboxylic acid, ester, ether, halogen, hydroxy, ketone, azido, nitro, silyl, sulfo-oxo or thiol as described herein.

A term "cycloalkenyl" as used herein is a non-aromatic carbon-based ring of 3 to 30 carbon atoms which consists of at least 3 carbon atoms and contains at least one carbon-carbon double bond, i.e. C=C. Examples of cycloalkenyl include, but are not limited to, cyclopropenyl, cyclobutenyl, cyclopentenyl, cyclopentadienyl, cyclohexenoyl, cycloheptene, and the like. A term "heterocyclic alkenyl" is a type of cycloalkenyl as defined above and is included in meaning of the term "cycloalkenyl" in which at least one carbon atom of the ring is substituted with a heteroatom such as, but not limited to, a nitrogen, oxygen, sulfur or phosphorus atom. The cycloalkenyl and heterocyclic alkenyl may be substituted or unsubstituted. The cycloalkenyl and heterocyclic alkenyl may be substituted with one or more groups including, but not limited to, alkyl, cycloalkyl, alkoxy, alkenyl, cycloalkenyl, alkynyl, cycloalkynyl, aryl, heteroaryl, aldehyde, amino, carboxylic acid, ester, ether, halogen, hydroxy, ketone, azido, nitro, silyl, sulfo-oxo or thiol as described herein.

A term "alkynyl" as used herein is a hydrocarbon having 2 to 30 carbon atoms and having a structural formula containing at least one carbon-carbon triple bond. The alkynyl may be unsubstituted or substituted with one or more groups including, but not limited to, alkyl, cycloalkyl, alkoxy, alkenyl, cycloalkenyl, alkynyl, cycloalkynyl, aryl, heteroaryl, aldehyde, amino, carboxylic acid, ester, ether, halogen, hydroxy, ketone, azido, nitro, silyl, sulfo-oxo or thiol as described herein.

A term "cycloalkynyl" as used herein is a non-aromatic carbon-based ring that contains at least 7 carbon atoms and contains at least one carbon-carbon triple bond. Examples of cycloalkynyl include, but are not limited to, cycloheptynyl, cyclooctynyl, cyclononynyl, and the like. A term "heterocyclic alkynyl" is a cycloalkenyl as defined above and is included within meaning of the term "cycloalkynyl" in which at least one of the carbon atoms of the ring is replaced by a heteroatom such as, but not limited to, a nitrogen, oxygen, sulfur or phosphorus atom. The cycloalkynyl and heterocyclic alkynyl may be substituted or unsubstituted. The cycloalkynyl and heterocyclic alkynyl may be substituted with one or more groups including, but not limited to, alkyl, cycloalkyl, alkoxy, alkenyl, cycloalkenyl, alkynyl, cycloalkynyl, aryl, heteroaryl, aldehyde, amino, carboxylic acid, ester, ether, halogen, hydroxy, ketone, azido, nitro, silyl, sulfo-oxo or thiol as described herein.

A term "aryl" as used herein refers to a group containing 60 or less carbon atoms of any carbon-based aromatic group, including but not limited to benzene, naphthalene, phenyl, biphenyl, phenoxybenzene, and the like. The term "aryl" further includes "heteroaryl", which is defined as a group containing an aromatic group having at least one heteroatom within a ring. Examples of heteroatoms include, but are not limited to, a nitrogen, oxygen, sulfur, or phosphorus atom. Likewise, a term "non-heteroaryl" (which is also included in the term "aryl") defines an aromatic-containing group that is free of heteroatoms. The aryl may be substituted or unsubstituted. The aryl may be substituted with one or more groups including, but not limited to, alkyl, cycloalkyl, alkoxy, alkenyl, cycloalkenyl, alkynyl, cycloalkynyl, aryl, heteroaryl, aldehyde, amino, carboxylic acid, ester, ether, halogen, hydroxy, ketone, azido, nitro, silyl, sulfo-oxo or thiol as described herein. A term "biaryl" is a particular type of aryl and is included in definition of "aryl". The biaryl refers to two aryl joined together by a fused ring structure, as in naphthalene, or two aryl joined by one or more carbon-carbon bonds, as in biphenyl.

A term "aldehyde" as used herein is represented by a formula -C(O)H. Throughout this specification, "C(O)" is a short form of carbonyl (i.e., C=O).

A term "amine" or "amino" as used herein is represented by the formula -NR¹R², where R¹ and R² may independently be selected from hydrogen, alkyl, cycloalkyl, alkenyl, cycloalkenyl, alkynyl, cycloalkynyl, aryl or heteroaryl.

A term "alkylamino" as used herein is represented by a formula -NH(-alkyl), where the alkyl is as described in the present disclosure. Representative examples include, but are not limited to, methylamino, ethylamino, propylamino, isopropylamino, butylamino, isobutylamino, sec-butylamino, tert-butylamino, pentylamino, isopentylamino, tert-pentylamino, hexylamino and the like.

A term "alkylamino" as used herein is represented by a formula -N(-alkyl)₂, where the alkyl is as described in the present disclosure. Representative example include, but are not limited to, dimethylamino, diethylamino, dipropylamino, diisopropylamino, dibutylamino, diisobutylamino, di-sec-butylamino, di-tert-butylamino, dipentylamino, diisopentylamino, di-tert-pentylamino, dihexylamino, N-ethyl-N-methylamino, N-methyl-N-propylamino, N-ethyl-N-propylamino and the like.

A term "carboxylic acid" as used herein is represented by a formula -C(O)OH.

A term "ester" as used herein is represented by a formula -OC(O)R¹ or -C(O)OR¹, where R¹ may be alkyl, cycloalkyl, alkenyl, cycloalkenyl, alkynyl, cycloalkynyl, aryl or heteroaryl as described herein. A term "polyester" as used herein is represented by a formula -(R¹O(O)C-R²-C(O)O)ₐ- or -(R¹O(O)C-R²-OC(O))ₐ-, where R¹ and R² can independently be alkyl, cycloalkyl, alkenyl, cycloalkenyl, alkynyl, cycloalkynyl, aryl or heteroaryl as described herein and "a" is an integer between 1 to 500. The term "polyester" is used to describe groups produced by reaction between a compound having at least two carboxyl and a compound having at least two hydroxy.

A term "ether" as used herein is represented by a formula R¹OR², where R¹ and R² may independently be alkyl, cycloalkyl, alkenyl, cycloalkenyl, alkynyl, cycloalkynyl, aryl or heteroaryl as described herein. A term "polyether" as used herein is represented by a formula -(R¹O-R2O)ₐ-, where R¹ and R²may independently be alkyl, cycloalkyl, alkenyl, cycloalkenyl, alkynyl, cycloalkynyl, aryl or heteroaryl as described herein and "a" is an integer between 1 to 500. Examples of polyether groups include polyethylene oxide, polypropylene oxide and polybutylene oxide.

A term "halogen" as used herein refers to halogen fluorine, chlorine, bromine and iodine.

A term "heterocyclyl" as used herein refers to monocyclic and polycyclic non-aromatic ring systems, and "heteroaryl" as used herein refers to monocyclic and polycyclic aromatic ring systems of not more than 60 carbon atoms, where at least one of ring members is not carbon. This term includes azetidinyl, dioxane, furyl, imidazolyl, isothiazolyl, isoxazolyl, morpholinyl, oxazolyl (oxazolyl including 1,2,3- oxadiazole, 1,2,5- oxadiazole and 1,3,4-oxadiazole), piperazinyl, piperidyl, pyrazinyl, pyrazolyl, pyridazinyl, pyridinyl, pyrimidinyl, pyrrolyl, pyrrolidinyl, tetrahydrofuran, tetrahydropyranyl, tetrazinyl including 1,2,4, 5- tetrazinyl, tetrazolyl including 1,2,3,4- tetrazolyl and 1,2,4,5- tetrazolyl, thiadiazole including 1,2,3- thiadiazole, 1,2,5- thiadiazole and 1,3,4- thiadiazole, thiazolyl, thienyl, triazinyl including 1,3,5- triazinyl and 1,2,4- triazinyl, thiadiazolyl including 1,2,3- triazolinyl and 1,3,4-triazolinyl, and the like.

A term "hydroxyl" as used herein is represented by a formula -OH.

A term "ketone" as used herein is represented by a formula R¹C(O)R², where R¹ and R² may independently be alkyl, cycloalkyl, alkenyl, cycloalkenyl, alkynyl, cycloalkynyl, aryl or heteroaryl as described herein.

A term "azido" as used herein is represented by a formula -N₃.

A term "nitro" as used herein is represented by a formula -NO₂.

A term "nitrile" as used herein is represented by a formula -CN.

A term "silyl" as used herein is represented by a formula -SiR¹R²R³, where R¹, R² and R³ may independently be alkyl, cycloalkyl, alkoxy, alkenyl, cycloalkenyl, alkynyl, cycloalkynyl, aryl or heteroaryl as described herein.

A term "sulfo-oxo" as used herein is represented by a formula -S(O)R¹, -S(O)₂R¹, -OS(O)₂R¹ or -OS(O)₂OR¹, where R¹ may be alkyl, cycloalkyl, alkenyl, cycloalkenyl, alkynyl, cycloalkynyl, aryl or heteroaryl as described herein. Throughout this specification, "S(O)" is a short form of S=O. A term "sulfonyl" as used herein refers to a sulfo-oxo represented a formula -S(O)₂R¹, where R' may be alkyl, cycloalkyl, alkenyl, cycloalkenyl, alkynyl, cycloalkynyl, aryl or heteroaryl. A term "sulfone" as used herein is represented by a formula R¹S(O)₂R², where R¹ and R² may independently be alkyl, cycloalkyl, alkenyl, cycloalkenyl, alkynyl, cycloalkynyl, aryl or heteroaryl as described herein. A term "sulfoxide" as used herein is represented by a formula R¹S(O)R², where R¹ and R² may independently be alkyl, cycloalkyl, alkenyl, cycloalkenyl, alkynyl, cycloalkynyl, aryl or heteroaryl as described herein.

A term "thiol" as used herein is represented by a formula -SH.

"R¹", "R²", "R³", "Rⁿ" (where n is an integer) as used herein may independently have one or more of groups listed above. For example, if R¹ is linear alkyl, one hydrogen atom of the alkyl may be optionally substituted with hydroxy, alkoxy, alkyl, halogen or the like. Depending on a selected group, a first group may be incorporated within a second group, or the first group may be side linked (i.e., connected) to the second group. For example, for a phrase "an alkyl including amino", the amino may be incorporated within a main chain of the alkyl. Alternatively, the amino may be linked to the main chain of the alkyl. Nature of the selected group may determine whether the first group is embedded in or linked to the second group.

The compound of that present disclosure may contain an "optionally substituted" moiety. In general, a term "substituted" (whether or not a term "optionally" exists before it) means that one or more hydrogen atoms of a given moiety are substituted with a suitable substituent. Unless otherwise stated, an "optionally substituted" group may have suitable substituents at each of substitutable positions of the group, and when more than one position in any given structure may be substituted with more than one substituent selected from groups designated, the substituents may be the same or different at each position. Combinations of substituents contemplated in the present disclosure are preferably combinations that form stable or chemically feasible compounds. It is also contemplated that in certain aspects, respective substituents may be further optionally substituted (i. e., further substituted or unsubstituted) unless explicitly stated to the contrary.

A structure of the compound may be represented by a following formula: 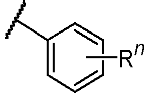 which is understood as equivalent to a following formula: 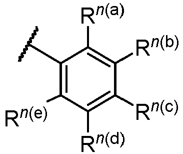
in which n is typically an integer. That is, R" is understood to indicate five individual substituents R^{*n*(a)}, R^{*n*(b)}, R^{*n*(c)}, R^{*n*(d)} and R^{*n*(e)}. "Individual substituent" means that each R substituent may be defined independently. For example, if R*^{n(a)}* is halogen in a case, R*^{n(b)}* is not necessarily halogen in this case.
R¹, R², R³, etc. are mentioned several times in chemical structures and units disclosed and described in this disclosure. Any description of R¹, R², R³, etc. in the specification is applicable to any structure or unit referring to R¹, R², R³, etc. respectively, unless otherwise specified.

A term "fused ring" as used herein means that two adjacent substituents may be fused to form a six-member aromatic ring, a heteroaromatic ring, such as a benzene ring, a pyridine ring, a pyrazine ring, a pyridazine ring, a m-diazepine ring, and the like, as well as a saturated six or seven-member carbocyclic ring or carboheterocyclic ring, and the like.

Unless otherwise specified, all commercial reagents (1-Br, 2-Br, ligand 1 and ligand 2) involved in following tests are used directly after purchase and are not further purified. Both hydrogen and carbon nuclear magnetic resonance spectra were measured in deuterated chloroform (DCl₃) or deuterated dimethyl sulfoxide (DMSO-d₆), in which the hydrogen spectra is made using a 400 or 500 MHz nuclear magnetic resonance spectrometer and the carbon spectra is made using a 100 or 126 MHz nuclear magnetic resonance spectrometer, with chemical shifts being based on tetramethylsilane (TMS) or residual solvent. If CDCl₃ is used as a solvent, TMS(δ= 0.00 ppm) and CDCl₃ (δ = 77.00 ppm) are used as internal standards for the hydrogen and carbon spectra, respectively. If DMSO-d₆ is used as a solvent, TMS(δ= 0.00 ppm) and DMSO-d₆ (δ = 39.52 ppm) are used as internal standards for the hydrogen and carbon spectra, respectively. Following abbreviations (or combinations) are used to explain hydrogen peaks: s indicates a single peak, d indicates a double peak, t indicates a triple peak, q indicates a quadruple peak, p indicates a quintic peak, m indicates a multiple peaks, and br indicates a wide peak. A high-resolution mass spectrum was measured on an ESI-QTOF mass spectrometer from Applied Biosystems, with an ionization mode of samples being electrospray ionization.

### General synthetic route

A general synthetic route of the compound according to the disclosure is as follows:

### Synthesis of compounds in formula (I):

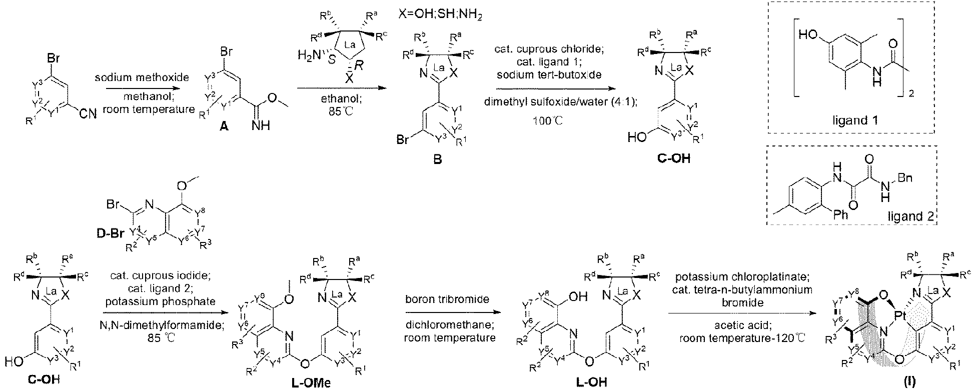

### Synthesis of compounds in formula (I'):

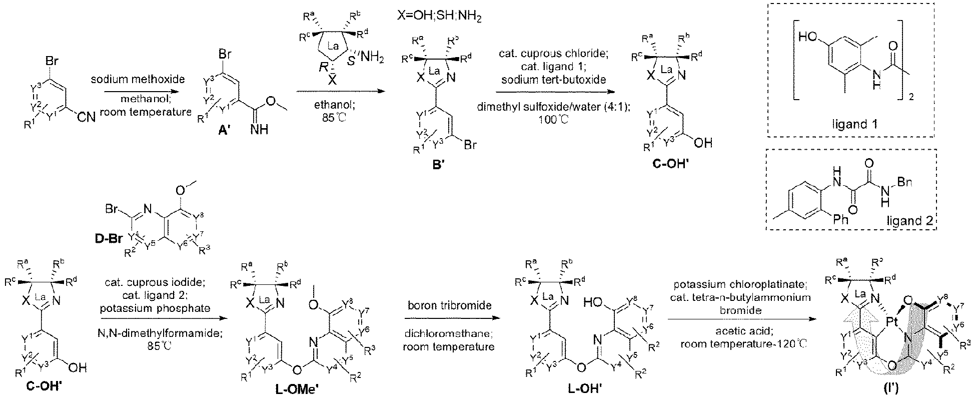

### Example 1: synthesis of enantiomer (R,S)-M-PtLD1 of tetradentate cyclometalated platinum (II) complex Pt22.

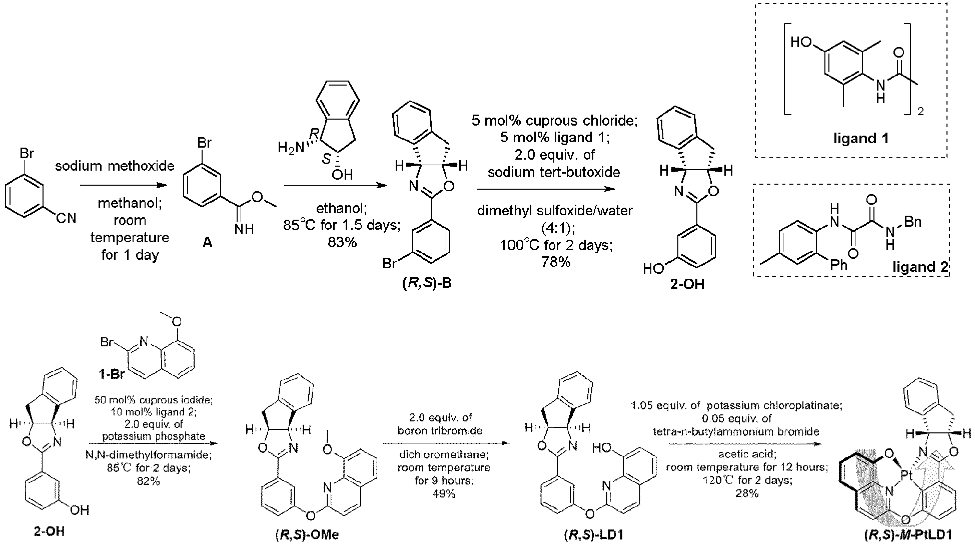

(1) Synthesis of intermediate chiral (R,S)-B: 3-Bromobenzonitrile (10 g, 54.94 mmol, 1.0 equiv.) and sodium methoxide (297 mg, 5.49 mmol, 0.1 equiv.) were sequentially added into a single-necked flask with a magnetic rotor and stirred at a room temperature for 1 day. Acetic acid was added until solid disappeared, and solvent was distilled off at a reduced pressure so as to obtain crude A, then (1R,2S)-1- amino-2,3- dihydro -1H- indene -2-ol (3.28 g, 21.97 mmol, 0.4 equiv.) and anhydrous ethanol (30 mL) were added, and this mixture was reacted with stiring in an oil bath at 85°C for 1.5 days, cooled to the room temperature, and the solvent was distilled off at a reduced pressure. The crude was separated and purified by a silica gel chromatography column with an eluent of petroleum ether/ethyl acetate of 50: 1 to 10: 1 so as to obtain a product (R, S)-B, 5.74 g as white solid, with a yield of 83%. 1H NMR (500 MHz, CDCl3): δ 3.41 (d, J = 18.5 Hz, 1H), 3.52-3.57 (m, 1H), 5.59 (s, 1H), 5.81 (d, J = 3.0 Hz, 1H), 7.27-7.31 (m, 4H), 7.60-7.65 (m, 2H), 7.98-8.00 (m, 1H), 8.13 (s, 1H).
(2) Synthesis of intermediate 2-OH: (*S,R*)-B (1.5 g, 4.77 mmol, 1.0 equiv.), cuprous chloride (24 mg, 0.24 mmol, 5 mol%), ligand 1 (87 mg, 0.24 mmol, 5 moL%) and sodium tert-butoxide (917 mg, 9.55 mmol, 2.0 equiv.) were sequentially added into a dry sealed tube with a magnetic rotor. Nitrogen was purged for three times, and dimethyl sulfoxide (8 mL) and deionized water (2 mL) were added under nitrogen protection. The sealed tube was placed in an oil bath at 110°C, stirred for reacting for 2 days, cooled to the room temperature, and then this mixture was washed with water, dilute hydrochloric acid was added to adjust to be neutral or weak acid, then sodium bicarbonate was added to adjust to weak base, ethyl acetate was added for extraction, with an aqueous layer extracted with ethyl acetate for three times, then organic phases were combined, washed once with brine, dried with anhydrous sodium sulfate, and filtered, and solvent was distilled off at a reduced pressure. The crude was separated and purified by a silica gel chromatography column with an eluent of petroleum ether/ethyl acetate of 10: 1 to 5: 1 so as to obtain a product 2-OH, 934 mg as brown solid, with a yield of 78%. 1H NMR (500 MHz, DMSO-d6): δ 3.22 (d, J = 18.0 Hz, 1H), 3.46-3.51 (m, 1H), 5.47-5.50 (m, 1H), 5.68 (d, J = 8.0 Hz, 1H), 6.87-6.90 (m, 1H), 7.21-7.3 (m, 6H), 7.43-7.44 (m, 1H), 9.67 (s, 1H).
(3) Synthesis of intermediate **(*R,S*)-OMe:** 1-Br (383 mg, 1.61 mmol, 1.5 equiv.), 2-OH (270 mg, 1.07 mmol, 1.0 equiv.) and cuprous iodide (103 mg, 0.54 mmol, 50 mol%), ligand 2 (38 mg, 0.11 mmol, 10 moL%) and potassium phosphate (454 mg, 2.14 mmol, 2.0 equiv.) were sequentially added into a dry sealed tube with a magnetic rotor. Nitrogen was purged for three times, and N,N- dimethylformamide (10 mL) was added under nitrogen protection. The sealed tube was placed in an oil bath at 85 °C, stirred for reacting for 2 days, cooled to the room temperature, then sodium bicarbonate was added to adjust to weak base, ethyl acetate was added for extraction, with a water layer extracted with ethyl acetate for three times, then organic phases were combined, washed once with brine, dried with anhydrous sodium sulfate, and filtered, and solvent was distilled off at a reduced pressure. The crude was separated and purified by a silica gel chromatography column with an eluent of petroleum ether/dichloromethane/ethyl acetate of 10:1:1 so as to obtain a product ***(R,S)*-OMe,** 358 mg as white solid, with a yield of 82%. HRMS (ESI): calcd for C₂₆H₂₁N₂O₃ [M+H]⁺ 409.1547, found 409.1532.
(4) Synthesis of ligand **(*R,S*)-LD1:** a ligand **(*R*,*S*)-OMe** (360 mg, 0.88 mmoL, 1.0 equiv.), dichloromethane (15 mL) and boron tribromide (441 mg, 1.76 mmoL, 2.0 equiv.) were added in turn to a dry three-necked flask with a magnetic rotor and stirred at room temperature for 9 hours. After reaction, water was added to quench, and then a saturated sodium bicarbonate solution was added to adjust pH to 7 to 8, a aqueous layer was extracted three times with dichloromethane, organic phases were combined, dried with anhydrous sodium sulfate and filtered, and solvent was distilled off at a reduced pressure. The crude was separated and purified by a silica gel chromatography column with an eluent of petroleum ether/ethyl acetate of 10: 1 to 5: 1 so as to obtain a product **(*R,S*)-LD1,** 170 mg as white solid, with a yield of 49%. ¹H NMR (500 MHz, DMSO-*d₆*): δ (ppm) 3.23 (d, *J =* 18.0 Hz, 1H), 3.49 (dd, *J* = 18, 6.5 Hz, 1H), 5.51-5.54 (m, 1H), 5.70 (d, *J =* 7.5 Hz, 1H), 7.07 (dd, *J =* 7.5, 1.5 Hz, 1H), 7.20 (d, *J =* 9.0 Hz, 1H), 7.22-7.30 (m, 3H), 7.33 (t, J = 8.0 Hz, 1H), 7.39 (dd, *J =* 8.5, 1.5 Hz, 1H), 7.42-7.44 (m, 2H), 7.53 (t, J = 7.5 Hz, 1H), 7.61-7.62 (m, 1H), 7.72 (dt, *J =* 8.0, 1.0 Hz, 1H), 8.36 (d, *J =* 9.0 Hz, 1H), 9.20 (s, 1H).
(5) Synthesis of (*R,S*)-*M*-PtLD1: **(*R*,*S*)-LD1** (170 mg, 0.43 mmol, 1.0 equiv.), potassium chloroplatinate (195 mg, 0.47 mmol, 1.05 equiv.), tetra-n-butylammonium bromide (7 mg, 0.022 mmol, 0.05 equiv.) were sequentially added into a 100 mL dry three-necked flask with a magnetic rotor and a condenser tube, followed by nitrogen purge for three times and addition of acetic acid (26 mL) pre-purged with nitrogen. After a reaction solution was bubbled with nitrogen for 30 minutes, it was stirred at the room temperature for 12 hours, and then was reacted with stirring at 120°C for 2 days, cooled to the room temperature, and solvent was distilled off at a reduced pressure. The crude was separated and purified by a silica gel chromatography column with an eluent of petroleum ether/dichloromethane of 2:1 to 1:1 so as to obtain a product (R,S)-M-PtLD1, 70 mg as pale yellow solid, with a yield of 28%. ¹H NMR (500 MHz, DMSO-*d₆*): δ (ppm) 3.48 (d, *J =* 18.5 Hz, 1H), 3.70 (dd, *J =* 18.5, 7.0 Hz, 1H), 5.83 (d, *J* = 7.5 Hz, 1H), 6.18-6.21 (m, 1H), 7.10 (dd, *J* = 8.0, 1.0 Hz, 1H), 7.18 (dd, *J* =8.0, 1.0 Hz, 1H), 7.26-7.39 (m, 6H), 7.45-7.48 (m, 2H), 8.22-8.23 (m, 1H), 8.62 (d, *J* = 9.0 Hz, 1H).

### Example 2: synthesis of tetradentate cyclometalated platinum (II) complex Pt22.

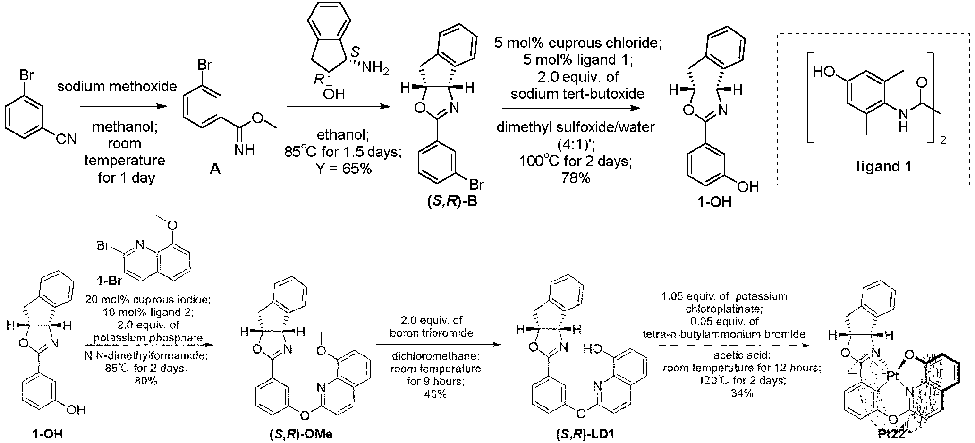

(1) Synthesis of intermediate chiral *(S,R)*-B: 3-Bromobenzonitrile (10 g, 54.94 mmol, 1.0 equiv.) and sodium methoxide (297 mg, 5.49 mmol, 0.1 equiv.) were sequentially added into a single-necked flask with a magnetic rotor and stirred at room temperature for 1 day. Acetic acid was added until solid disappeared, and solvent was distilled off at a reduced pressure so as to obtain crude A, then (1S,2R)-1- amino-2,3- dihydro -1H- indene -2-ol (4.10 g, 27.47 mmol, 0.5 equiv.) and anhydrous ethanol (30 mL) were added, and this mixture was reacted with stiring in an oil bath at 85°C for 1.5 days, cooled to the room temperature, and the solvent was distilled off at a reduced pressure. The crude was separated and purified by a silica gel chromatography column with an eluent of petroleum ether/ethyl acetate of 50: 1 to 5: 1 so as to obtain a product (*S*, *R*)*-B,* 5.60 g as white solid, with a yield of 65%. 1H NMR (500 MHz, CDCl3): δ 3.40 (d, J = 18.0 Hz, 1H), 3.51-3.56 (m, 1H), 5.57 (t, J = 7.5 Hz, 1H), 7.79 (d, J = 8.0 Hz, 1H), 7.26-7.31 (m, 4H), 7.59-7.63 (m, 2H), 7.96 (d, J = 8.0 Hz, 1H), 8.12 (t, J = 2.0 Hz, 1H).
(2) Synthesis of intermediate 2-OH: (*S,R*)-B (1.5 g, 4.77 mmol, 1.0 equiv.), cuprous chloride (24 mg, 0.24 mmol, 5 mol%), ligand 1 (87 mg, 0.24 mmol, 5 moL%) and sodium tert-butoxide (917 mg, 9.55 mmol, 2.0 equiv.) were sequentially added into a dry sealed tube with a magnetic rotor. Nitrogen was purged for three times, and dimethyl sulfoxide (8 mL) and deionized water (1 mL) were added under nitrogen protection. The sealed tube was placed in an oil bath at 110°C, stirred for reacting for 2 days, cooled to the room temperature, and then this mixture was washed with water, dilute hydrochloric acid was added to adjust to be neutral or weak acid, then sodium bicarbonate was added to adjust to weak base, ethyl acetate was added for extraction, with an aqueous layer extracted with ethyl acetate for three times, then organic phases were combined, washed once with brine, dried with anhydrous sodium sulfate, and filtered, and solvent was distilled off at a reduced pressure. The crude was separated and purified by a silica gel chromatography column with an eluent of petroleum ether/ethyl acetate of 10: 1 to 5: 1 so as to obtain a product 1-OH, 934 mg as brown solid, with a yield of 78%. 1H NMR (500 MHz, DMSO-d6): δ 3.22 (d, J = 18.0 Hz, 1H), 3.46-3.51 (m, 1H), 5.47-5.50 (m, 1H), 5.68 (d, J = 8.0 Hz, 1H), 6.87-6.90 (m, 1H), 7.21-7.3 (m, 6H), 7.43-7.44 (m, 1H), 9.67 (s, 1H).
(3) Synthesis of intermediate **(*S,R*)-OMe:** 1-Br (617 mg, 2.59 mmol, 1.3 equiv.) (commercially available), 1-OH (500 mg, 1.99 mmol, 1.0 equiv.) and cuprous iodide (76 mg, 0.40 mmol, 20 mol%), ligand **2** (69 mg, 0.20 mmol, 10 moL%) and potassium phosphate (849 mg, 4.00 mmol, 2.0 equiv.) were sequentially added into a dry sealed tube with a magnetic rotor. Nitrogen was purged for three times, and N,N- dimethylformamide (15 mL) was added under nitrogen protection. The sealed tube was placed in an oil bath at 85 °C, stirred for reacting for 2 days, cooled to the room temperature, then sodium bicarbonate was added to adjust to weak base, ethyl acetate was added for extraction, with a water layer extracted with ethyl acetate for three times, then organic phases were combined, washed once with brine, dried with anhydrous sodium sulfate, and filtered, and solvent was distilled off at a reduced pressure. The crude was separated and purified by a silica gel chromatography column with an eluent of petroleum ether/dichloromethane/ethyl acetate of 10:1:1 so as to obtain a product **(*S,R*)-OMe,** 650 mg as white solid, with a yield of 80%. HRMS (ESI): calcd for C₂₆H₂₁N₂O₃ [M+H]⁺ 409.1547, found 409.1534.
(4) Synthesis of ligand **(*S*,*R*)-LD1**: a ligand **(*S*,*R*)-OMe** (400 mg, 0.98 mmoL, 1.0 equiv.), dichloromethane (10 mL) and boron tribromide (491 mg, 1.96 mmoL, 2.0 equiv.) were added in turn to a dry three-necked flask with a magnetic rotor and stirred at room temperature for 9 hours. After reaction, water was added to quench, and then a saturated sodium bicarbonate solution was added to adjust pH to 7 to 8, a aqueous layer was extracted three times with dichloromethane, organic phases were combined, dried with anhydrous sodium sulfate and filtered, and solvent was distilled off at a reduced pressure. The crude was separated and purified by a silica gel chromatography column with an eluent of petroleum ether/ethyl acetate of 10: 1 to 5: 1 so as to obtain a product **(*S,R*)-LD1,** 155 mg as white solid, with a yield of 40%. ¹H NMR (500 MHz, DMSO-*d₆*): δ (ppm) 3.23 (d, *J =* 18.0 Hz, 1H), 3.49 (dd, *J* = 18, 6.5 Hz, 1H), 5.51-5.54 (m, 1H), 5.70 (d, *J =* 7.5 Hz, 1H), 7.07 (dd, *J =* 7.5*,* 1.5 Hz, 1H), 7.20 (d*, J =* 9.0 Hz, 1H), 7.22-7.30 (m, 3H), 7.33 (t, J = 8.0 Hz, 1H), 7.39 (dd, *J =* 8.5, 1.5 Hz, 1H), 7.42-7.44 (m, 2H), 7.53 (t, J = 7.5 Hz, 1H), 7.61-7.62 (m, 1H), 7.72 (dt, *J =* 8.0, 1.0 Hz, 1H), 8.36 (d, *J =* 9.0 Hz, 1H), 9.20 (s, 1H).
(5) Synthesis of **Pt22: (*S*,*R*)-LD1** (120 mg, 0.30 mmol, 1.0 equiv.), potassium chloroplatinate (133 mg, 0.32 mmol, 1.05 equiv.), tetra-n-butylammonium bromide (5 mg, 0.015 mmol, 0.05 equiv.) were sequentially added into a 100 mL dry three-necked flask with a magnetic rotor and a condenser tube, followed by nitrogen purge for three times and addition of acetic acid (18 mL) pre-purged with nitrogen. After a reaction solution was bubbled with nitrogen for 30 minutes, it was stirred at the room temperature for 12 hours, and then was reacted with stirring at 120°C for 2 days, cooled to the room temperature, and solvent was distilled off at a reduced pressure. The crude was separated and purified by a silica gel chromatography column with an eluent of petroleum ether/dichloromethane of 2:1 to 1:1 so as to obtain a product Pt22, 60 mg as pale yellow solid, with a yield of 34%. ¹H NMR (500 MHz, DMSO-*d₆*): δ (ppm) 3.47 (d, *J =* 18.5 Hz, 1H), 3.70 (dd, *J =* 18.5, 7.0 Hz, 1H), 5.82 (d, *J =* 7.5 Hz, 1H), 6.18-6.21 (m, 1H), 7.10 (dd, *J* = 8.0, 1.0 Hz, 1H), 7.18 (dd, *J* =8.0, 1.0 Hz, 1H), 7.27-7.39 (m, 6H), 7.45-7.48 (m, 2H), 8.22-8.23 (m, 1H), 8.62 (d, *J =* 9.0 Hz, 1H).

### Example 3: synthesis of tetradentate cyclometalated platinum (II) complex Pt89.

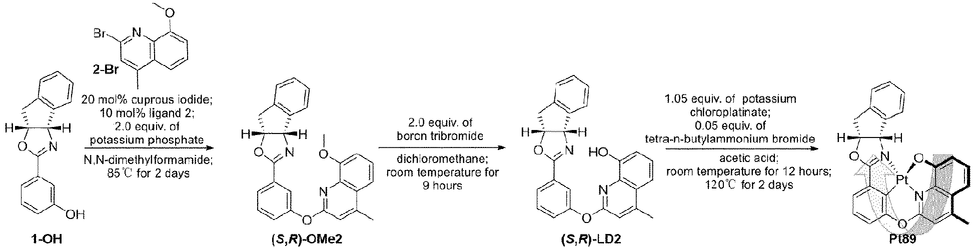

(1) Synthesis of intermediate **(*S,R*)-OMe2,** which can be referred to a synthesis method of **(*S,R*)-OMe** in Example 2, with difference that **1-Br** in Example 2 was replaced with **2-Br** commercially available for preparation.
(2) Synthesis of Intermediate **(*S,R*)-LD2.** It can be referred to a synthesis method of ligand **(*S,R*)-LD1** in Example 2, with difference that **(*S,R*)-OMe** in Example 2 was replaced with intermediate **(*S,R*)-OMe2** for preparation.
(3) Synthesis of Pt89, which can be referred to a synthesis method of **Pt22** in Example 2, with difference that **(*S,R*)-LD1** in Example 2 was replaced with intermediate **(*S,R*)-LD2** for preparation.

### Example 4: synthesis of enantiomer (R,S)-M-PtLD2 of tetradentate cyclometalated platinum (II) complex Pt89:

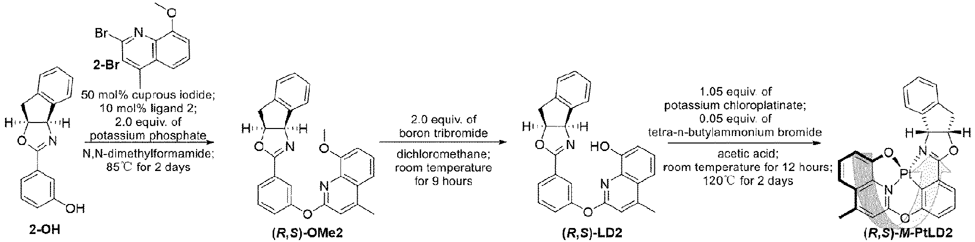

(1) Synthesis of intermediate **(*R*,*S*)-OMe2,** which can be referred to a synthesis method of **(*R,S*)-OMe** in Example 1, with difference that 1-Br in Example 1 was replaced with 2-Br commercially available for preparation.
(2) Synthesis of intermediate **(*R,S*)-LD2,** which can be referred to a synthesis method of ligand **(*R,S*)-LD1** in Example 1, and **(*S,R*)-OMe** in Example 1 is replaced with intermediate **(*R*,*S*)-OMe2** for preparation.
(3) Synthesis of **(*R,S*)-M-PtLD2,** which can be referred to a synthesis method of **(*R*,*S*)-*M*-PtLD1** in Example 1, with difference that **(*S*,*R*)-LD1** in Example 2 was replaced with intermediate **(*S,R*)-LD2** for preparation.

### Example 5: synthesis of tetradentate cyclometalated platinum (II) complex Pt93:

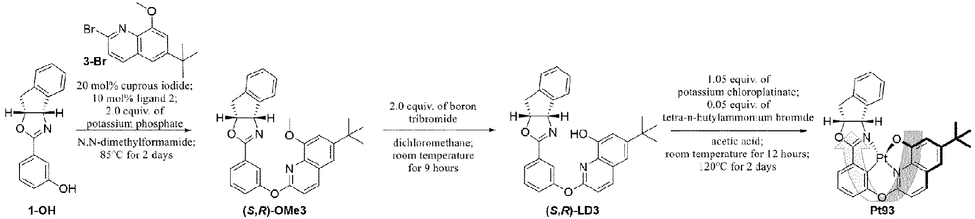

(1) Synthesis of intermediate **(*S,R*)-OMe3,** which can be referred to a synthesis method of **(*S,R*)-OMe** in Example 2, and **1-Br** in Example 2 was replaced with **3-Br** commercially available for preparation.
(2) Synthesis of Intermediate **(*S,R*)-LD3.** It can be referred to a synthesis method of ligand **(*S,R*)-LD1** in Example 2, and **(*S,R*)-OMe** in Example 2 was replaced with intermediate **(*S,R*)-OMe3** for preparation.
(3) Synthesis of **Pt93,** which can be referred to a synthesis method of **Pt22** in Example 2.

### Example 6: synthesis of enantiomer (R,S)-M-PtLD3 of tetradentate cyclometalated platinum (II) complex Pt93.

Its synthetic route can be referred to a synthetic method of Pt93 in Example 5, and an original chiral amino alcohol raw material was replaced with a chiral amino alcohol raw material of its enantiomer for preparation.

### Example 7: synthesis of tetradentate cyclometalated platinum (II) complex Pt97.

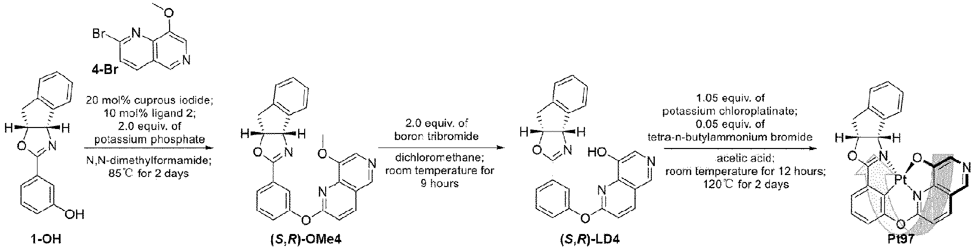

(1) Synthesis of intermediate **(*S,R*)-OMe4,** which can be referred to a synthesis method of **(*S,R*)-OMe** in Example 2, and **1-Br** in Example 2 was replaced with **4-Br** commercially available for preparation.
(2) Synthesis of Intermediate **(*S,R*)-LD4.** It can be referred to a synthesis method of ligand **(*S,R*)-LD1** in Example 2, and **(*S*,*R*)-OMe**1 in Example 2 was replaced with intermediate **(*S,R*)-OMe4** for preparation.
(3) Synthesis of **Pt97,** which can be referred to a synthesis method of **Pt22** in Example 2.

### Example 8: synthesis of enantiomer (R,S)-M-PtLD4 of tetradentate cyclometalated platinum (II) complex Pt97.

Its synthetic route can be referred to a synthetic method of Pt97 in Example 7, and an original chiral amino alcohol raw material was replaced with a chiral amino alcohol raw material of its enantiomer for preparation.

### Example 9: synthesis of tetradentate cyclometalated platinum (II) complex Pt42.

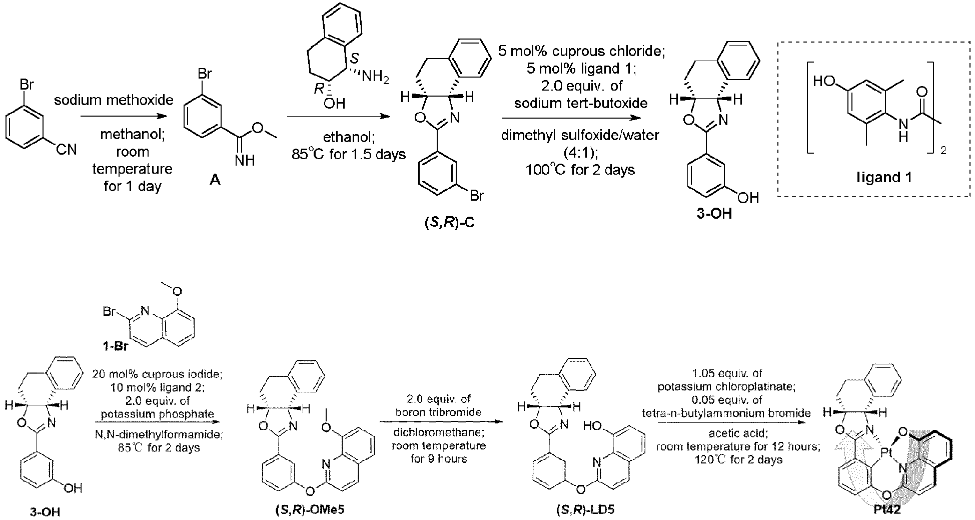

(1) Synthesis of intermediate **(*S,R*)-C,** which can be referred to a synthesis method of **(*S,R*)-B** in Example 2, chiral amino alcohol in Example 2 was replaced with a new commercially available chiral amino alcohol for preparation.
(2) Synthesis of intermediate **3-OH,** which can be referred to a synthesis method of 1-OH in Example 2, and (*S,R*)-B in Example 2 was replaced with intermediate **(*S,R*)-C** for preparation.
(3) Synthesis of intermediate **(*S,R*)-OMe5,** which can be referred to a synthesis method of **(*S,R*)-OMe** in Example 2, and **1-OH** in Example 2 was replaced with **3-OH** commercially available for preparation.
(4) Synthesis of Intermediate **(*S,R*)-LD5.** It can be referred to a synthesis method of ligand **(*S,R*)-LD1** in Example 2, and **(*S*,*R*)-OMe**1 in Example 2 was replaced with intermediate **(*S,R*)-OMe5** for preparation.
(5) Synthesis of **Pt42,** which can be referred to a synthesis method of **Pt22** in Example 2.

### Example 10: synthesis of enantiomer (R,S)-M-PtLD5 of tetradentate cyclometalated platinum (II) complex Pt42.

Its synthetic route can be referred to a synthetic method of **Pt42** in Example 9, and an original chiral amino alcohol raw material was replaced with a chiral amino alcohol raw material of its enantiomer for preparation.

### Example 11: Synthesis route of tetradentate cyclometalated platinum (II) complex Pt480.

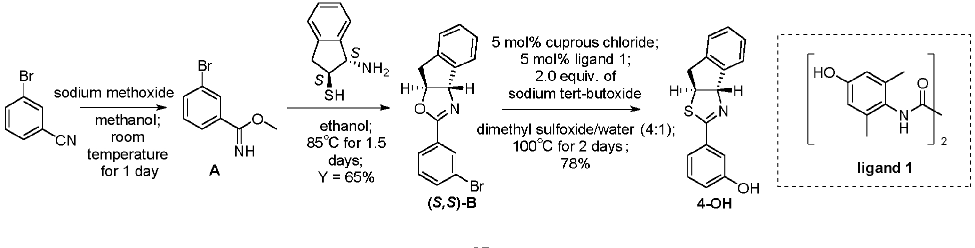

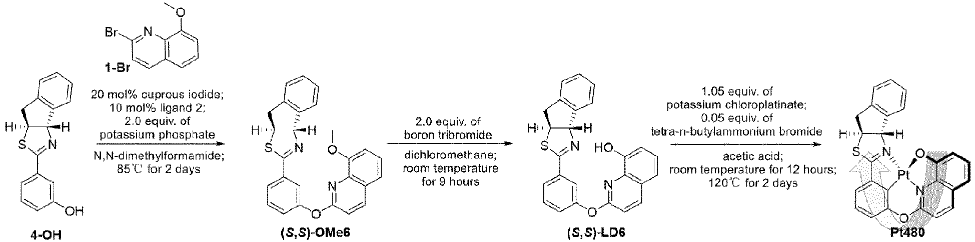

(1) Synthesis of intermediate **(*S,S*)-B,** which can be referred to a synthesis method of **(*S,R*)-B** in Example 2, chiral amino alcohol in Example 2 was replaced with a new commercially available chiral aminothiol raw material for preparation.
(2) Synthesis of intermediate **4-OH,** which can be referred to a synthesis method of **1-OH** in Example 2, and (*S,R*)-B in Example 2 was replaced with intermediate **(*S,S*)-B** for preparation.
(3) Synthesis of intermediate **(*S*,*S*)-OMe6**, which can be referred to a synthesis method of **(*S,S*)-OMe** in Example 2, and **1-OH** in Example 2 was replaced with **4-OH** commercially available for preparation.
(4) Synthesis of Intermediate **(*S,S*)-LD6.** It can be referred to a synthesis method of ligand **(*S,R*)-LD1** in Example 2, and **(*S*,*R*)-OMe1** in Example 2 was replaced with intermediate **(*S*,*S*)-OMe6** for preparation.
(5) Synthesis of **Pt480,** which can be referred to a synthesis method of **Pt22** in Example 2.

### Example 12: synthesis of enantiomer (S,S)-M-PtLD6 of tetradentate cyclometalated platinum (II) complex Pt480.

Its synthetic route can be referred to a synthetic method of **Pt480** in Example 11, and an original chiral amino alcohol raw material was replaced with a chiral aminothiol raw material of its enantiomer for preparation.

### Electrochemical, photophysical test and theoretical calculations

Absorption spectra were measured on an Agilent 8453 UV-Vis spectrometer, steady-state emission experiments and lifetime measurements on a Horiba Jobin Yvon FluoroLog-3 spectrometer, or steady-state emission spectroscopy on a SHIMADZU RF-6000 spectrometer. A low temperature (77 K) emission spectrum and lifetime were measured in a 2- methyltetrahydrofuran (2-MeTHF) solution cooled using liquid nitrogen. Theoretical calculation of Pt(II) complex is carried out by using Gaussian 09 software package, a geometric structure of a ground-state (S0) molecule is optimized by density functional theory (DFT), and DFT calculation is carried out by B3LYP functional, in which a 6-31G(d) basis set is used for C, H, O and N atoms, and a LANL2DZ basis set is used for Pt atoms. Enantiomeric purity (ee value) was determined on a chiral column EnantiopakR-C (with a specification of 4.6×250 mm, 5 um).

### Experimental data and analysis

FIG. 1 shows a design idea of a helical chiral tetradentate cyclometalated metal complex with metal ion as a center according to the disclosure. As can be seen from FIG. 1, in the disclosure, the optically pure raw materials are economical and easy to be obtained; helical chirality can be generated by autonomous induction of central chirality; there's no need for chiral resolution for the circularly polarized luminescence material, which greatly saves preparation cost of the optical pure materials, and the circularly polarized luminescence material can be prepared in a large amount and is not limited by resolution of a chiral preparation column.

FIG. 2 shows a molecular structure of the tetradentate cyclometalated platinum (II) complex optimized by density functional theory (DFT) calculation, in which (A) is a top view, (B) is a front view, and (C) is a structural view. As can be seen from FIG. 2, all ligands with central chirality of (R,S) can autonomously induce generation of M type helical chirality, and all ligands with central chirality of (S,R) can mainly induce generation of P type helical chirality, and M type helical chiral molecules and P type helical chiral molecules are enantiomers to each other. In addition, a molecular structure of the tetradentate palladium (II) complex optimized by DFT calculation has similar results.

In the disclosure, the tetradentate cyclometalated platinum (II) complexes PtONN1 and PtONN3 are compared, and their structures are shown as follows. Because they are achiral molecules, specific rotation ([a]²⁰_{D}) and asymmetry factor (*g*_{PL}) are both zero, and there is no circular polarization luminescence.

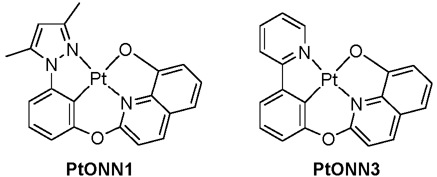

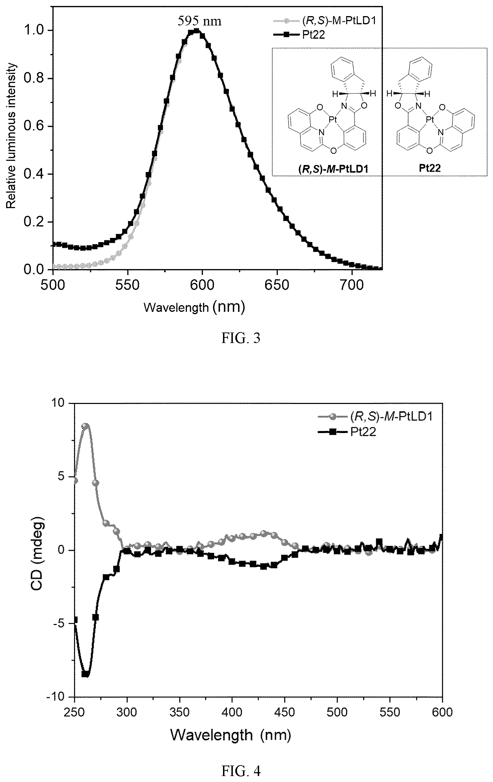

FIG. 3 is emission spectra of (*R,S*)-M-PtLD1 and Pt22 in a dichloromethane solution according to the disclosure. As can be seen from FIG. 3, the emission spectra of (R,S)-M-PtLD1 and Pt22 are basically identical, which further proves that material molecules (R,S)-M-PtLD1 and Pt22 are enantiomers.

FIG. 4 is the emission spectrum of Pt22 and (R,S)-M-PtLD1 in dichloromethane solution, in which CD refers to a circular dichroism spectrum and a sample concentration is 5×10⁻⁵ M. As can be seen from FIG. 4, circular dichroism spectrum of Pt22 and (*R*,*S*)-*M*-PtLD1 in a dichloromethane solution have high mirror symmetry and strong Cotton effect at about 262 nm, 307 nm and 434 nm, indicating that enantiomers Pt22 and (*R,S*)-*M*-PtLD1 have strong deflection ability to linearly polarized light.

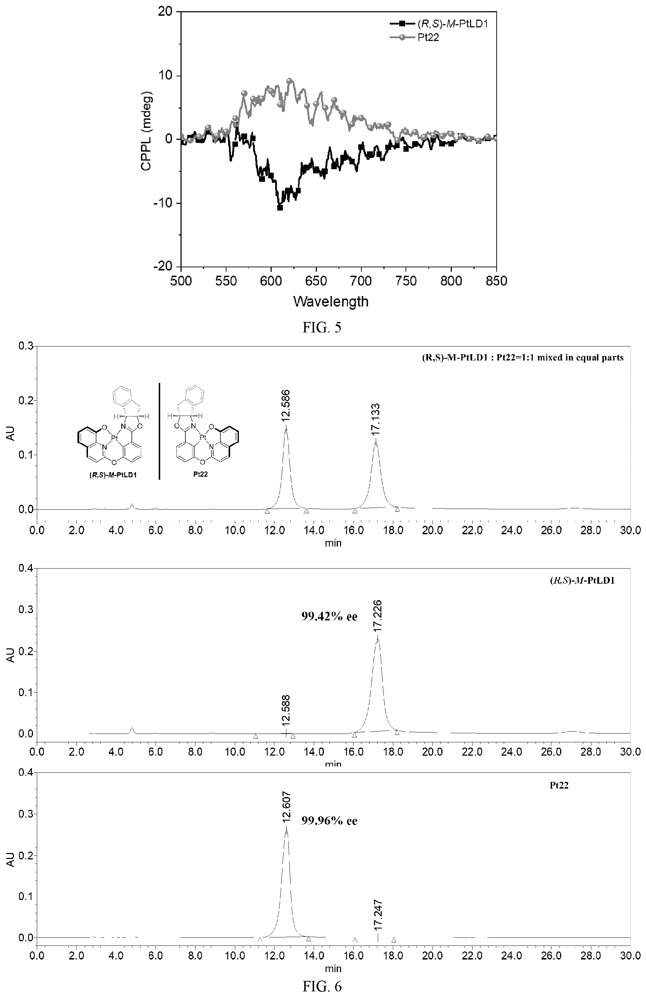

FIG. 5 is circularly polarized luminescence spectra (CPPL) of Pt22 and (*R,S*)-*M*-PtLD1 in a dichloromethane solution according to the disclosure.

The designed and developed tetradentate ligand in the disclosure can well coordinate with dsp² hybridized platinum (II) metal ions to form molecules in a stable and rigid quadrilateral configuration, with high chemical stability; meanwhile, since large steric hindrance effect exists between the designed central chiral ligand L^{a} and the ligand L¹ or L^{b} at another end, the metal complex molecule as a whole can form a stable helical chiral tetradentate cyclometalated metal complex, so that the helical chiral tetradentate cyclometalated metal complex can not be racemized and lose circularly polarized luminescence property in a solution.

FIG. 6 shows high performance liquid chromatography spectra (HPLC) of a mixture of (R,S)-M-PtLED1 and Pt22 with a ratio of 1: 1, optically pure (R,S)-M-PtLD1, and Pt22. As can be seen from FIG. 6, (*R,S*)-*M*-PtLD1 and Pt22 are both more than 99%, and they have high enantiomeric purity (ee value).

**Table 1 Specific rotation ([a]²⁰_{D}) of part of chiral raw intermediates and chiral metal complexes**

| Compound or metal complex | ee value | Specific rotation (°) | Compound or metal complex | ee value | Specific rotation (°) |
|---|---|---|---|---|---|
| **PtONN1** | | 0 | **PtONN3** | | 0 |
| **2-Br (1*R*,2*S*)** | | +157.2 | **1-Br (1*S*,2*R*)** | | -157.6 |
| **(*R,S*)-*M*-PtLD1** | >99% | -664.3 | **Pt22** | >99% | + 602.3 |

| | | | | | |
|---|---|---|---|---|---|
| Remarks: specific rotation values of all samples were determined in a dichloromethane solution. | | | | | |

Table 1 Specific rotation ([a]²⁰_{D}) of part of chiral raw intermediates and chiral metal complexes As can also be seen from the specific rotation ([a]²⁰_{D}) data in Table 1, the helical chiral tetradentate metal material molecules according to the present disclosure all show strong deflection ability for linearly polarized light. Specific rotation ([a]²⁰_{D}) of the comparative material molecules PtONN1 and PtONN3 are both zero. The designed (*R,S*)-*M*-PtLD1 and Pt22 are both single chiral materials with high optical purity, with ee values over 99%.

It further shows that even though rotatory directions of raw material intermediates and chiral metal complexes with same central chirality are completely different, and their specific rotation values are also very different. It shows that chirality of the complex with metal ion as a center has decisive influence on optical rotation of the whole compound. Meanwhile, because stimulated luminescence of the metal complexes mainly involves metal-to-ligand charge transfer states (MLCT) and intra-ligand charge transfer (ILCT) states, helical chirality and ligand structures of the metal complexes also have significant effect on circularly polarized light properties.

**Table 2: maximum emission wavelength (λₘₐₓ) and asymmetry factor (g_{PL}) for chiral metal complexes**

| Metal complex | *λ*ₘₐₓ (nm) | *g*_{PL} (×10⁻³) | Metal complex | *λ*ₘₐₓ (nm) | *g*_{PL} (×10⁻³) |
|---|---|---|---|---|---|
| **PtONN1** | | 0 | **PtONN3** | | 0 |
| **(*R*,*S*)-*M*-PtLD1** | 595 | -0.8 | **Pt22** | 595 | +1.0 |

| | | | | | |
|---|---|---|---|---|---|
| Remarks: the maximum emission wavelength (λₘₐₓ) and the asymmetry factor (*g*_{PL}) of all samples were determined in a dichloromethane solution. | | | | | |

Table 2 shows the maximum emission wavelength (λₘₐₓ) and asymmetry factor (*g*_{PL}) of chiral metal complexes. As can be seen from Table 2, all of the spiral chiral material molecules in the present disclosure show strong circularly polarized luminescence, with an absolute value of the asymmetry factor (*g*_{PL}) as high as 1.0×10⁻³.

**Table 3: Experiment for theoretical calculation of part of chiral metal complex material molecules**

| Metal complex material molecule s | Front view | Top view | LUMO energy level eV | HOMO energy level eV | Ener gy gap eV | Dihed ral angle (°) |
|---|---|---|---|---|---|---|
| Pt22 | 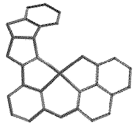 | 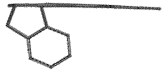 | -1.72 | -4.86 | 3.14 | 1.40 |
| Pt120 | 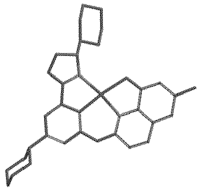 | 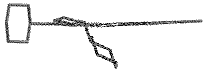 | -1.64 | -4.74 | 3.10 | 11.71 |
| Pt126 | 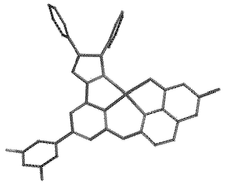 | 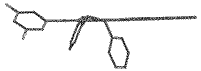 | -1.88 | -4.82 | 2.94 | 5.12 |
| Pt130 | 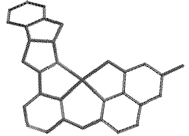 | 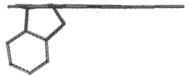 | -2.01 | -5.04 | 3.03 | 3.18 |
| Pt135 | 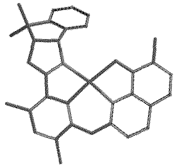 | 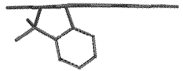 | -1.91 | -5.00 | 3.09 | 4.31 |
| Pt142 | 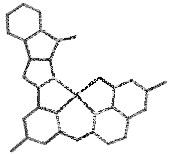 | 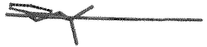 | -1.79 | -4.80 | 3.01 | 2.09 |
| Pt145 | 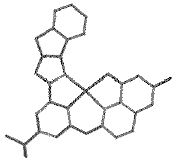 | 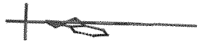 | -1.79 | -4.80 | 3.01 | 7.51 |
| Pt146 | 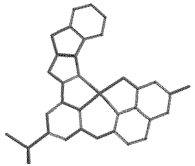 | 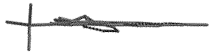 | -1.82 | -4.82 | 3.01 | 5.44 |
| Pt150 | 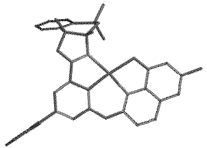 | 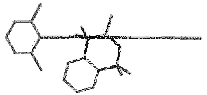 | -1.66 | -4.79 | 3.13 | 1.40 |
| Pt156 | 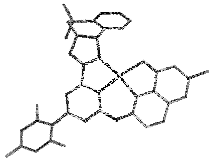 | 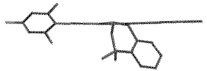 | -1.74 | -4.86 | 3.12 | 4.36 |
| Pt169 | 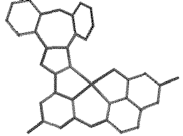 | 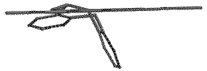 | -1.72 | -4.74 | 3.02 | 8.24 |
| Pt195 | 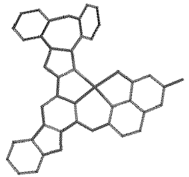 | 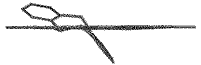 | -2.71 | -4.79 | 2.08 | 1.41 |
| Pt203 | 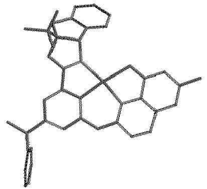 | 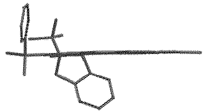 | -1.62 | -4.76 | 3.14 | 2.58 |
| Pt207 | 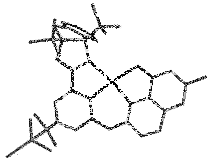 | 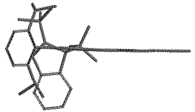 | -1.70 | -4.85 | 3.15 | 10.24 |
| Pt220 | 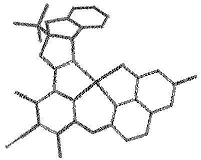 | 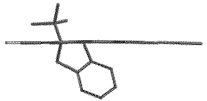 | -1.92 | -5.03 | 3.11 | 1.91 |
| Pt221 | 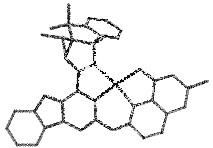 | 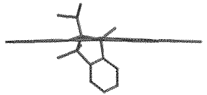 | -1.75 | -4.85 | 3.10 | 1.88 |
| Pt222 | 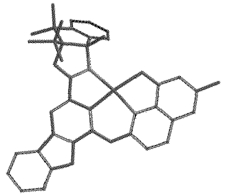 | 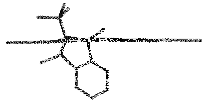 | -1.60 | -4.84 | 3.24 | 1.97 |
| Pt223 | 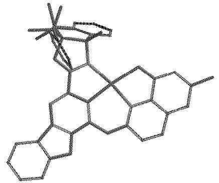 | 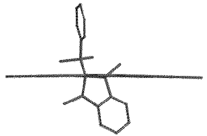 | -1.63 | -4.86 | 3.23 | 0.81 |
| Pt224 | 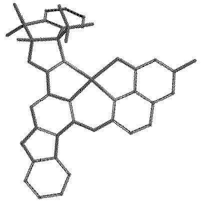 | 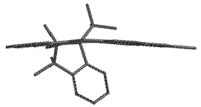 | -1.84 | -4.89 | 3.05 | 13.01 |
| Pt383 | 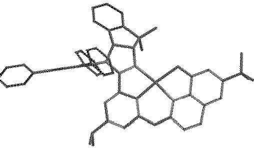 | 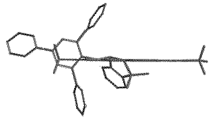 | -1.49 | -4.58 | 3.09 | 5.64 |
| Pt384 | 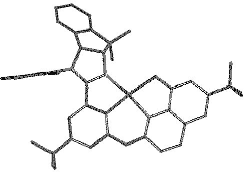 | 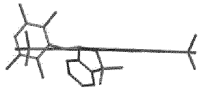 | -1.43 | -4.56 | 3.13 | 4.52 |
| Pt388 | 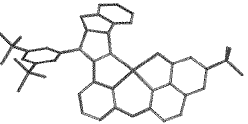 | 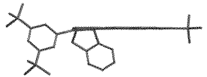 | -1.69 | -4.87 | 3.18 | 3.10 |
| Pt396 | 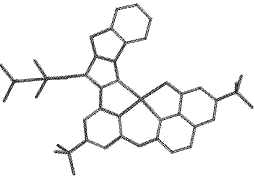 | 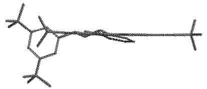 | -4.63 | -1.57 | 3.06 | 3.50 |
| Pt420 | 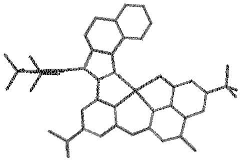 | 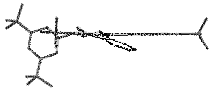 | -4.60 | -1.51 | 3.09 | 0.95 |

Remarks: the dihedral angle refers to an angle formed between the two terminal heterocyclic rings coordinated with the central metal ions.

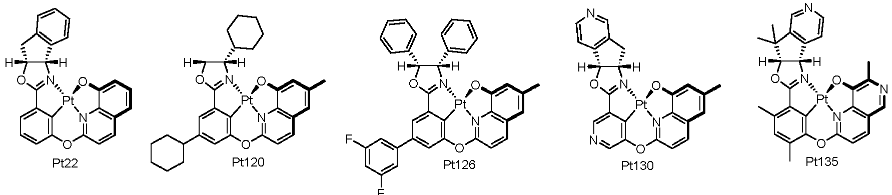

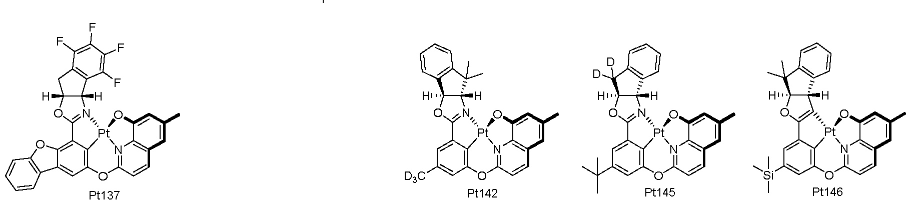

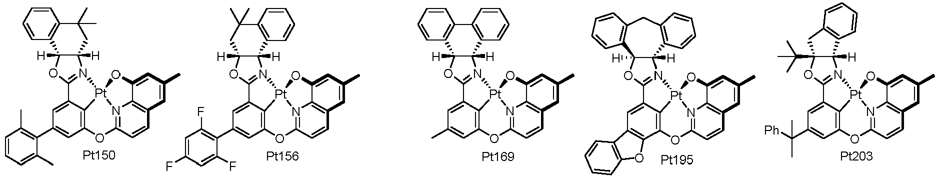

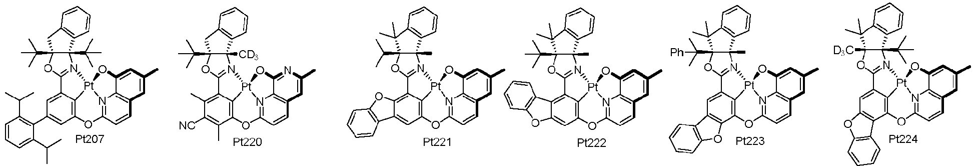

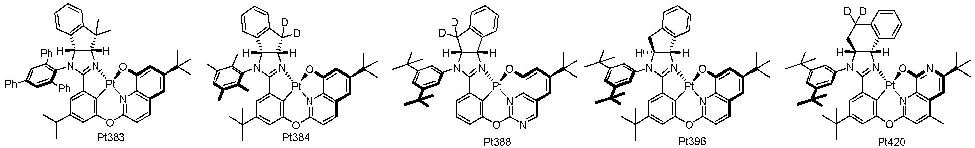

Table 3 Experimental data for theoretical calculation of part of chiral metal complex material molecules As can be seen From Table 3, such molecular parent nuclei containing chiral structural units are all in a distorted quadrilateral structure; and due to existence of ortho-chiral steric hindrance in a coordinated heterocyclic ring, two terminal heterocyclic rings coordinated with the central metal ions can be respectively positioned at two sides of a plane, so that helical chiral molecules with the central metal as the center is formed, which all can be used as circularly polarized luminescence materials.

In addition, a large amount of experimental data for theoretical calculation also indicates importance of the steric hindrance of ortho groups in the chiral structural units coordinated with the central metal, which is the key for the central chiral induction of the chiral structural units of the ligand to generate the helical chirality of the whole material molecules with the metal as the center. Meanwhile, a large number of synthetic experimental examples and characterization and testing of their photophysical properties also show that the design method of the circular polarized luminescent material molecules in the present disclosure is completely successful.

An electronic device is prepared by applying the central chirality induced helical chiral tetradentate cyclometalated platinum (II) complex with a general structure as shown in above formula (I) or (I') to the electronic device.

Preferably, the complex with a general structure shown in formula (I) or (I') is applied to the electronic device as a phosphorescent luminescent material.

The electronic device includes an organic electroluminescent device, an organic photoluminescence device, an organic integrated circuit, an organic field effect transistor, an organic thin film transistor, an organic light emitting transistor, an organic solar cell, an organic optical detector, an organic field quenching device, a light-emitting electrochemical cell or an organic laser diode.

An electronic device includes the central chirality induced helical chiral tetradentate cyclometalated platinum (II) complex with a general structure as shown in above formula (I) or (I') in an electronic device. The electronic device includes an organic electroluminescent device, an organic photoluminescence device, an organic integrated circuit, an organic field effect transistor, an organic thin film transistor, an organic light emitting transistor, an organic solar cell, an organic optical detector, an organic field quenching device, a light-emitting electrochemical cell or an organic laser diode.

The organic photoluminescence device has a structure in which at least a light-emitting layer is formed on a substrate. In addition, the organic electroluminescent device includes at least one cathode, at least one anode, and an organic layer between the at least one anode and the at least one cathode. The organic layer includes a light-emitting layer, which may be composed only of a light-emitting layer or may have more than one other organic layer besides the light-emitting layer. At least one layer in the organic layer contains the central chirality induced helical chiral tetradentate cyclometalated platinum (II) complex with a general structure shown in above formula (I) or (I'). Example of such other organic layers include a hole transport layer, a hole injection layer, an electron blocking layer, a hole blocking layer, an electron injection layer, an electron transport layer, an exciton blocking layer, and the like. The hole transport layer may be a hole injection and transport layer having a hole injection function, and the electron transport layer may be an electron injection and transport layer having an electron injection function. Respective layers of the organic light emitting device of the present disclosure may be formed by methods such as vacuum evaporation, sputtering, ion plating, or can be formed in a wet manner such as spin coating, printing, Screen Printing, and the like, and solvent used is not specifically limited.

As an example, the complex with a general structure shown in formula (I) or (I') of the present disclosure is applied to an OLED device as a phosphorescent luminescent material, with structure of:
ITO /HATCN (10 nm)/TAPC (65 nm)/ host material: luminescent material (10 wt.%, 20 nm)/TmPyPB (55 nm)/LiF/Al,
where ITO is a transparent anode; HATCN is a hole injection layer, TAPC is a hole transport layer, and the host material is 3,3'- bis (9H- carbazole -9- yl) -1,1'- biphenyl (mCBP) and 2,6bis (n-carbazolyl) pyridine (26mCPy), 1,3,5-tri(m-pyrid-3-yl-phenyl)benzene (TmPyPB) is an electron transport layer, LiF is an electron injection layer, and Al is a cathode. Numbers in nanometer (nm) in parentheses are thicknesse of films.

A molecular formula of the material used in the device is as follows:

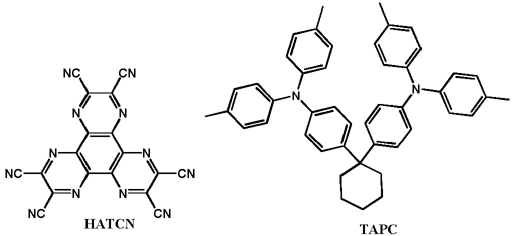

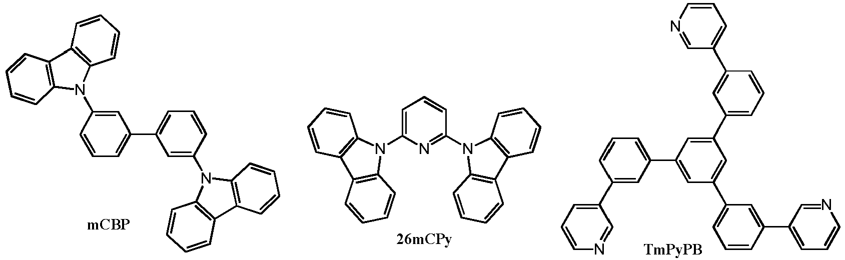

In a preferred embodiment of the present disclosure, an OLED device of the present disclosure contains a hole transport layer, a hole transport material may preferably be selected from known or unknown materials, particularly preferably from following structures, which does not imply that the present disclosure is limited to the following structures:

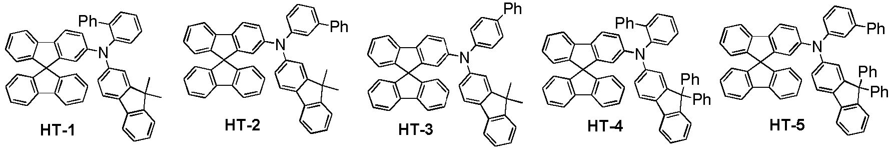

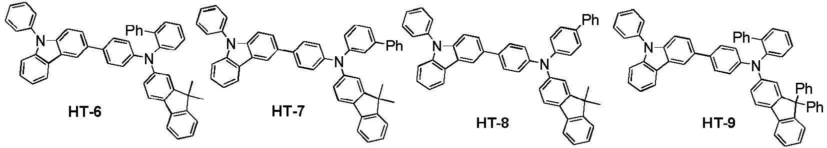

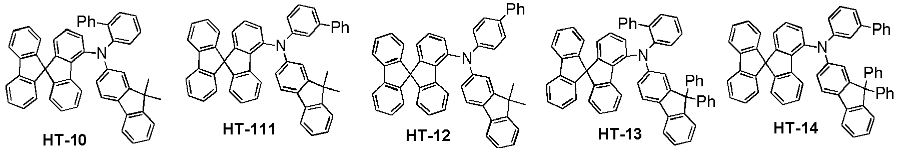

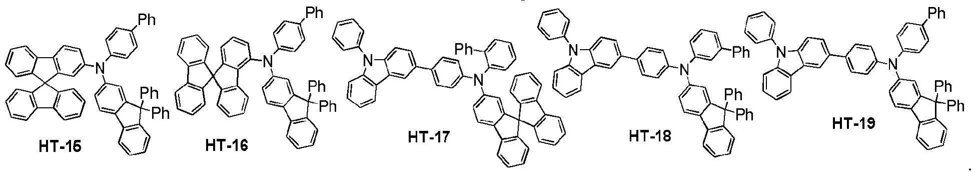

In a preferred embodiment of the present disclosure, the OLED device of the present disclosure contains a hole transport layer comprising one or more p-type dopants. A preferred p-type dopant of the present disclosure is of following structures, which does not imply that the present disclosure is limited to the following structures:

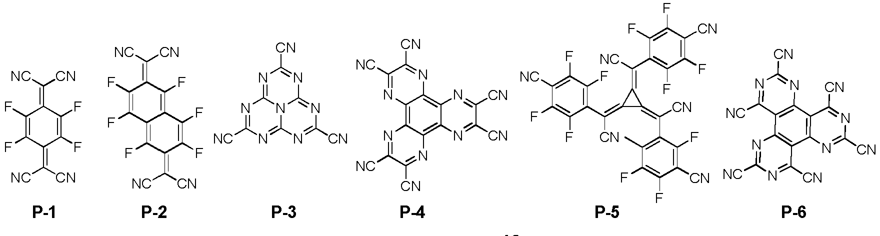

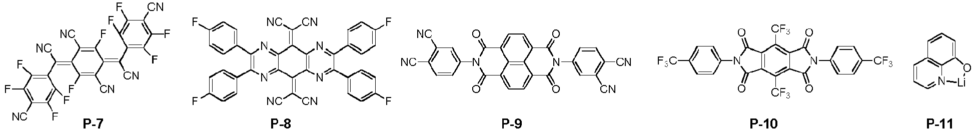

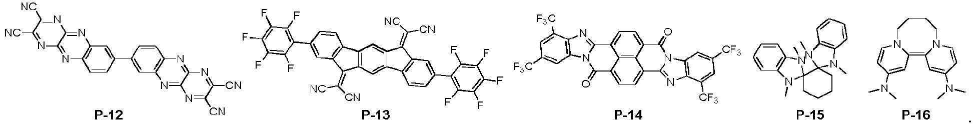

In a preferred embodiment of the present disclosure, the electron transport layer may be selected from at least one of compounds ET-1 to ET-13, which does not imply that the present disclosure is limited to following structures:

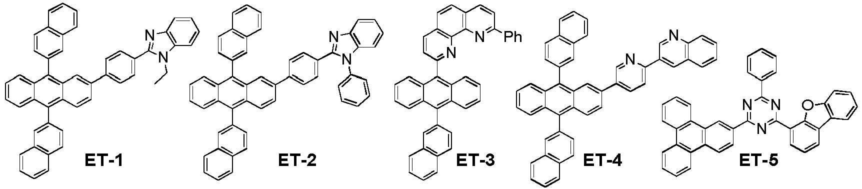

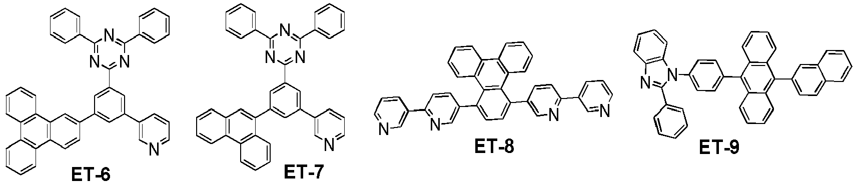

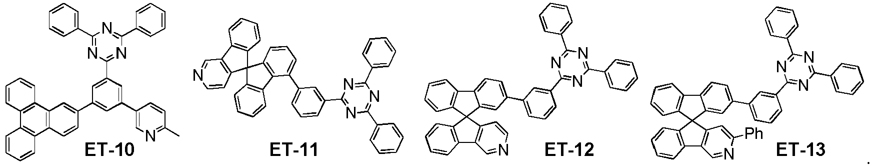

The electron transport layer may be formed of an organic material in combination with one or more n-type dopants such as LiQ.

The complex shown in Example 1 is applied to the OLED device as a circularly polarized luminescent material, with a structure expressed as follows: on glass containing ITO, a hole injection layer (HIL) of HT-1:P-3 (95:5 v/v%) with a thickness of 10 nm, a hole transport layer (HTL) of HT-1 with a thickness of 90 nm, an electron blocking layer (EBL) of HT-10 with a thickness of 10 nm, an emission layer (EML) of a host material (H-1 or H-2 or H-3 or H-4 or H-5 or H-6): the platinum complex (95:5 v/v%) according to the disclosure with a thickness of 35 nm, an electron transport layer (ETL) of ET-13: LiQ (50:50 v/v%) with a thickness of 35 nm, and an evaporated cathode of Al with a thickness of 70 nm.

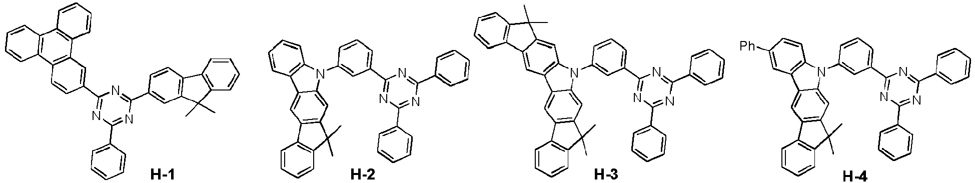

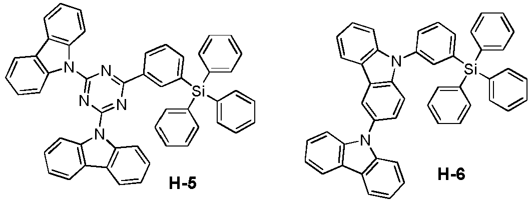

Maximum external quantum efficiency (Eqe) of an OLED device doped with Pt22 is 18.9%, with asymmetry factor (*g*_{EL}) of electroluminescence of 0.80×10⁻³.

Maximum external quantum efficiency of an OLED device doped with Pt89 is 22.5%, with asymmetry factor (*g*_{EL}) of electroluminescence of 1.23×10⁻³.

Maximum external quantum efficiency of an OLED device doped with Pt93 is 19.7%, with asymmetry factor (*g*_{EL}) of electroluminescence of 0.94×10⁻³.

Maximum external quantum efficiency of an OLED device doped with Pt42 is 21.2%, with asymmetry factor (*g*_{EL}) of electroluminescence of 1.14×10⁻³.

Maximum external quantum efficiency of an OLED device doped with Pt480 is 23.3%, with asymmetry factor (*g*_{EL}) of electroluminescence of 1.38×10⁻³.

It should be noted that the structure is an example of application of the circularly polarized luminescence material of the present disclosure and does not limit a specific structure of the OLED device of the circularly polarized luminescence material of the present disclosure, and the circularly polarized luminescence material is not limited to the compounds represented in the examples.

It should be noted that the structure is an example of application of the phosphorescent material of the present disclosure and does not limit a specific structure of the OLED device of the phosphorescent material of the present disclosure, and the phosphorescent material is not limited to the compounds represented in the examples.

## Claims

1. A central chirality induced helical chiral tetradentate cyclometalated platinum (II) complex, wherein the complex is selected from one of following structures or its enantiomers:

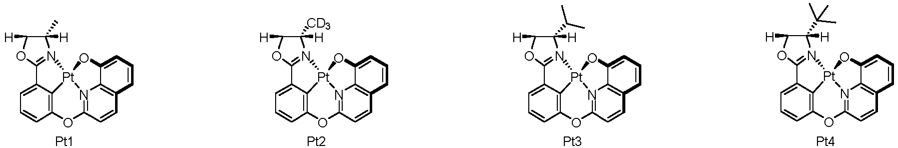

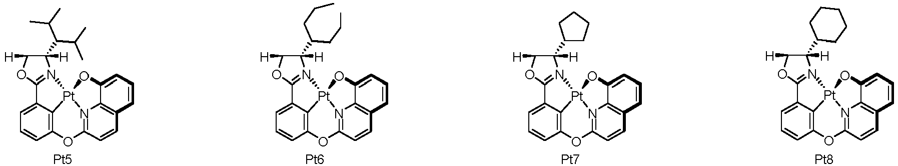

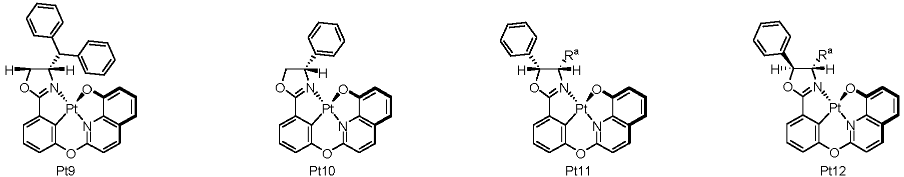

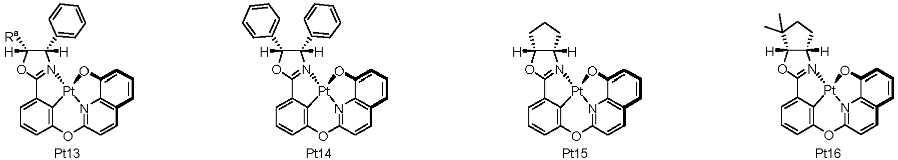

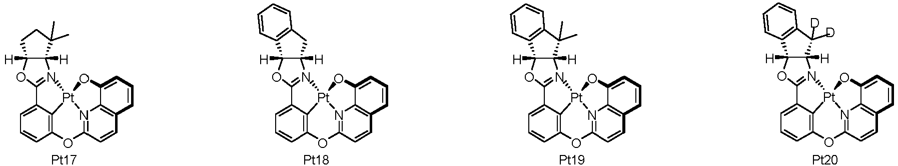

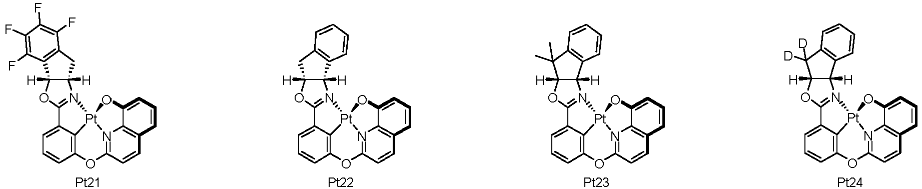

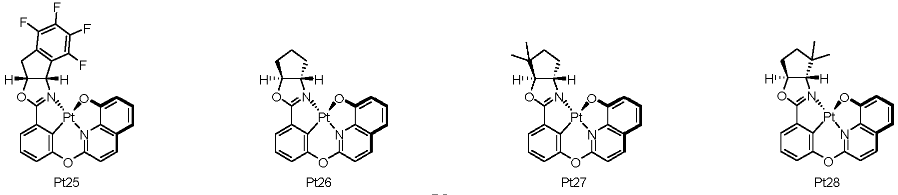

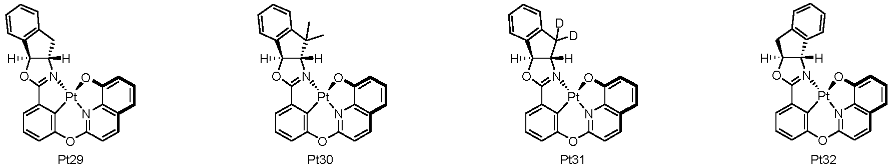

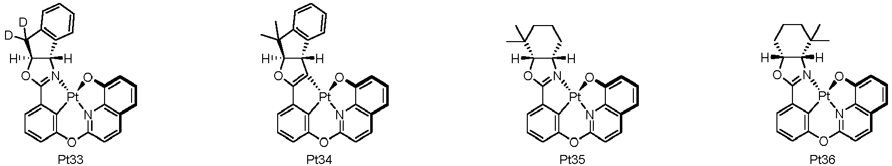

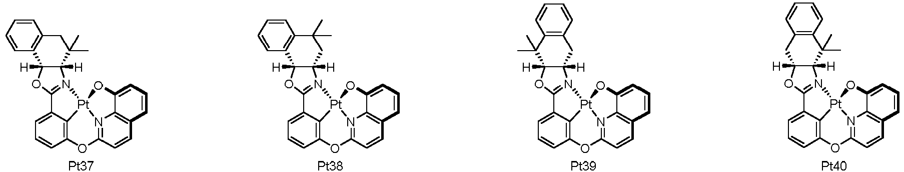

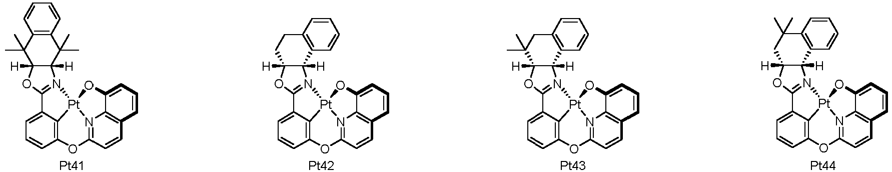

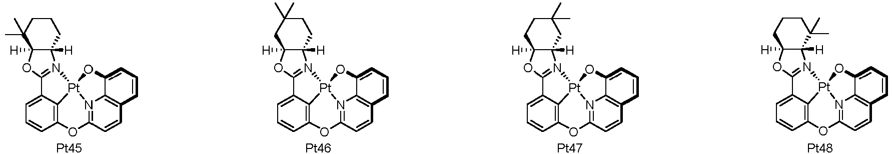

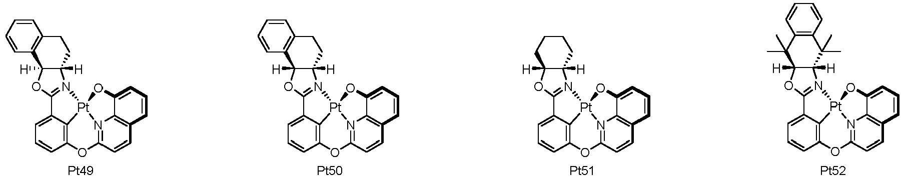

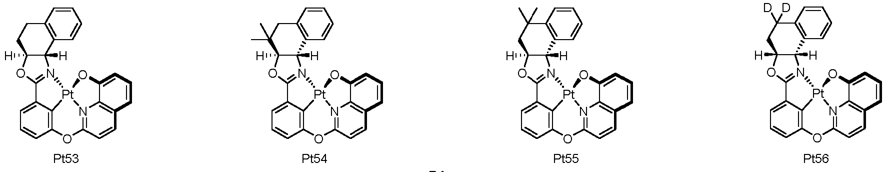

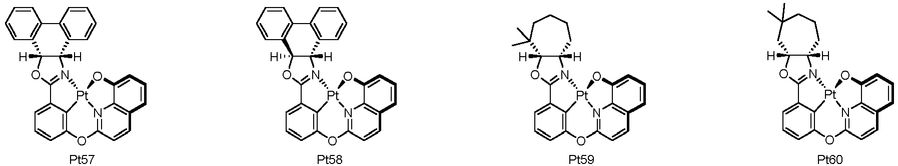

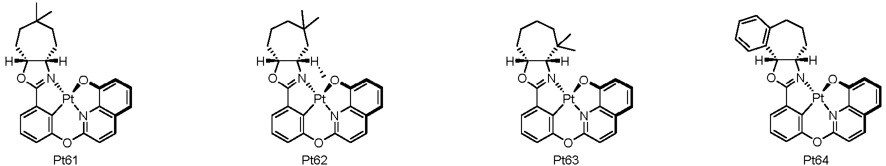

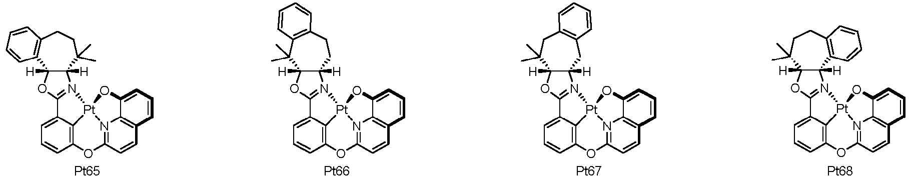

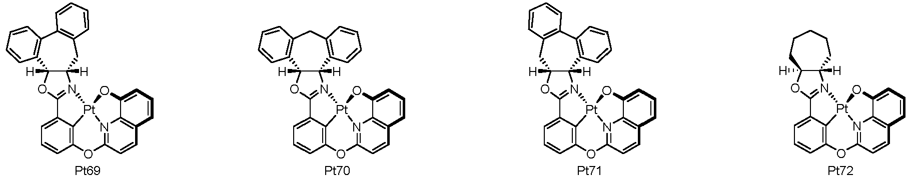

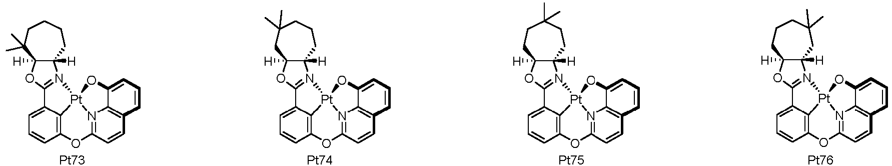

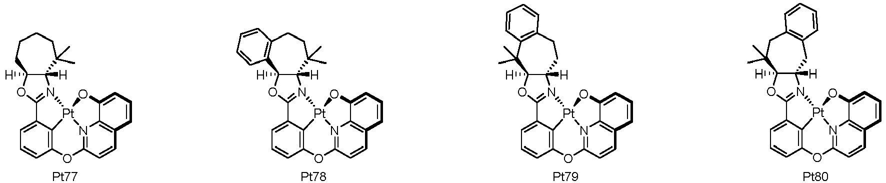

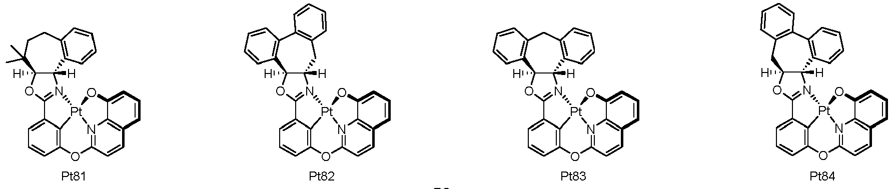

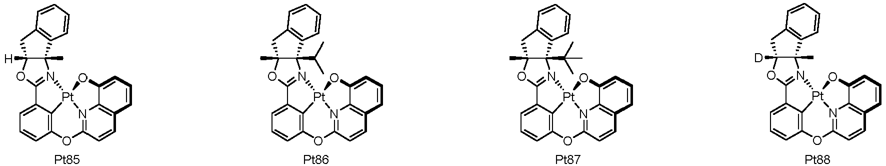

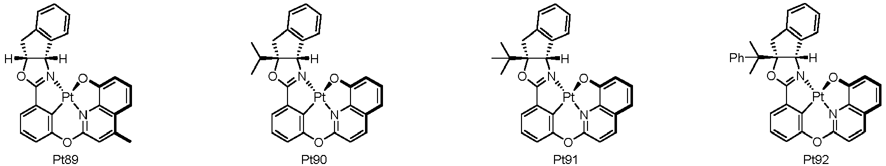

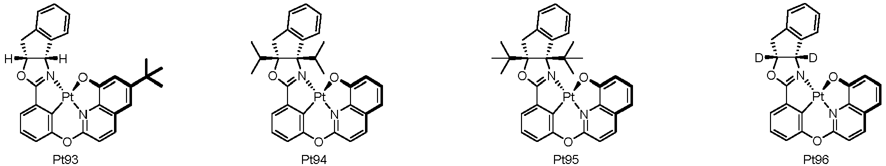

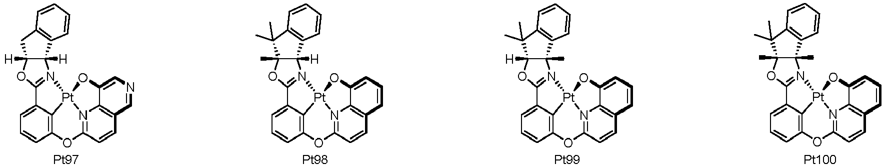

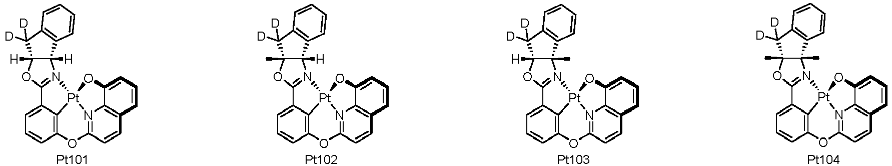

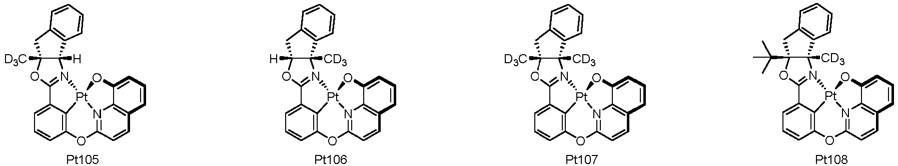

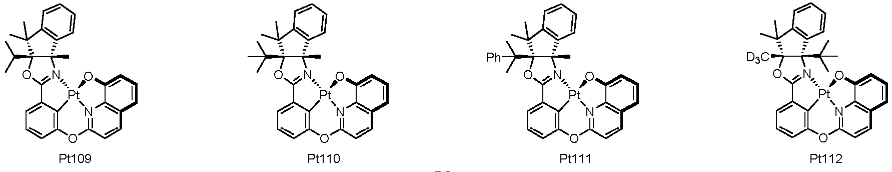

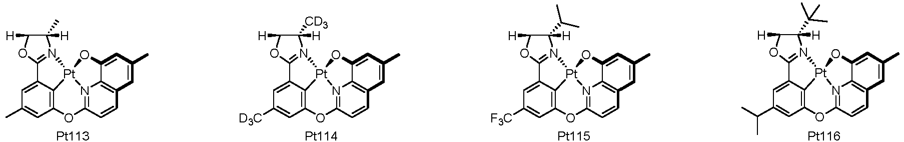

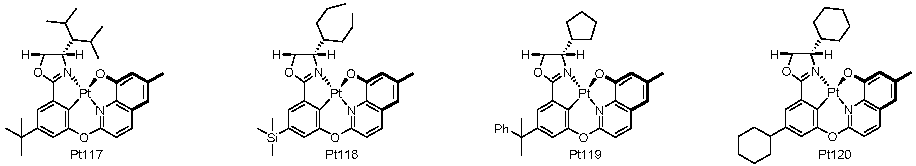

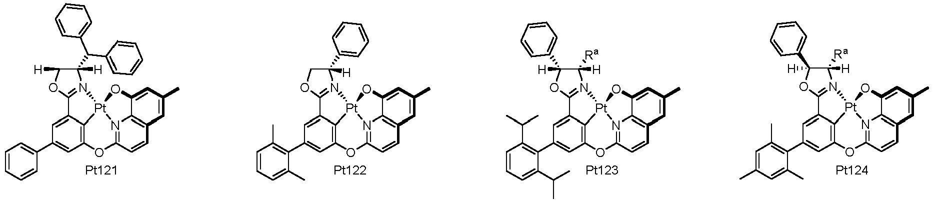

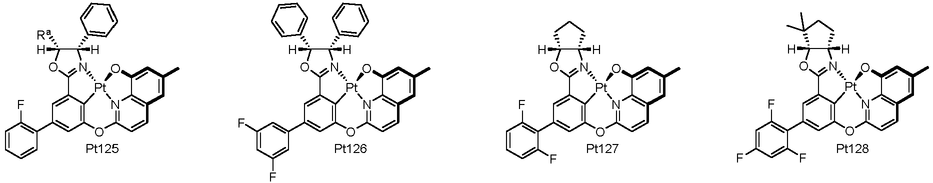

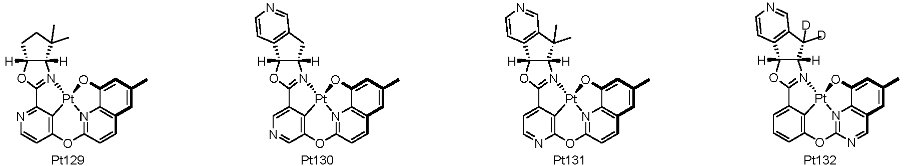

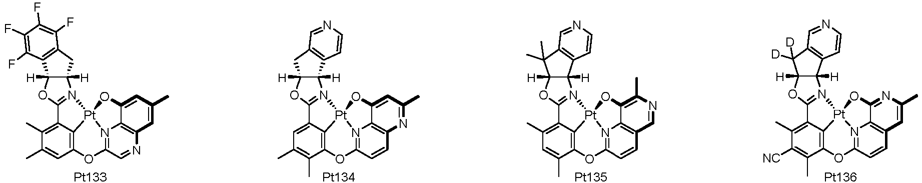

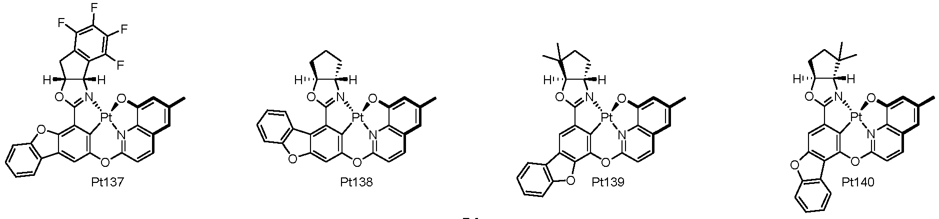

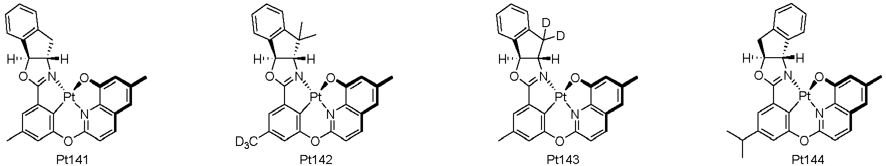

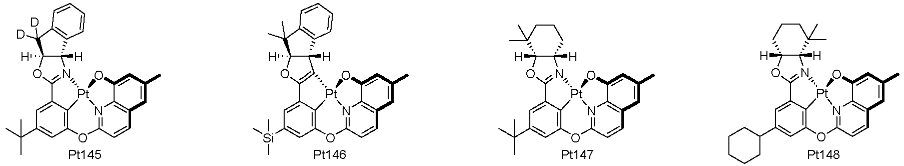

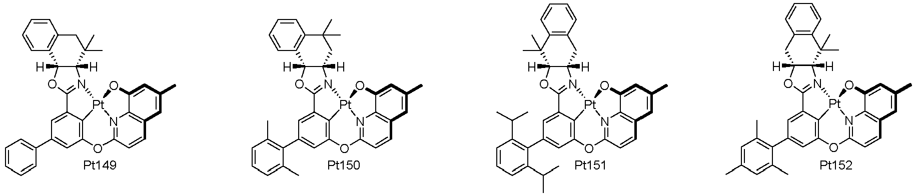

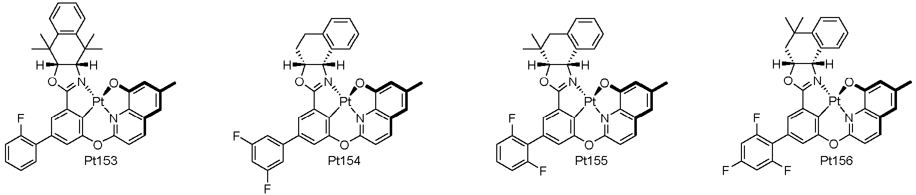

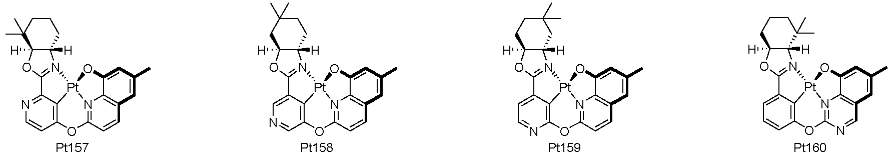

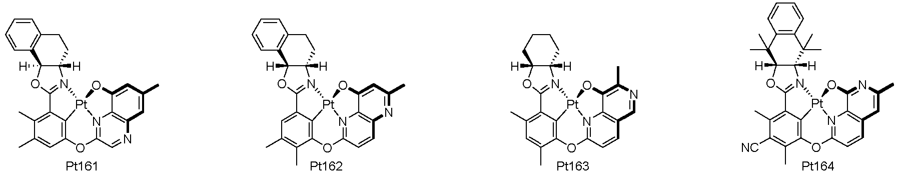

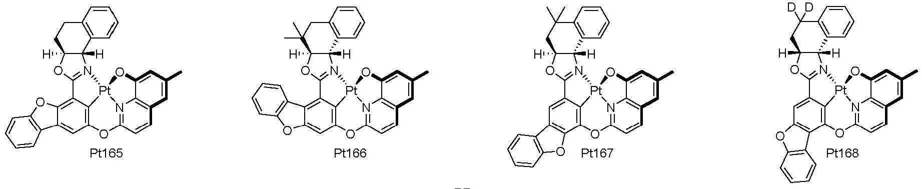

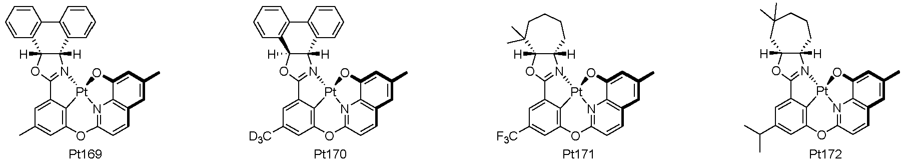

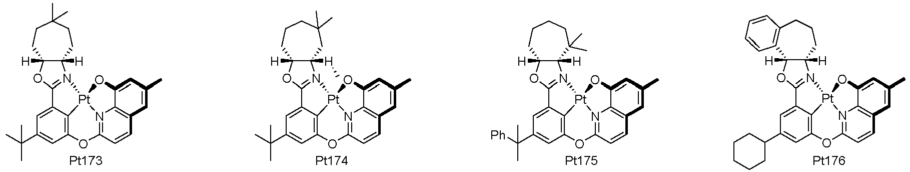

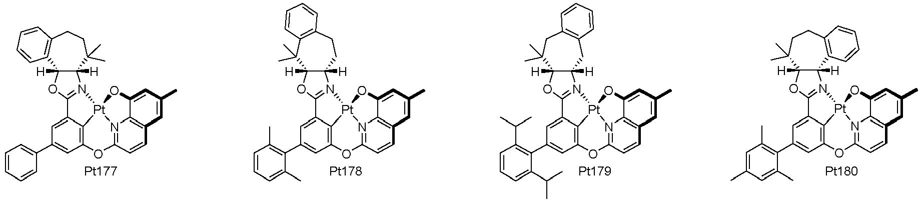

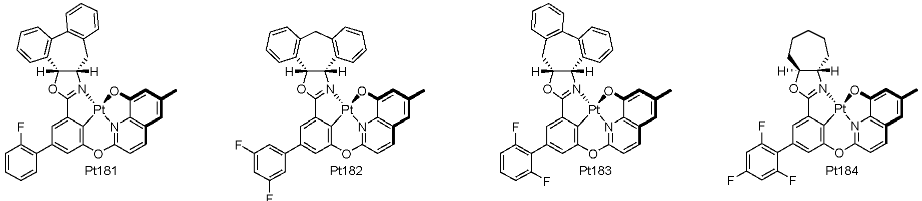

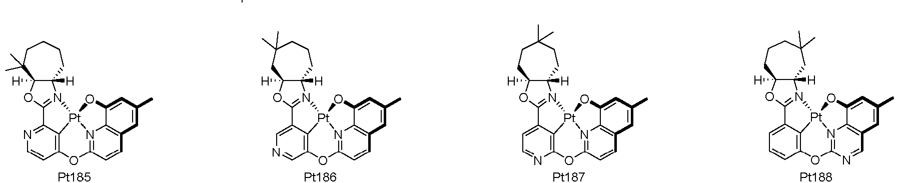

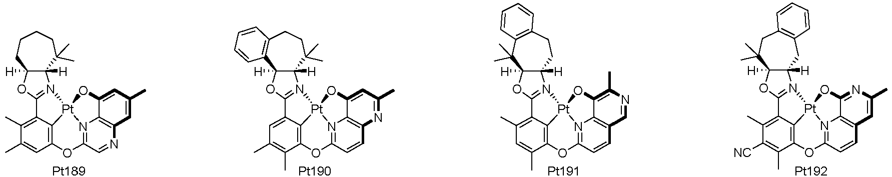

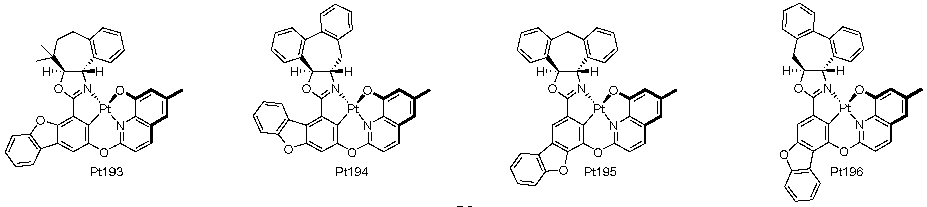

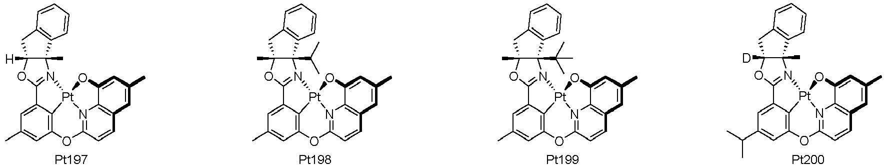

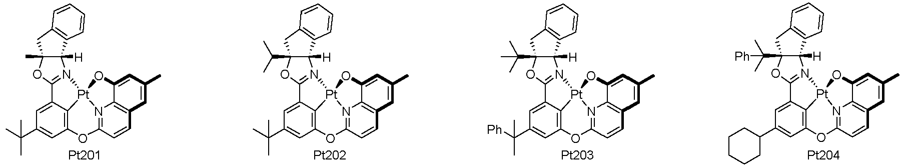

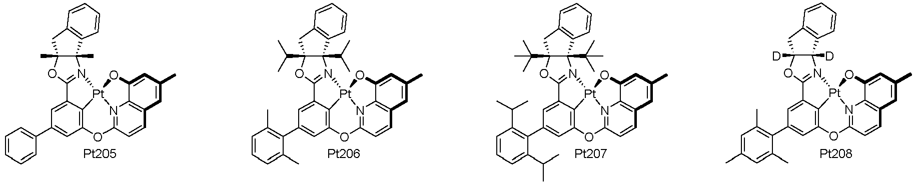

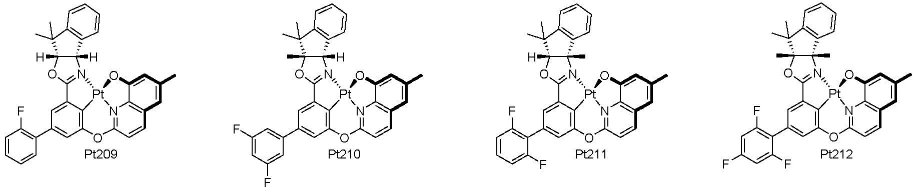

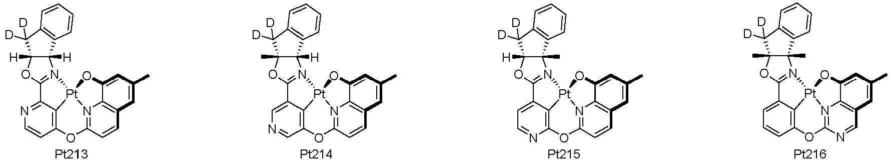

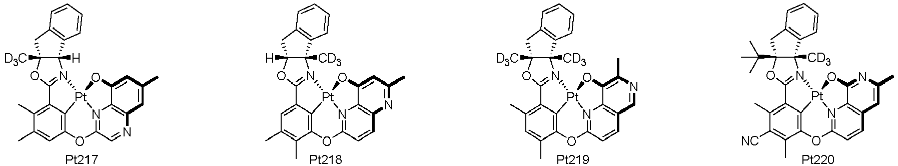

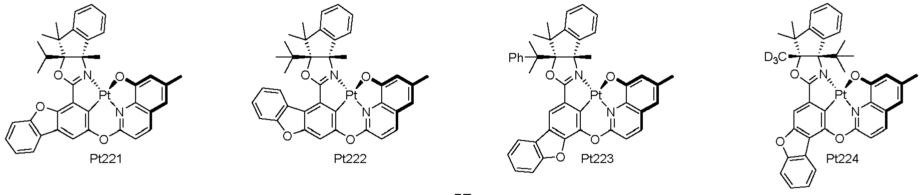

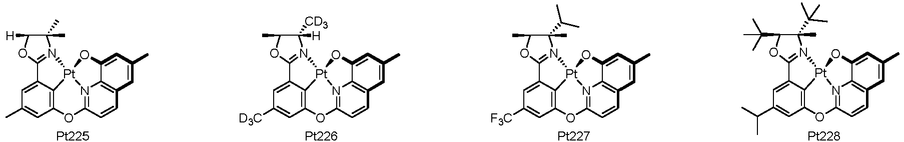

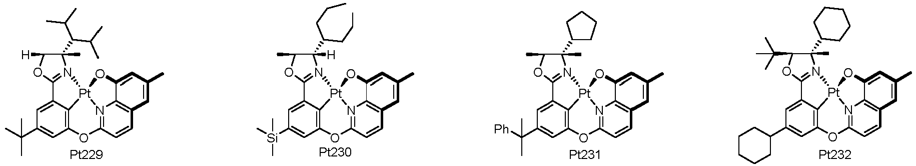

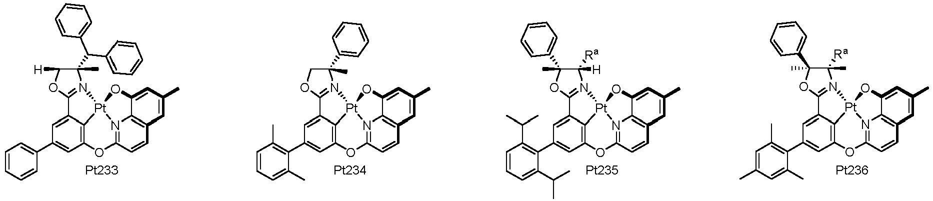

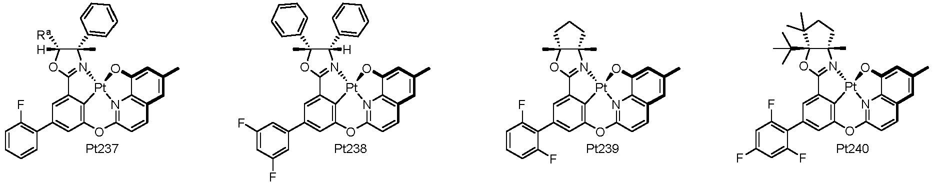

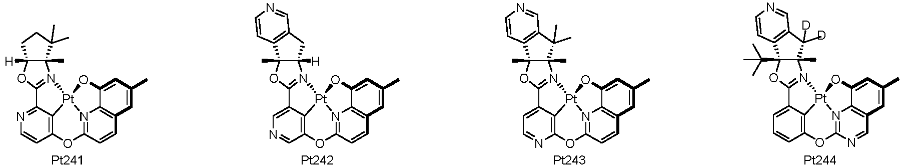

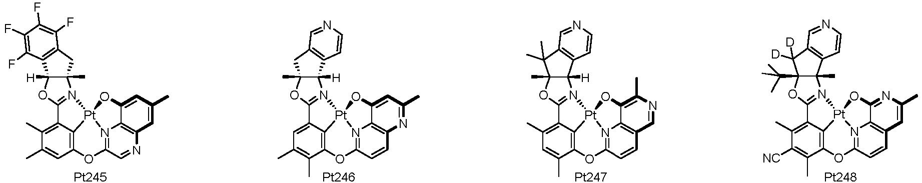

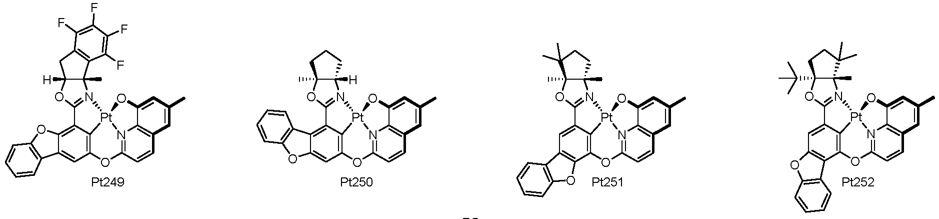

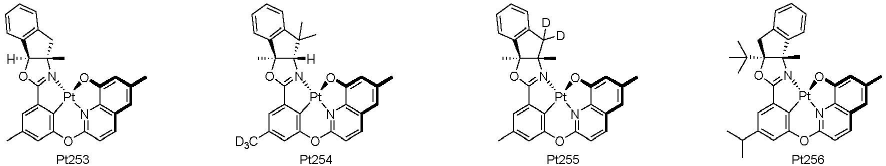

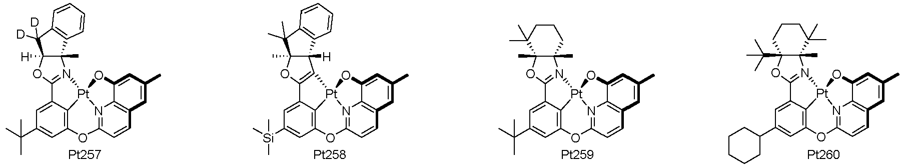

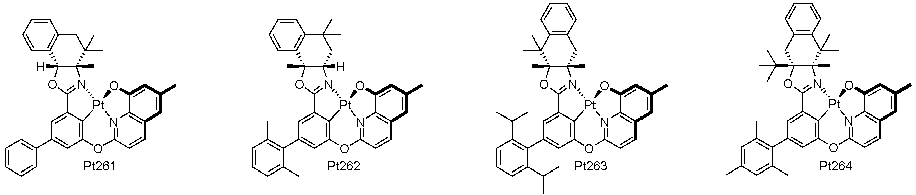

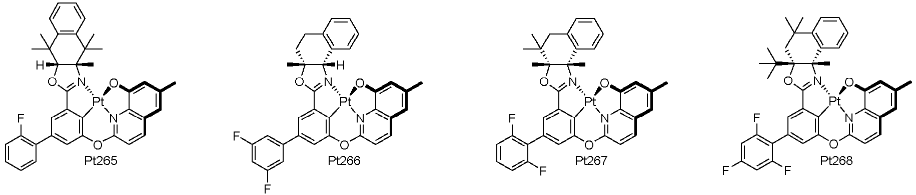

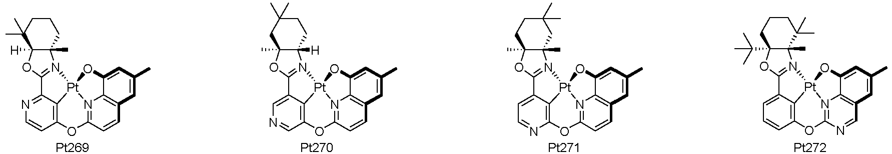

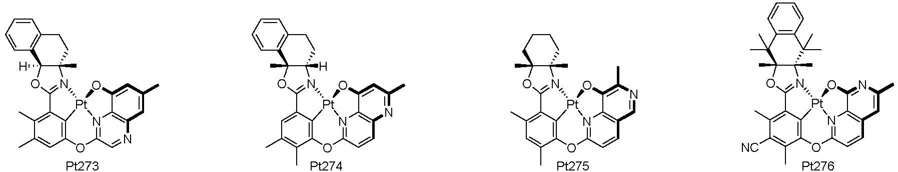

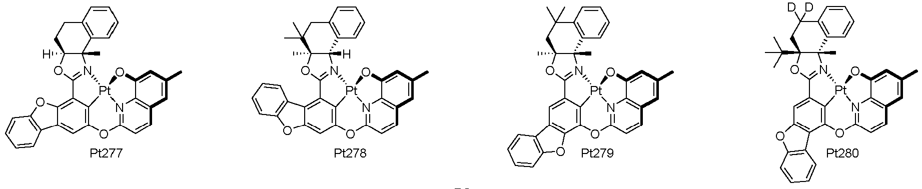

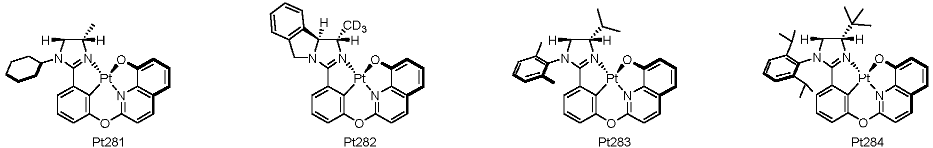

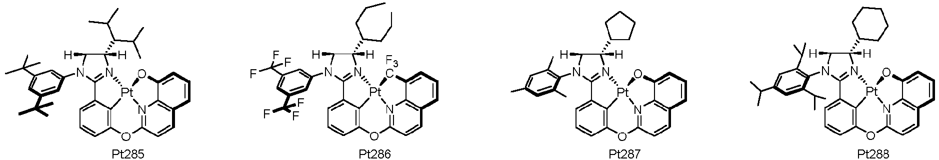

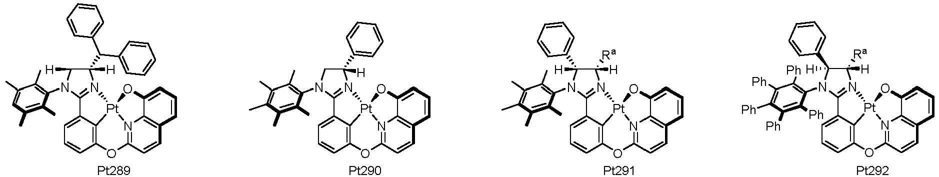

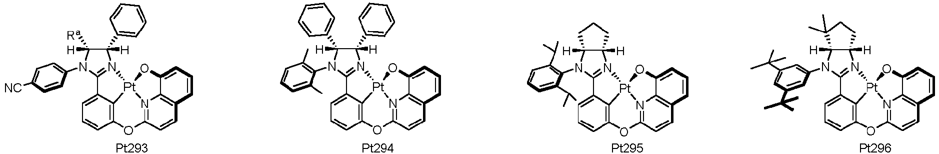

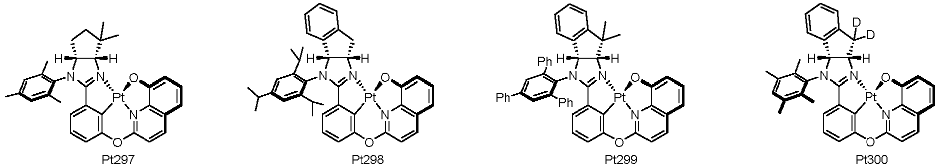

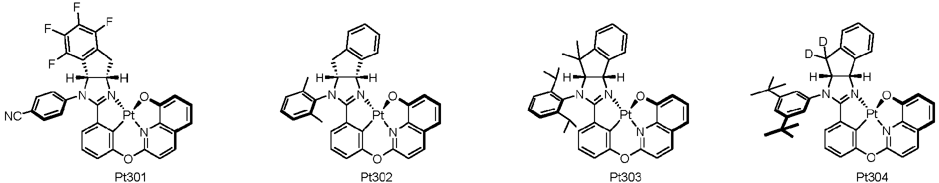

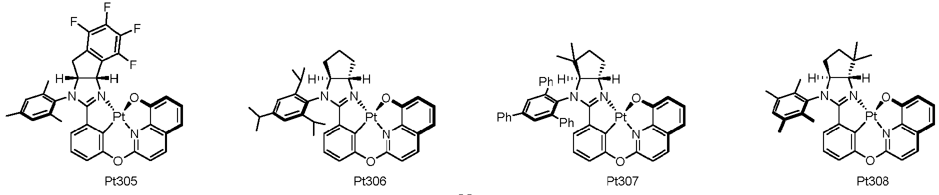

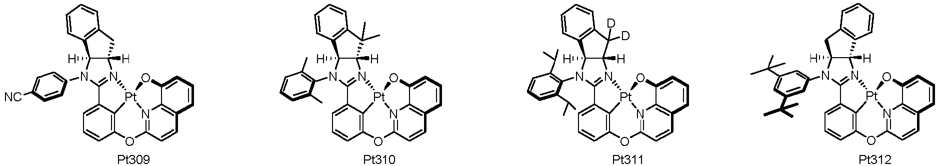

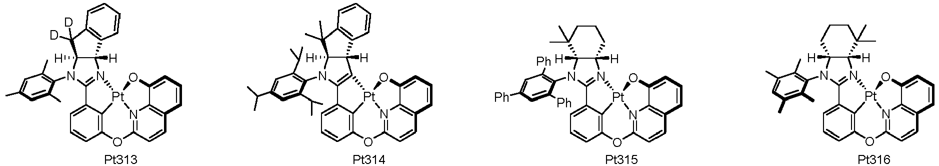

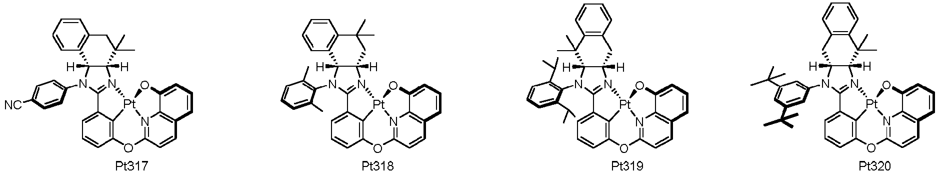

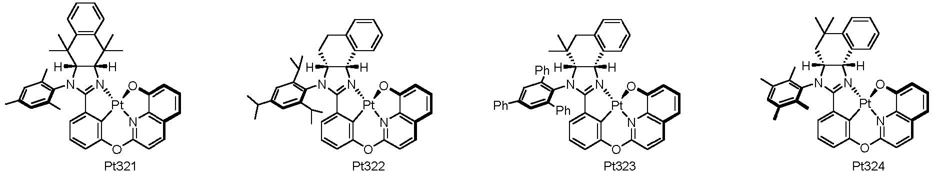

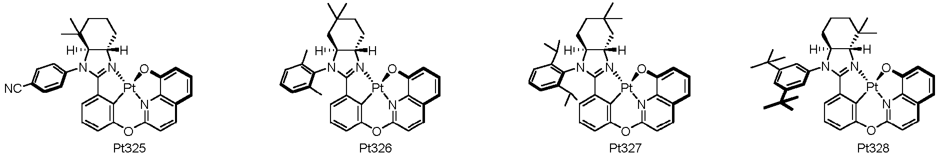

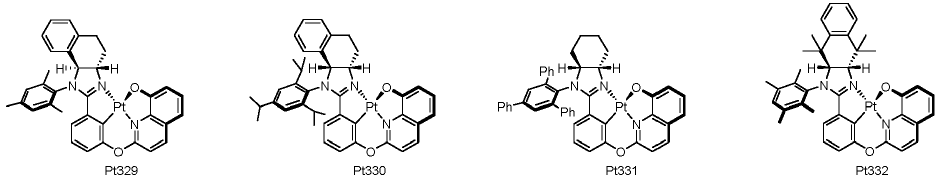

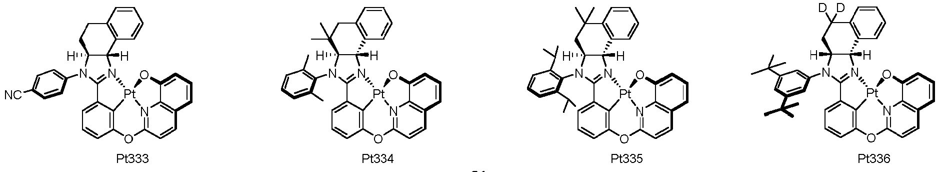

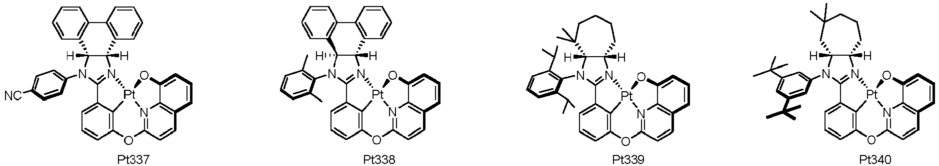

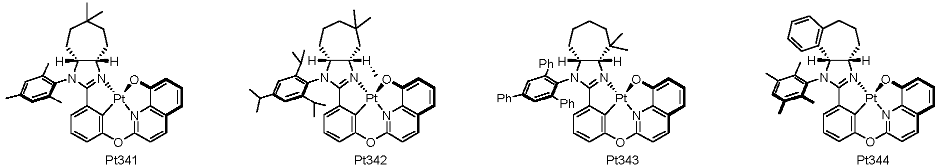

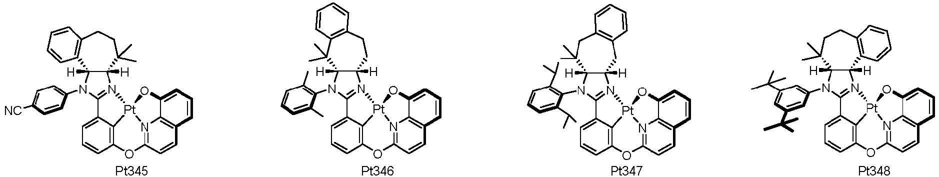

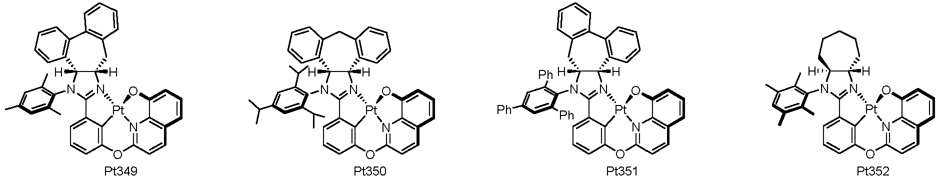

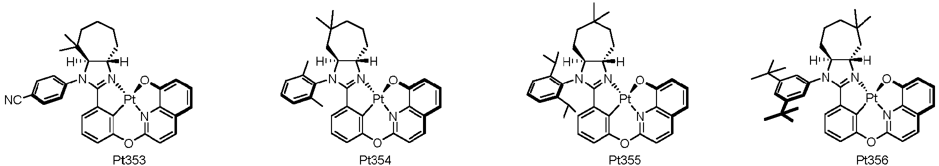

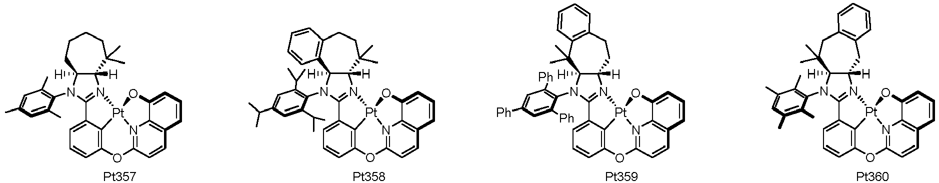

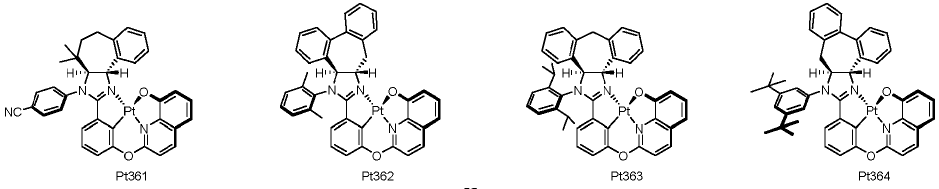

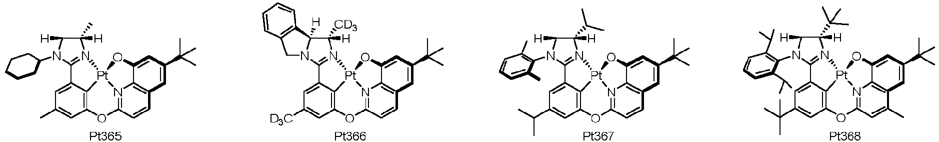

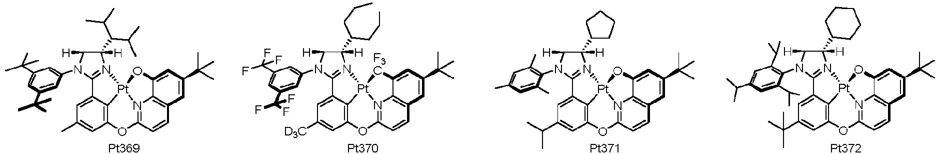

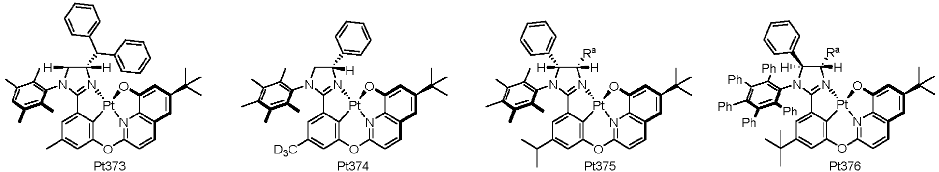

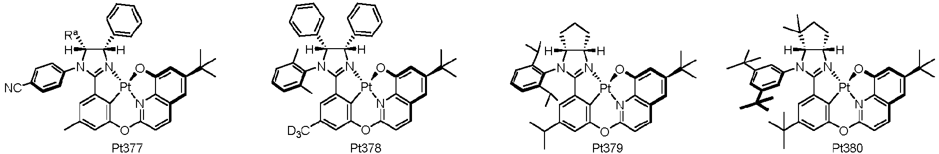

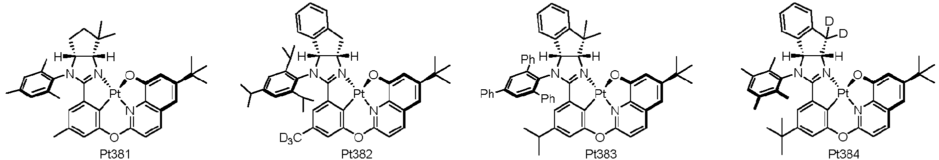

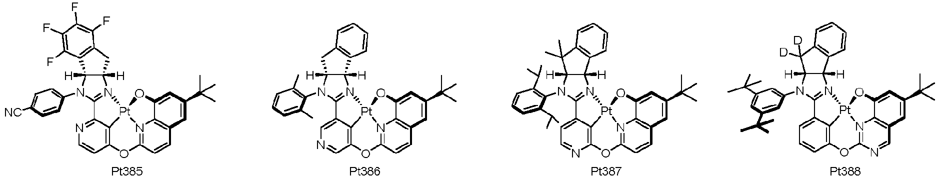

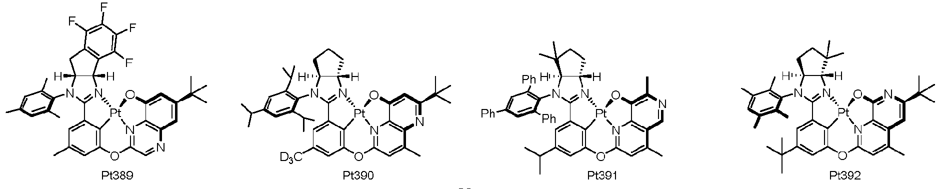

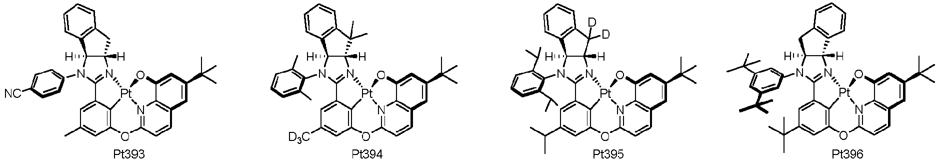

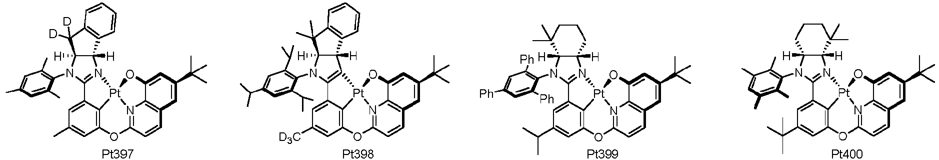

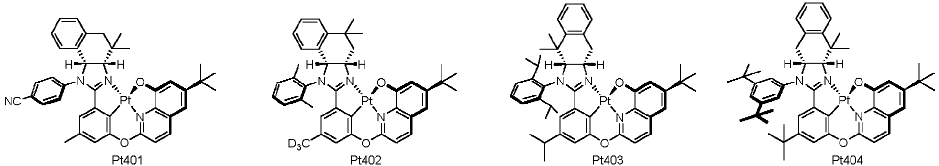

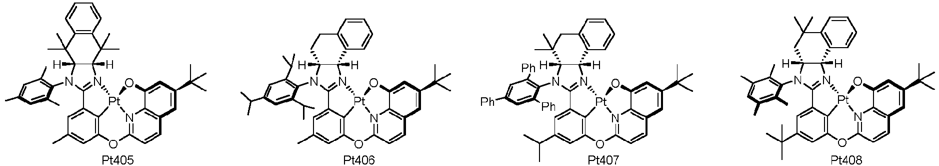

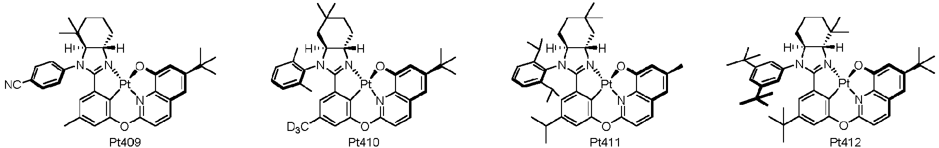

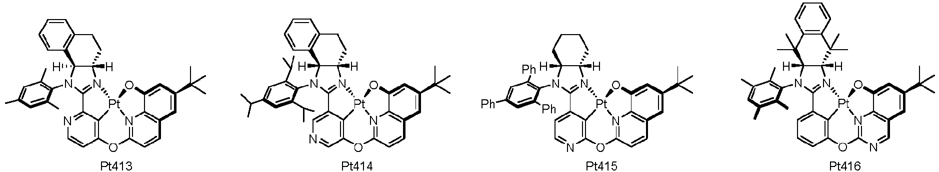

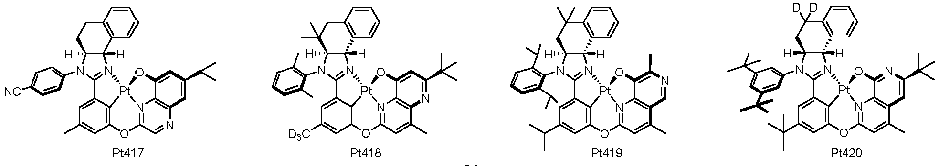

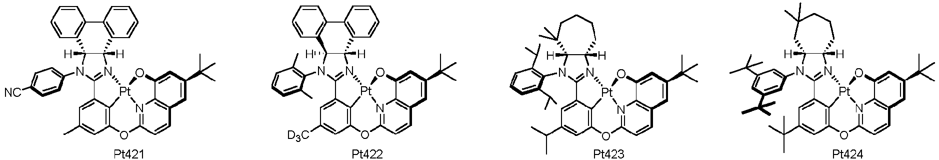

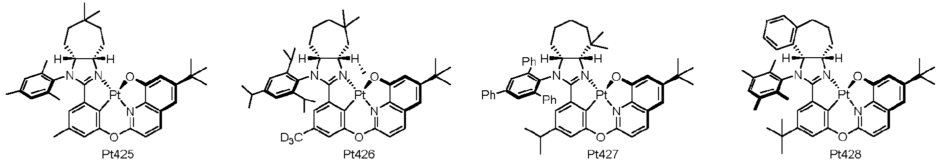

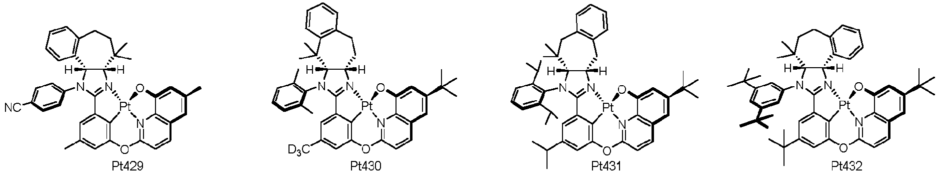

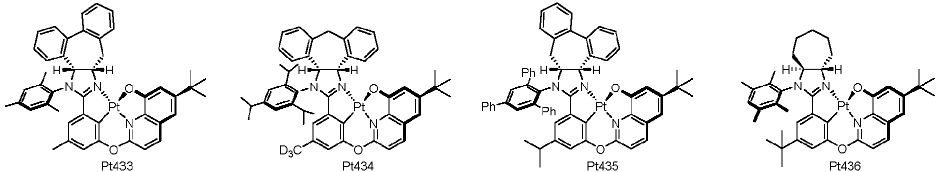

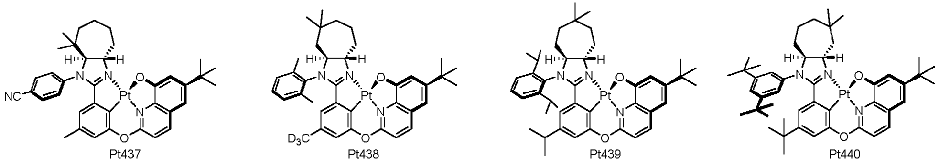

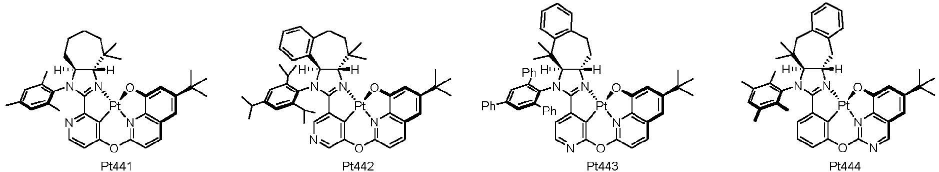

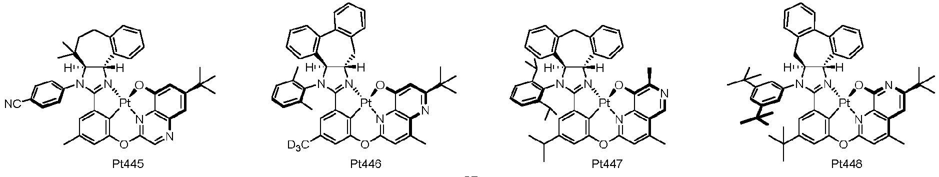

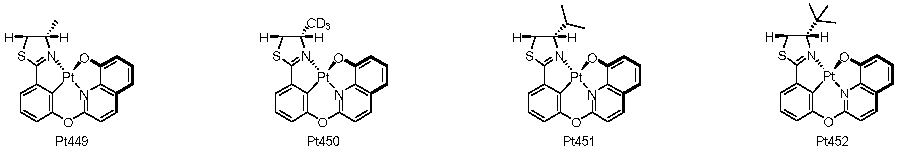

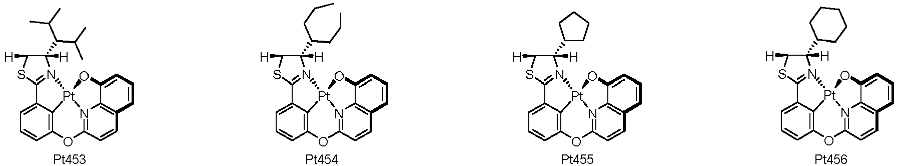

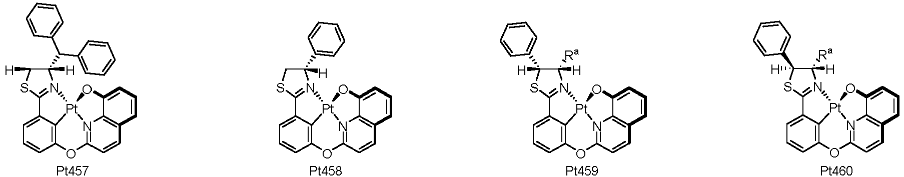

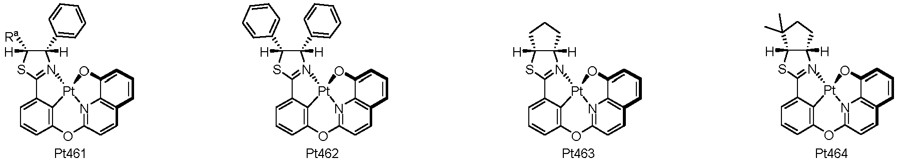

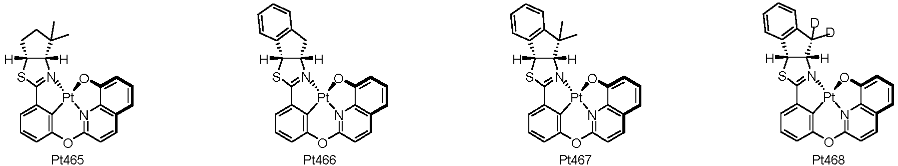

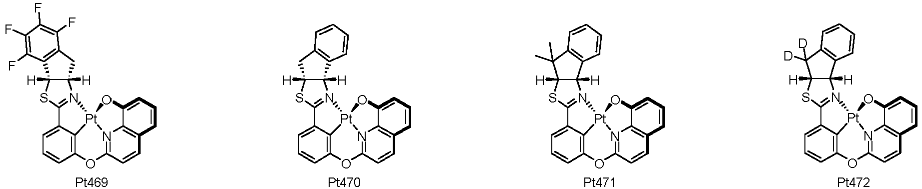

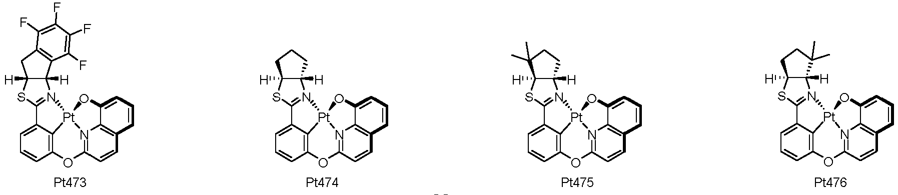

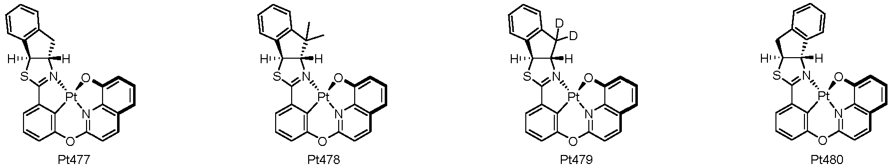

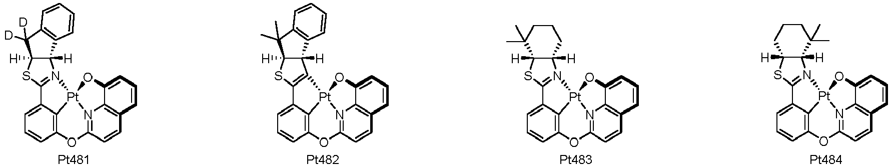

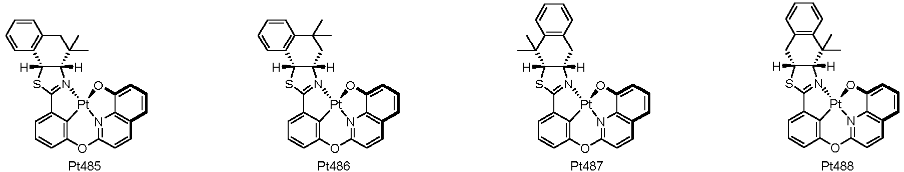

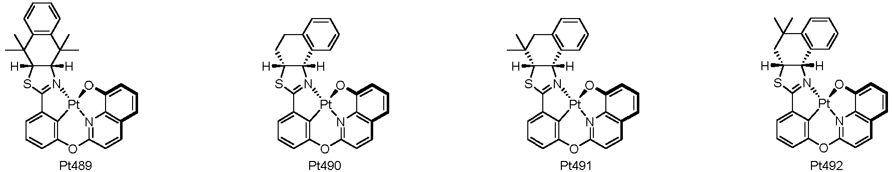

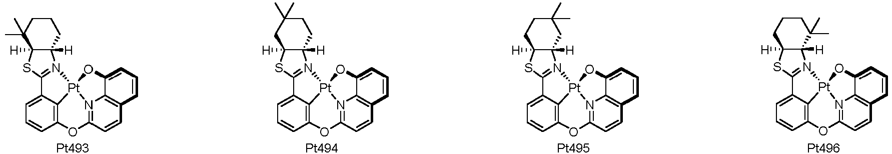

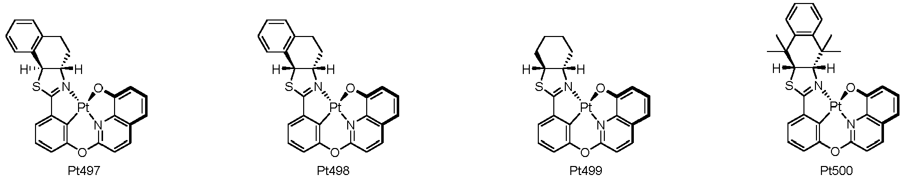

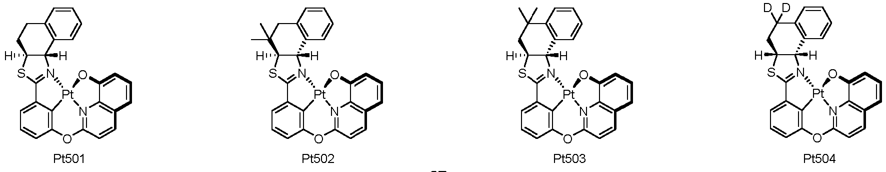

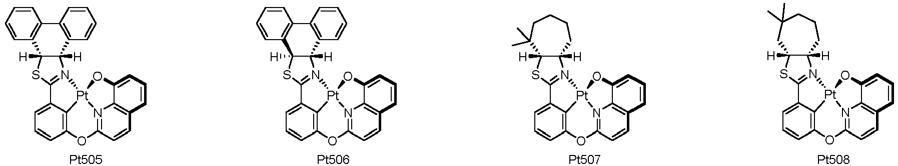

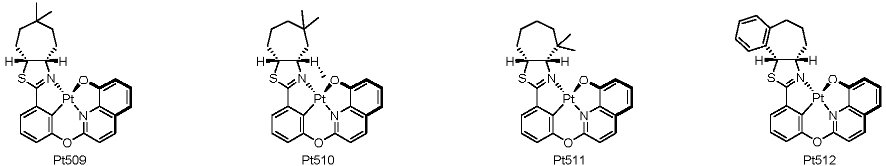

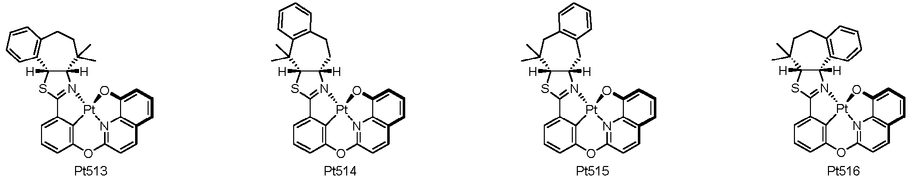

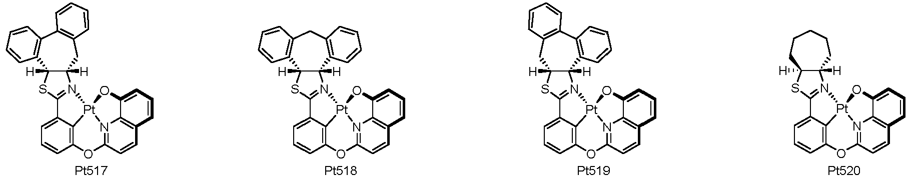

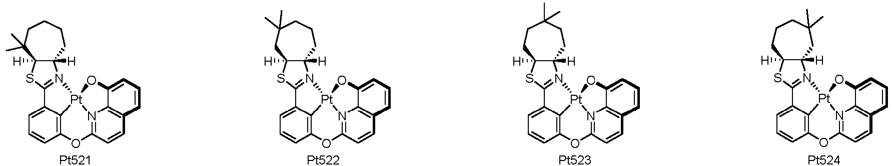

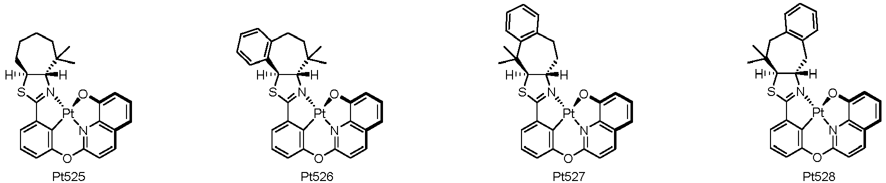

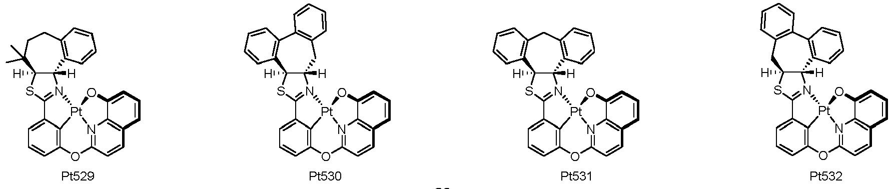

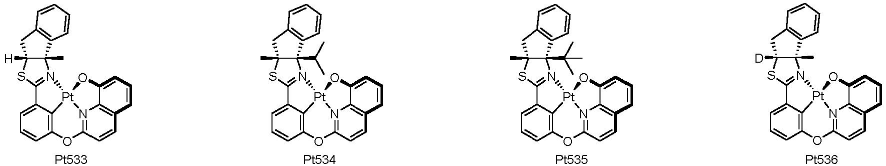

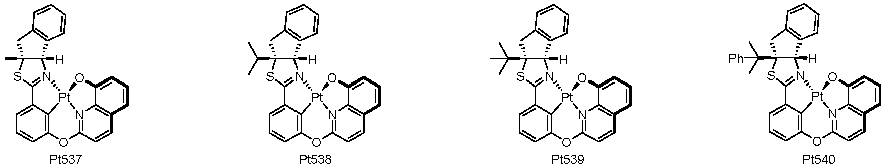

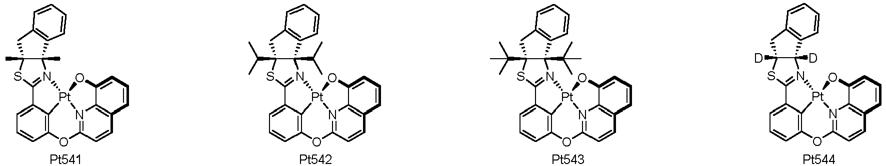

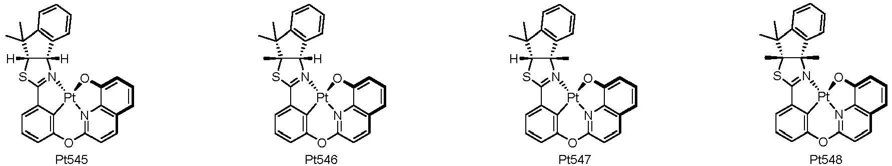

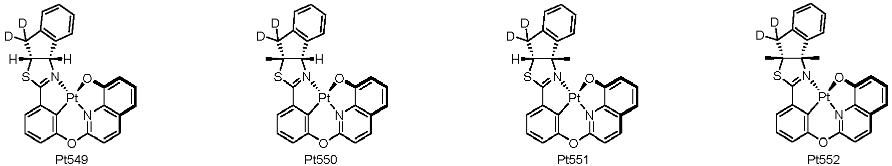

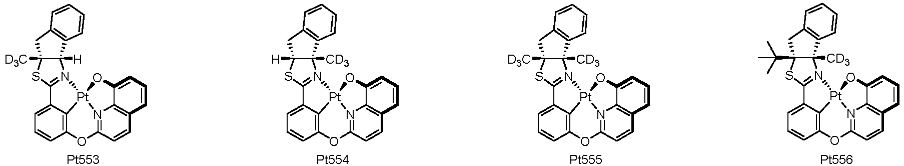

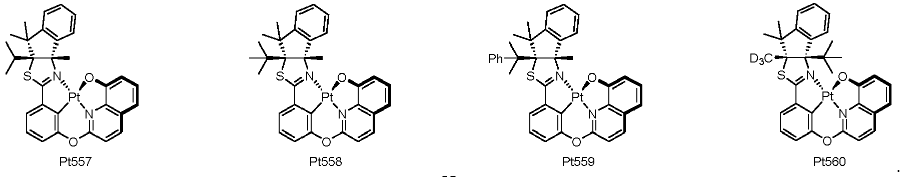

2. A central chirality induced helical chiral tetradentate cyclometalated platinum (II) complex according to claim 1, wherein the complex is selected from one of following structures:

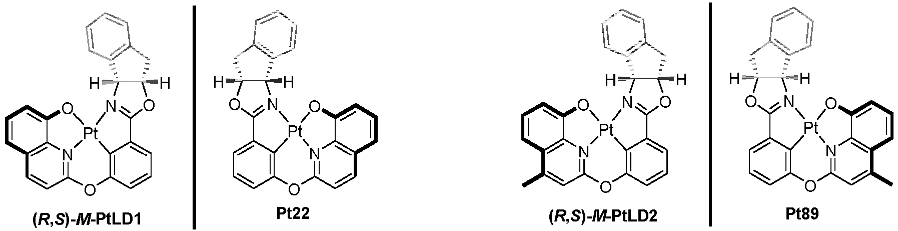

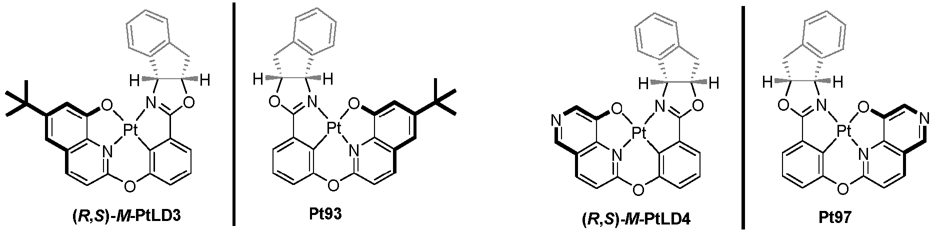

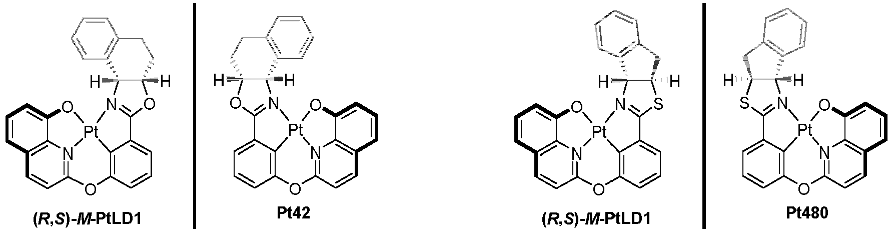

3. Application of the complex according to claim 1or claim 2 in an electronic device.

4. The application according to claim 3, wherein the electronic device comprises an organic electroluminescent device, an organic photoluminescence device, an organic integrated circuit, an organic field effect transistor, an organic thin film transistor, an organic light emitting transistor, an organic solar cell, an organic optical detector, an organic field quenching device, a light-emitting electrochemical cell or an organic laser diode.

5. An electronic device, comprising the central chirality induced helical chiral tetradentate cyclometalated platinum (II) complex according to claim 1 or claim 2.

6. The electronic device according to claim 5, wherein the electronic device is preferably selected from an organic electroluminescent device, an organic photoluminescence device, an organic integrated circuit, an organic field effect transistor, an organic thin film transistor, an organic light emitting transistor, an organic solar cell, an organic optical detector, an organic field quenching device, a light-emitting electrochemical cell or an organic laser diode.

7. The electronic device according to claim 5, wherein the electronic device comprises at least one cathode, at least one anode, and an organic layer between the at least one anode and at least one cathode, the organic layer comprising a light-emitting layer, which is composed only of a light-emitting layer or has more than one other organic layer besides the light-emitting layer; at least one layer in the organic layer containing the central chirality induced helical chiral tetradentate cyclometalated platinum (II) complex according to claim 1 or claim 2.

8. The electronic device according to claim 5, wherein the electronic device is an organic electroluminescent device, with a light-emitting layer containing the central chirality induced helical chiral tetradentate cyclometalated platinum (II) complex according to claim 1 or claim 2 and a corresponding host material, with a mass percentage of the complex of 1% to 50%.

9. A composition, comprising the central chirality induced helical chiral tetradentate cyclometalated platinum (II) complex according to claim 1 or claim 2.

10. A preparation, comprising the central chirality induced helical chiral tetradentate cyclometalated platinum (II) complex according to claim 1 or claim 2 or at least one composition according to claim 9, and at least one solvent.

11. A display or lighting device, comprising one or more of the electronic device according to claim 4.

## Patentansprüche

1. Durch eine zentrale Chiralität induzierter helikaler chiraler vierzähniger cyclometallierter Platin(II)-Komplex, wobei der Komplex aus einer der folgenden Strukturen oder ihren Enantiomeren ausgewählt ist:

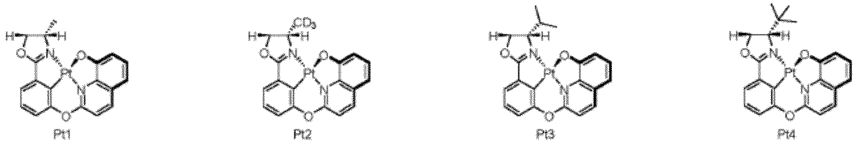

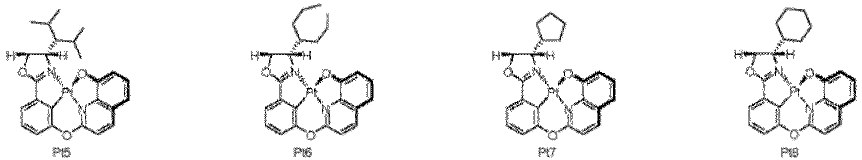

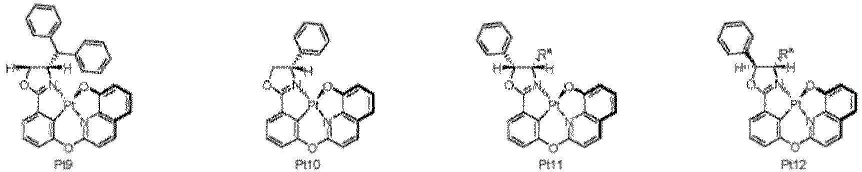

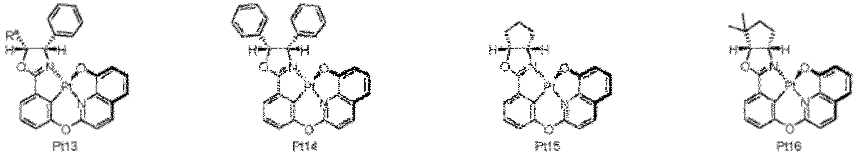

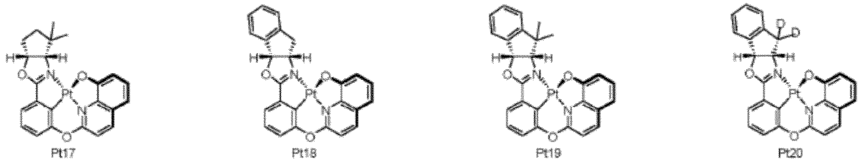

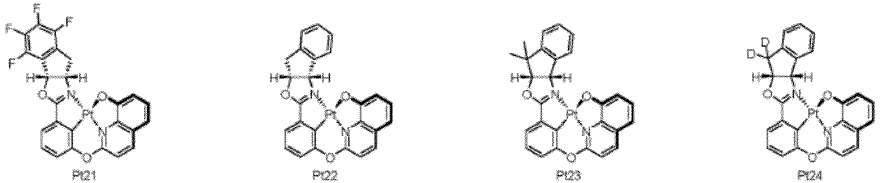

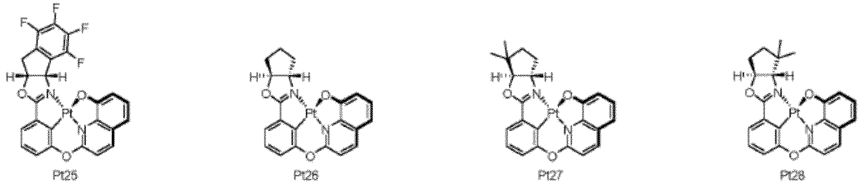

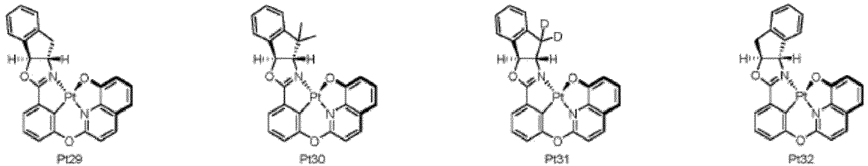

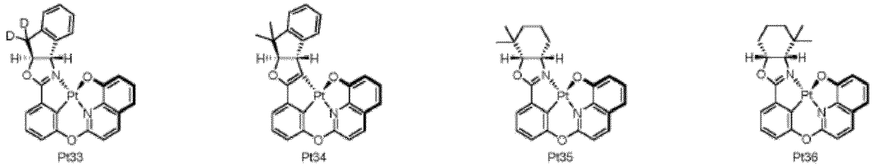

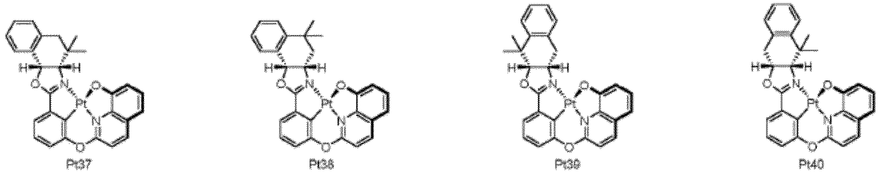

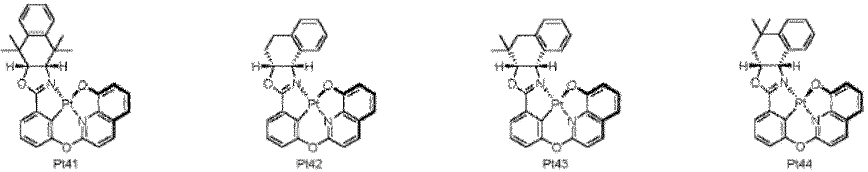

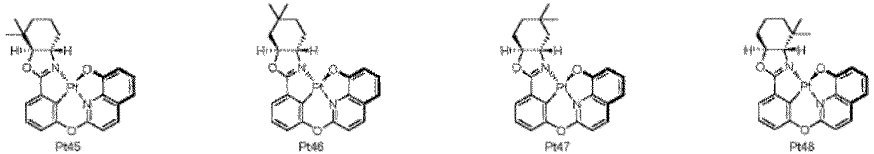

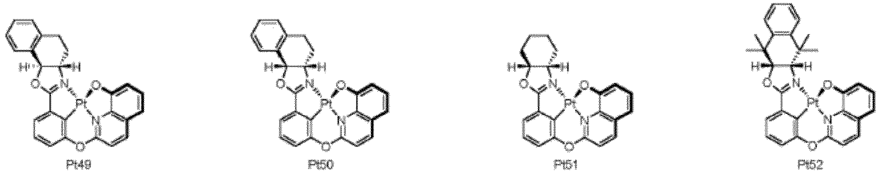

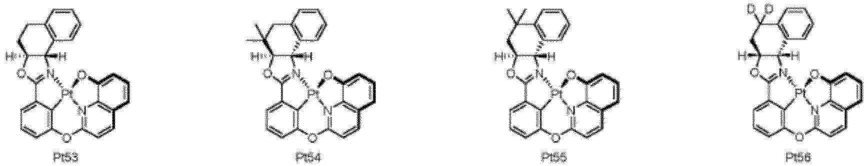

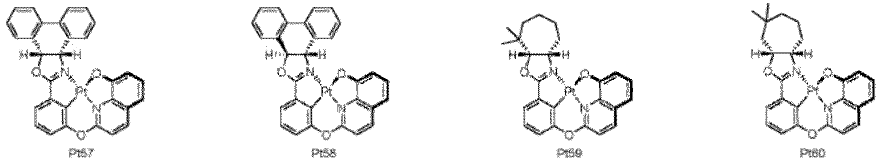

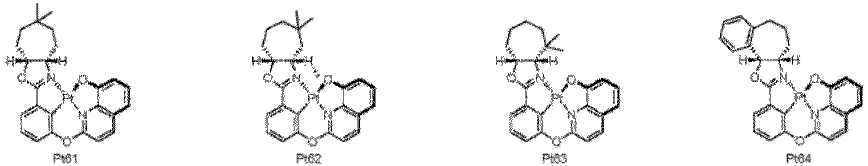

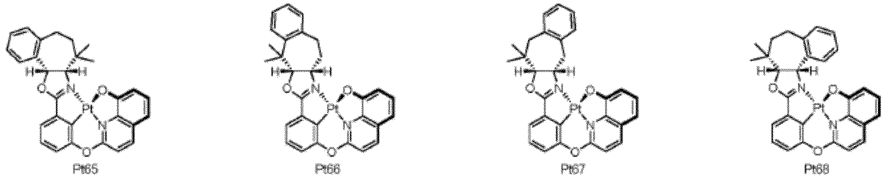

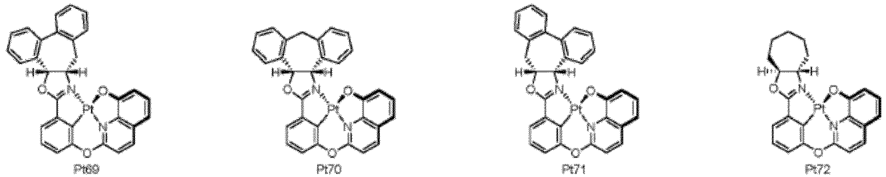

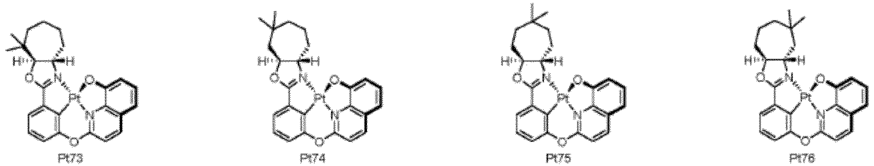

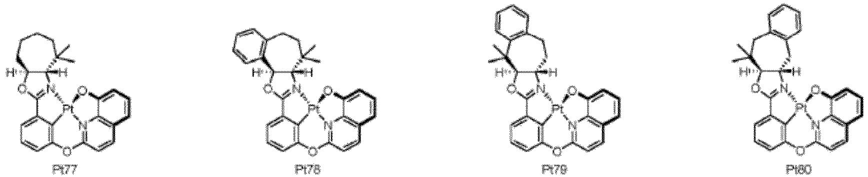

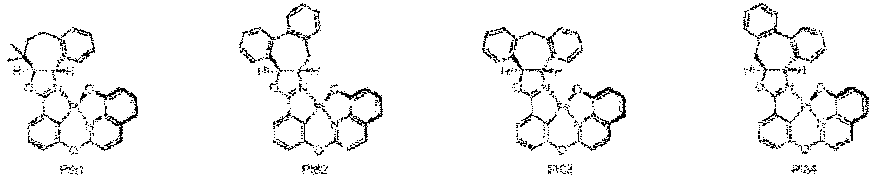

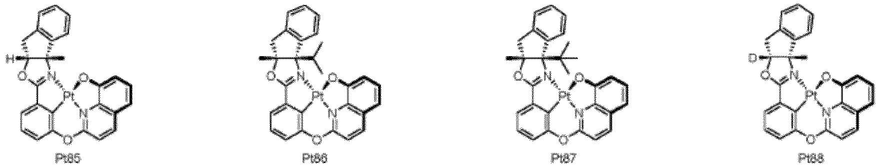

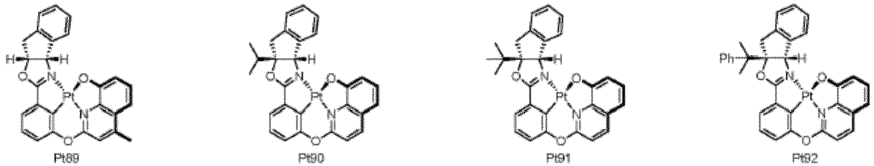

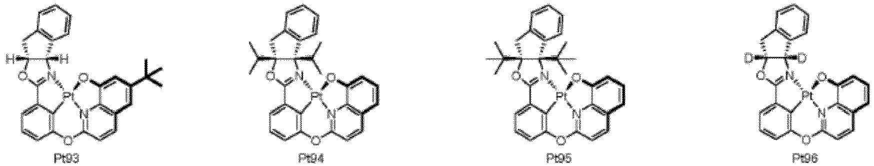

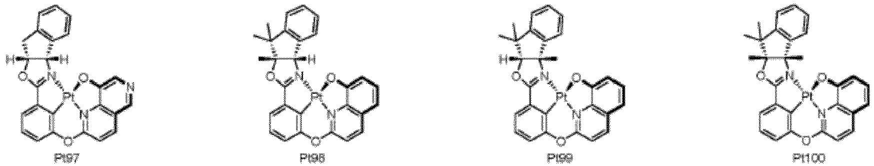

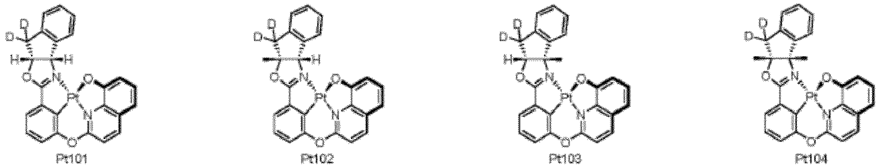

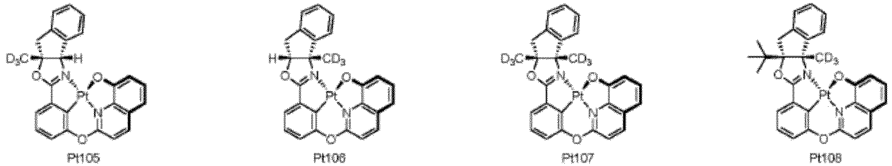

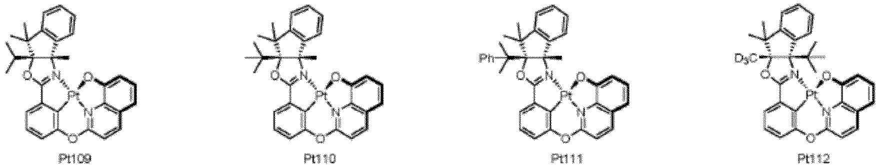

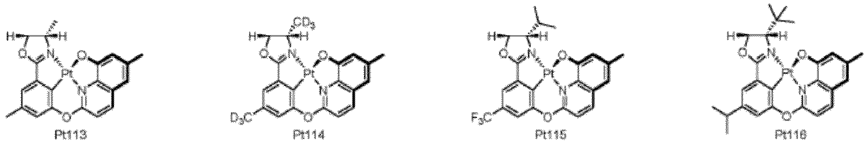

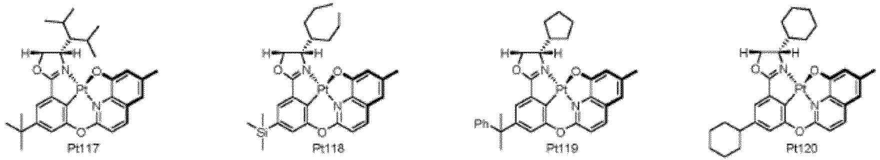

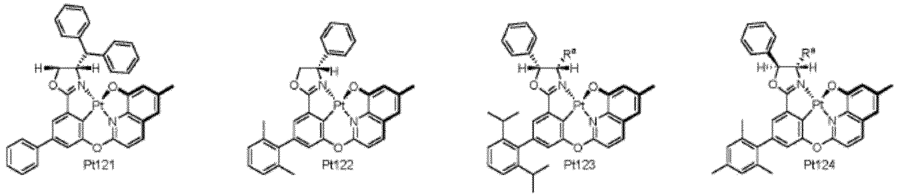

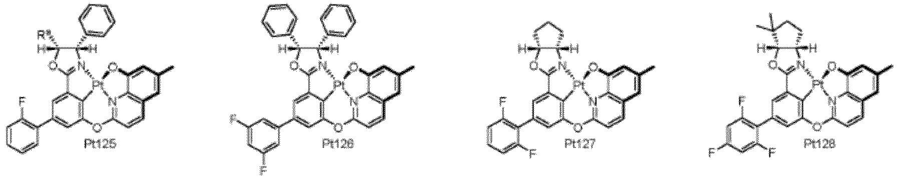

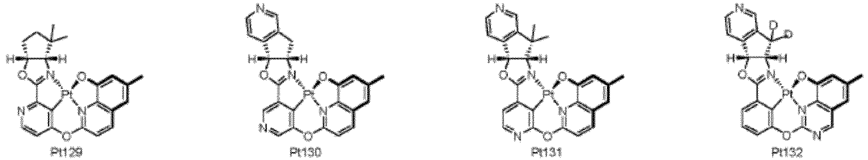

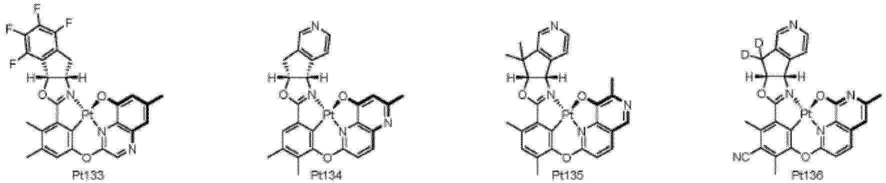

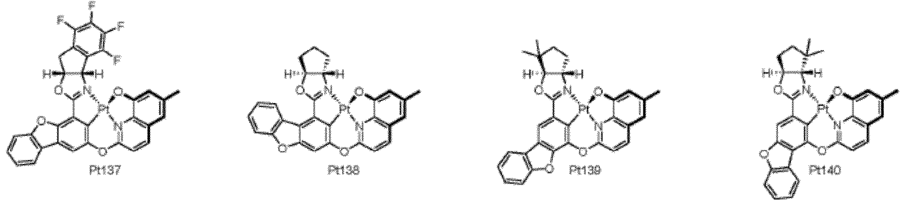

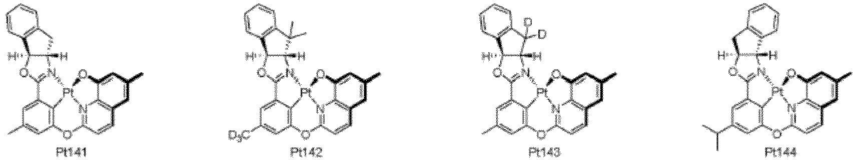

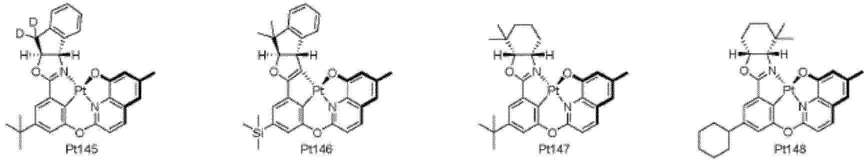

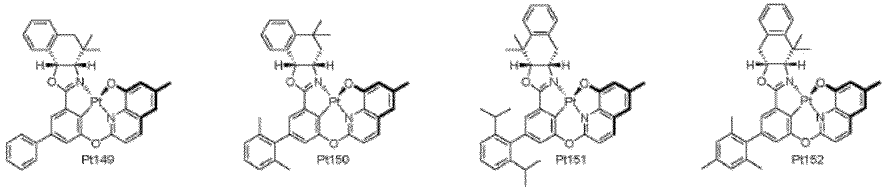

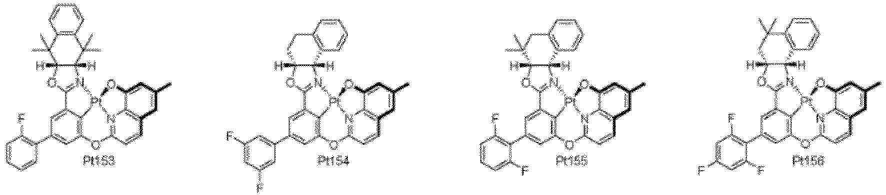

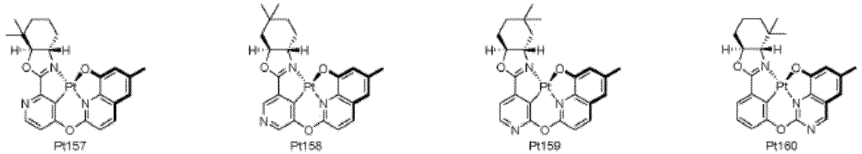

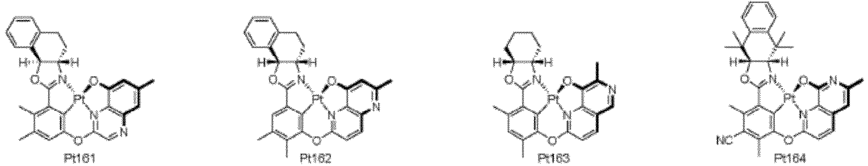

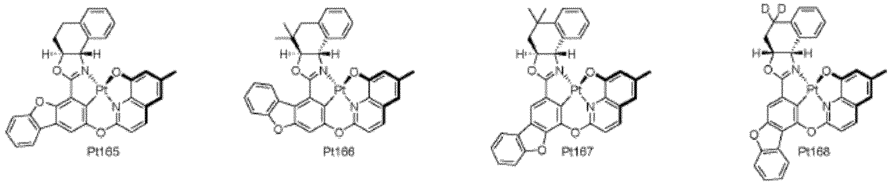

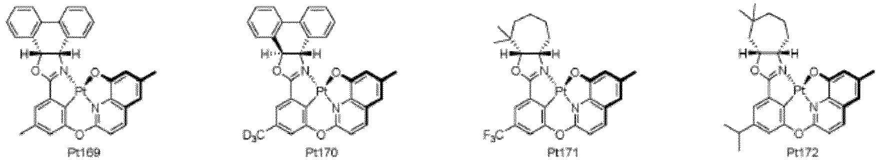

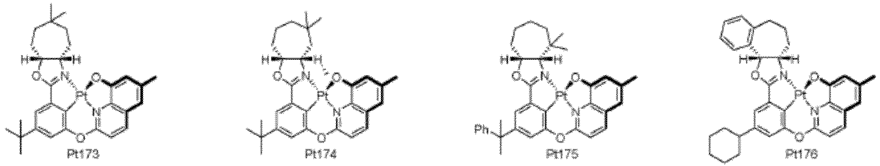

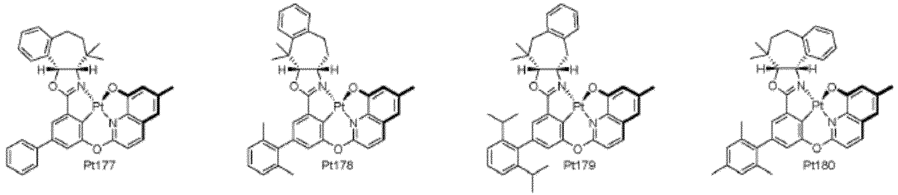

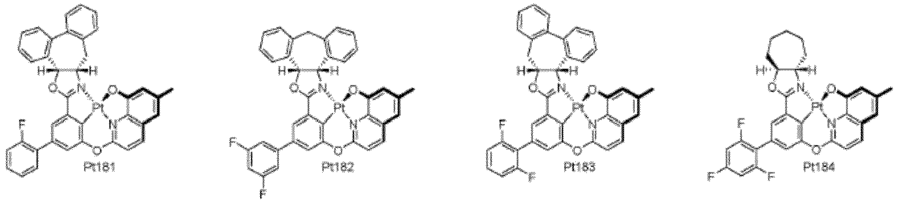

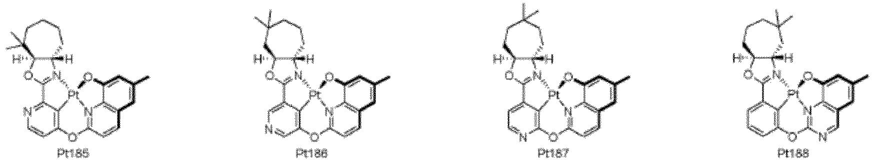

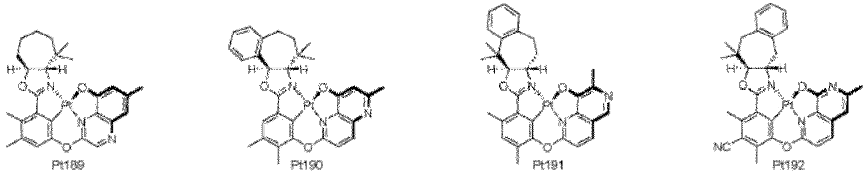

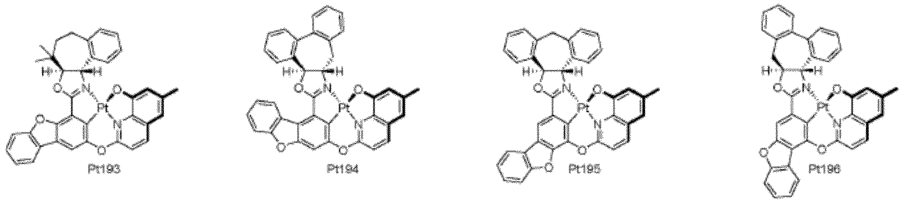

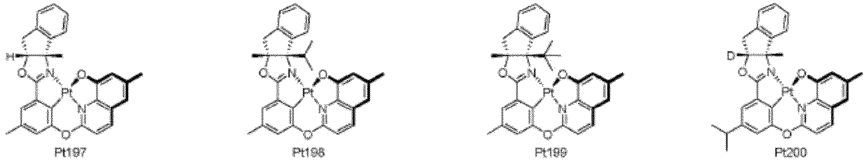

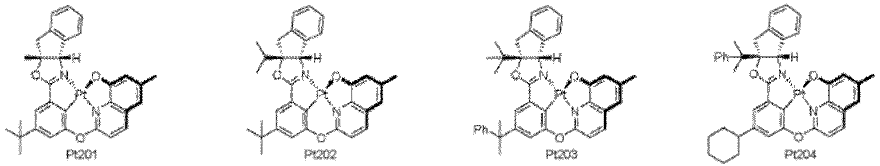

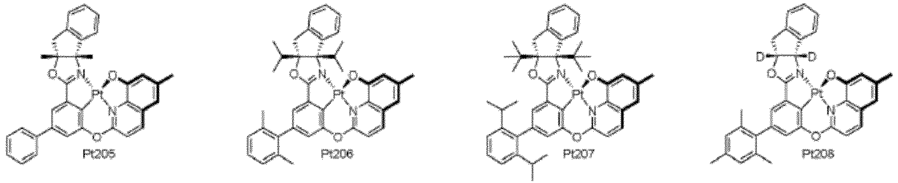

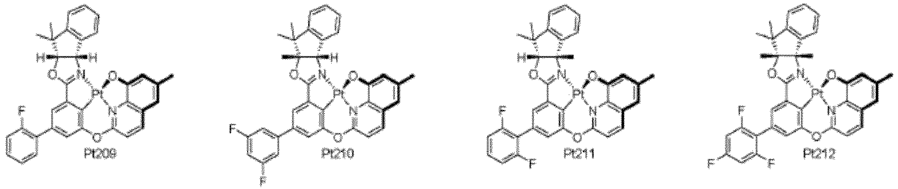

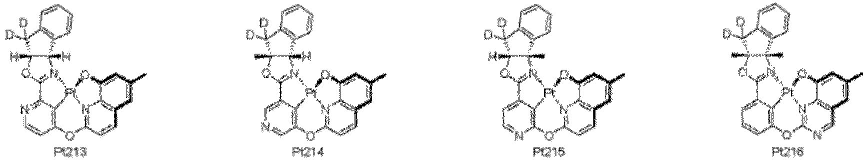

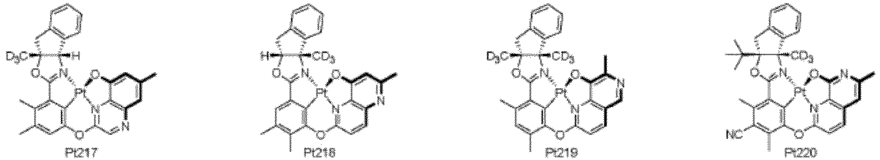

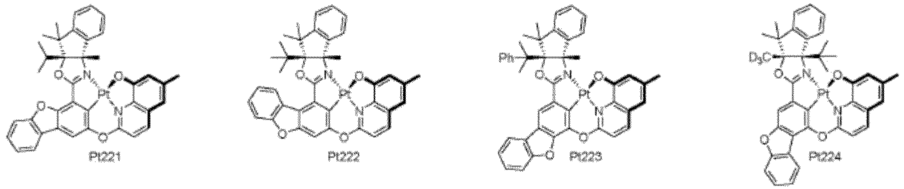

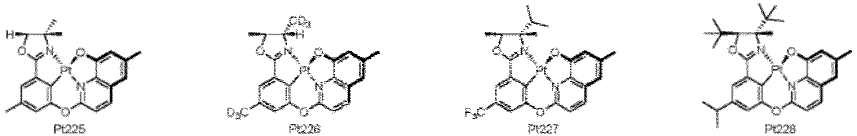

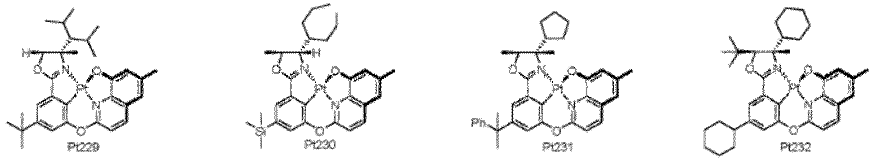

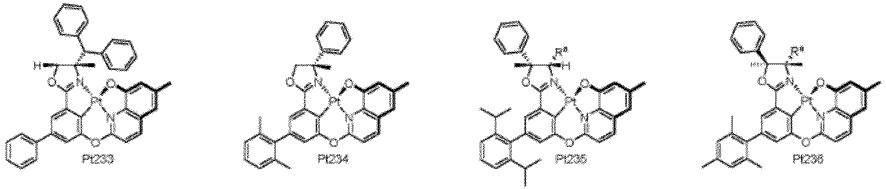

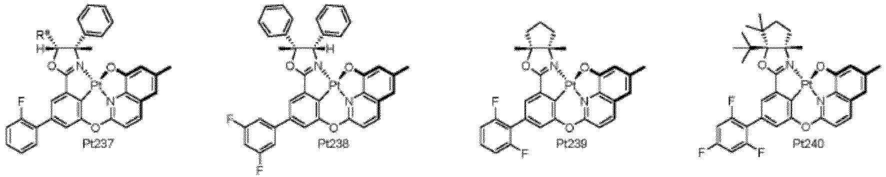

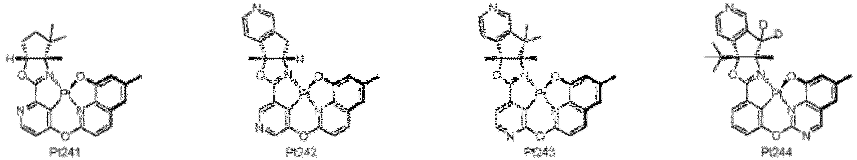

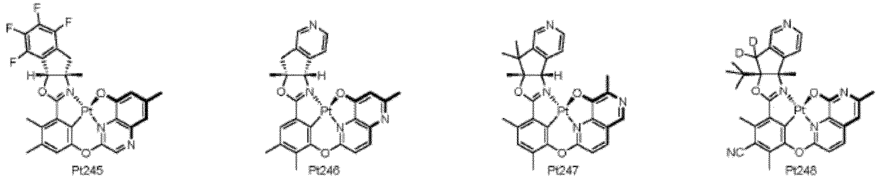

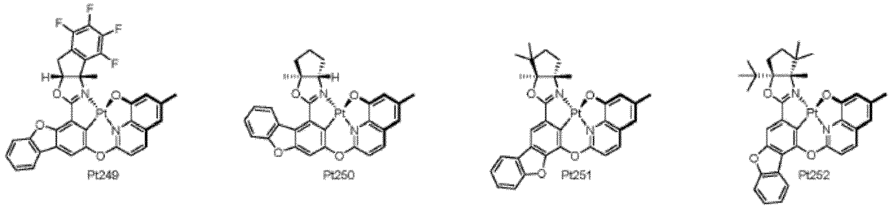

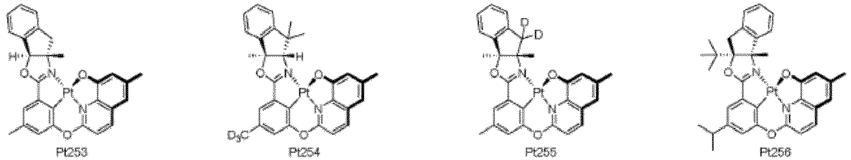

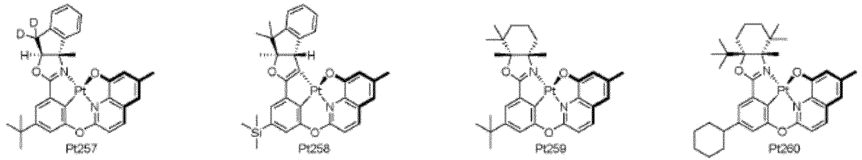

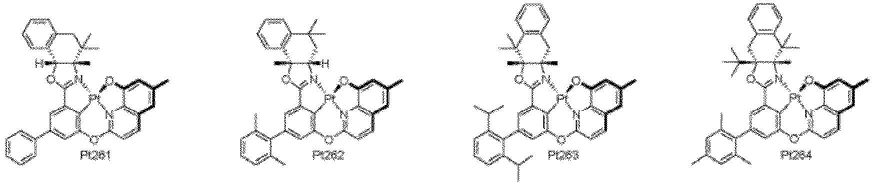

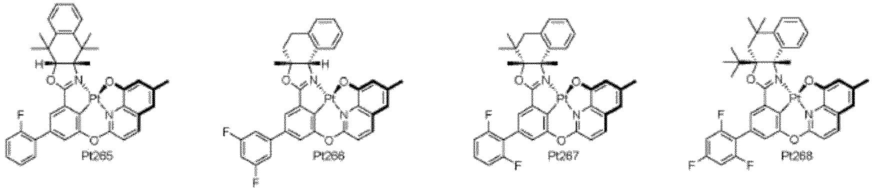

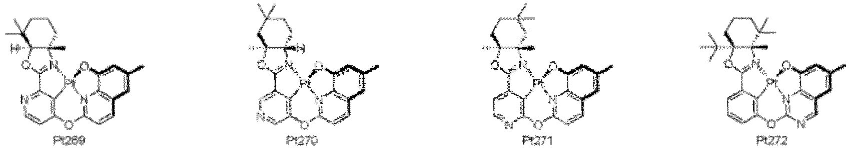

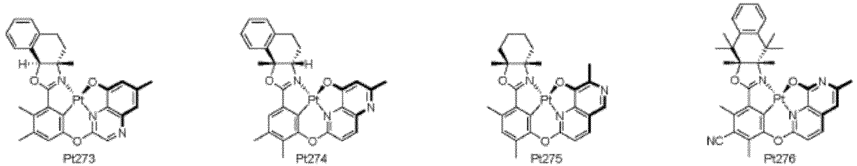

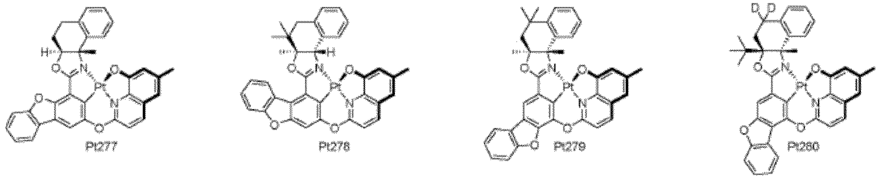

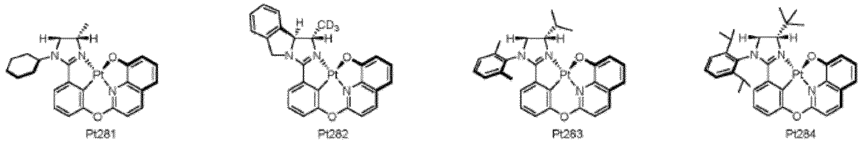

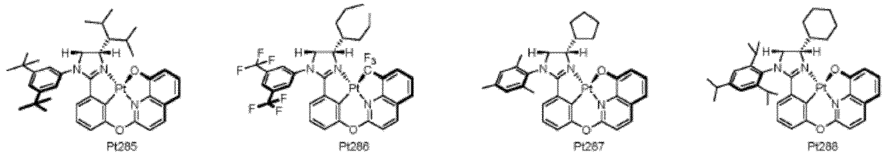

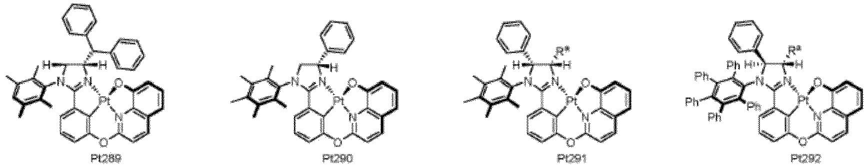

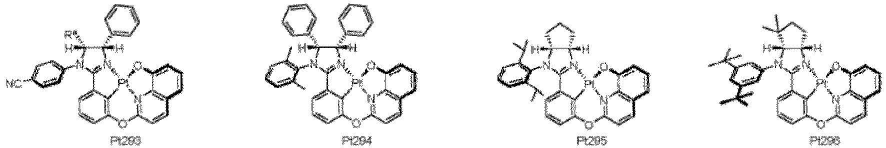

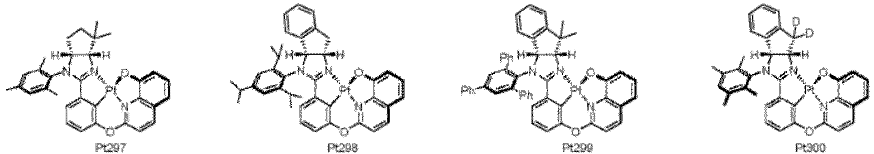

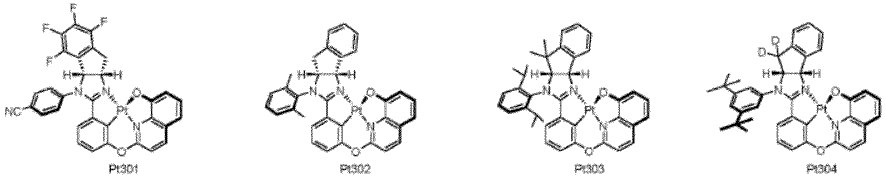

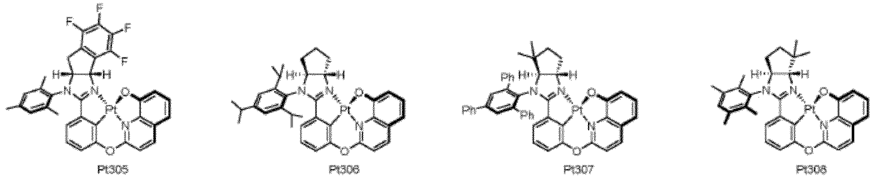

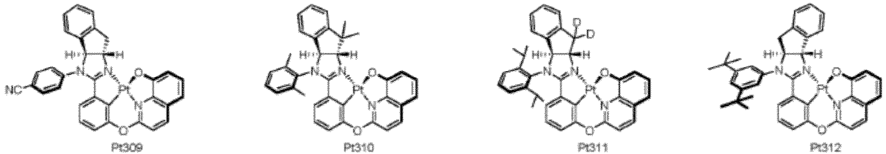

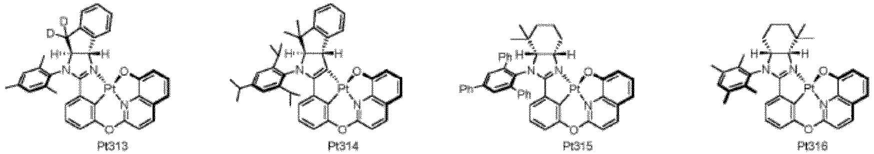

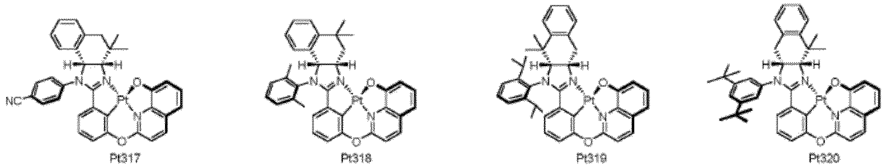

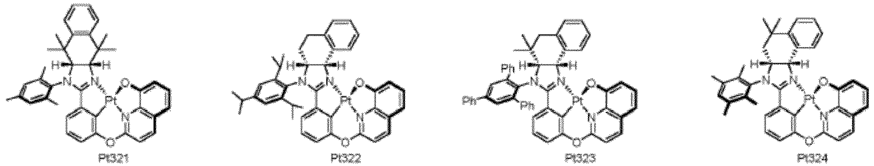

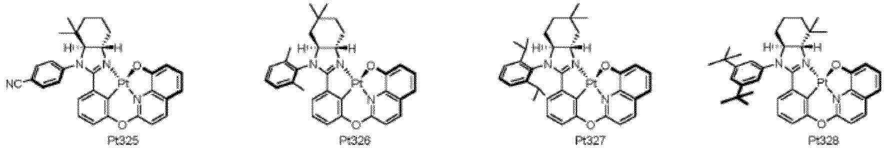

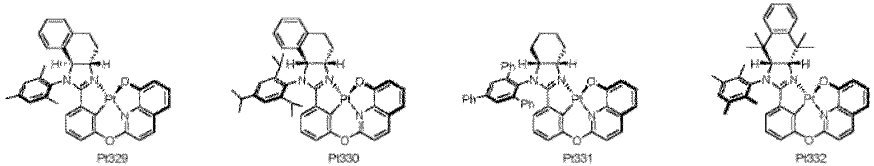

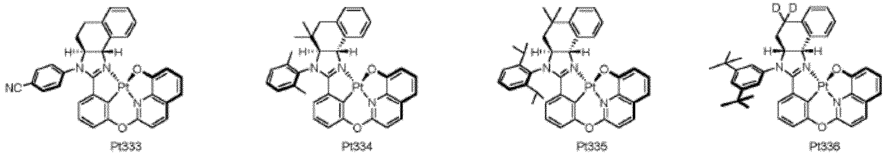

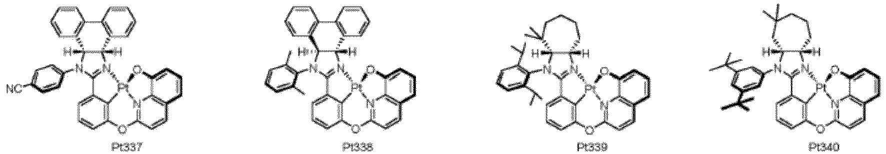

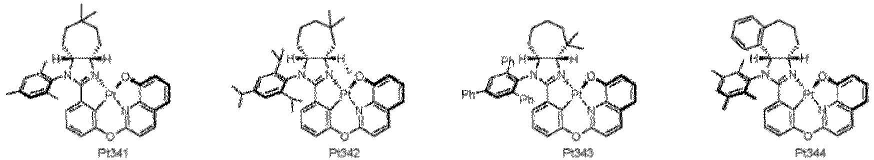

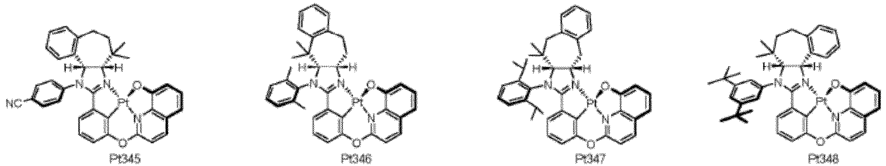

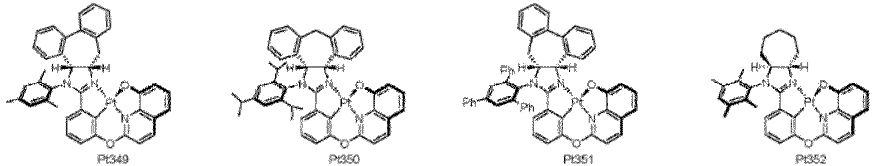

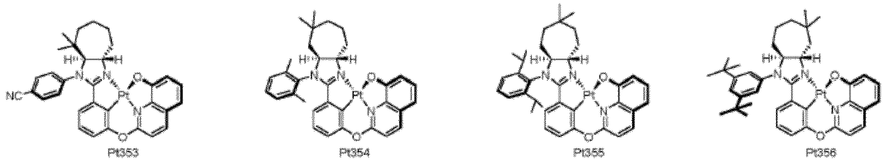

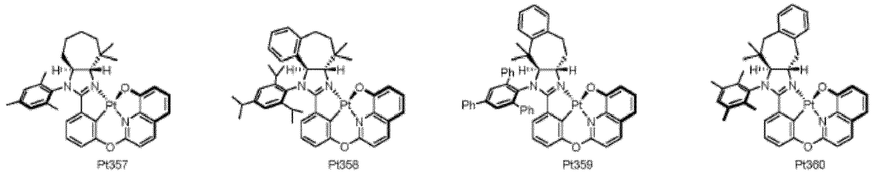

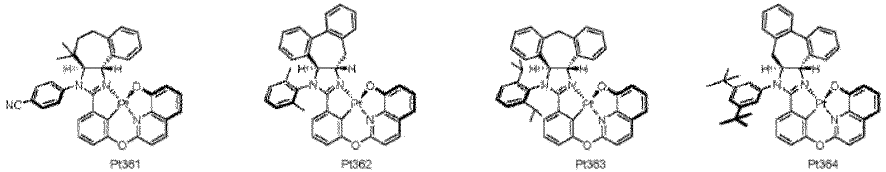

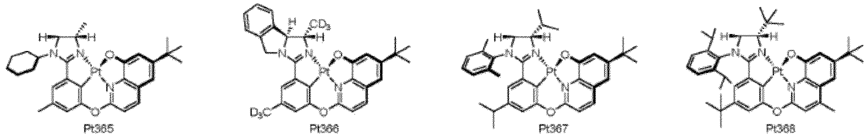

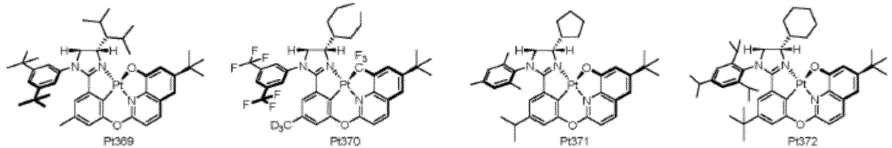

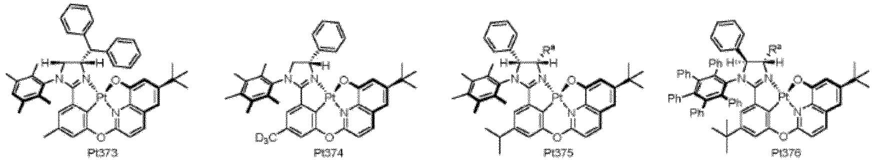

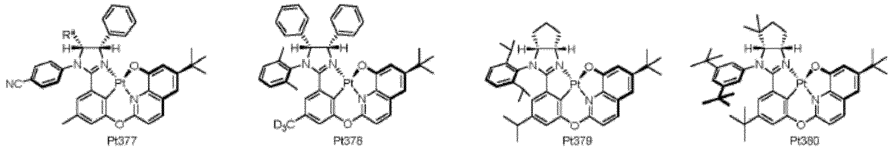

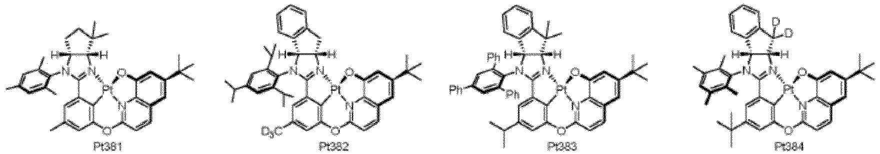

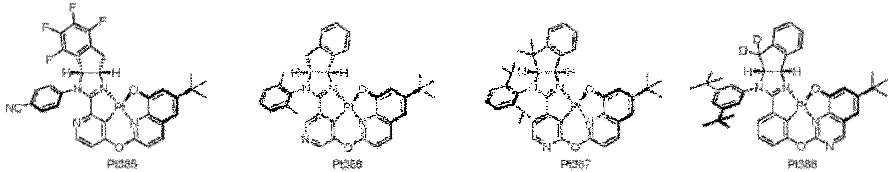

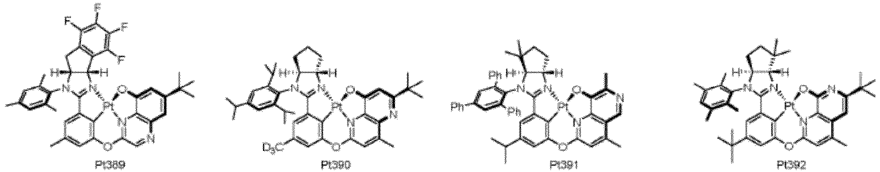

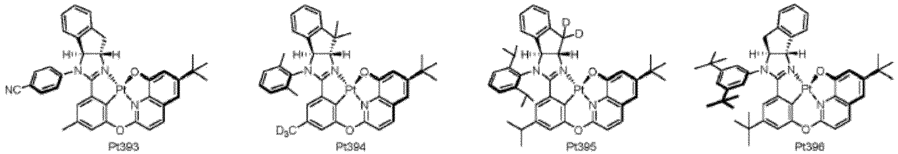

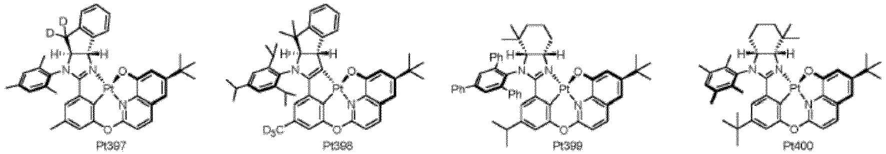

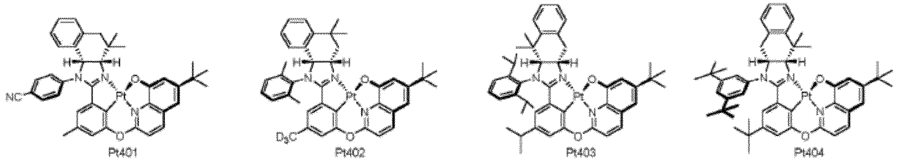

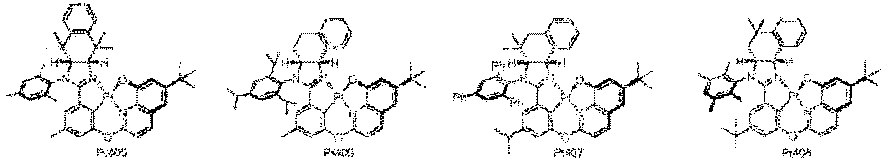

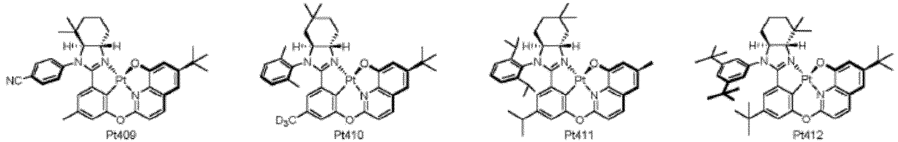

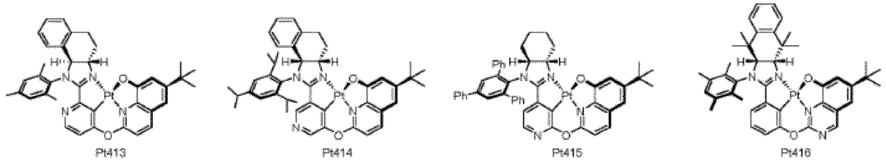

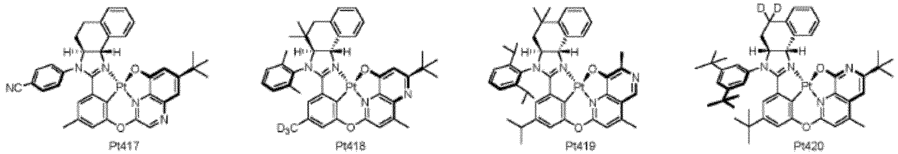

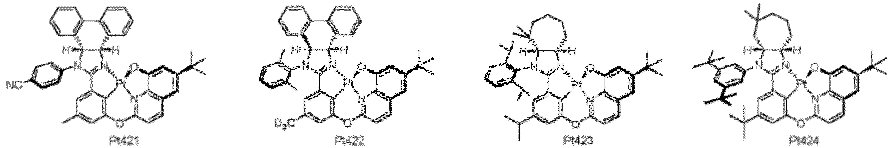

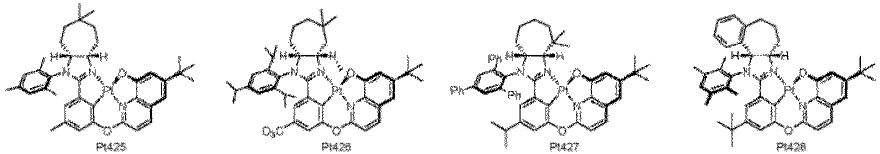

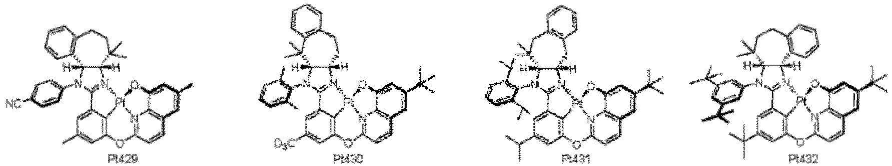

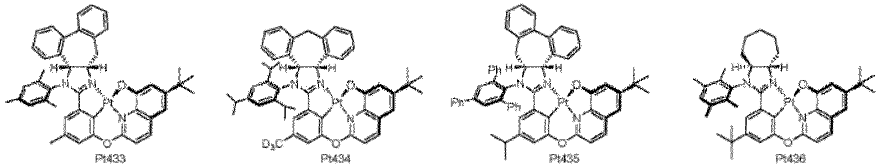

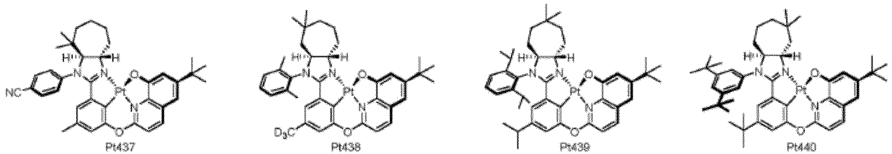

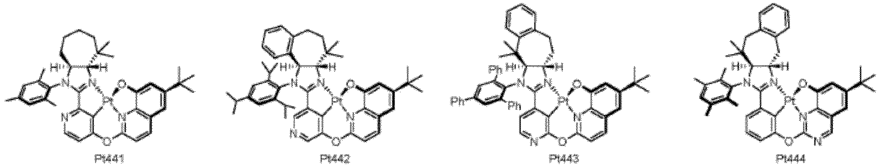

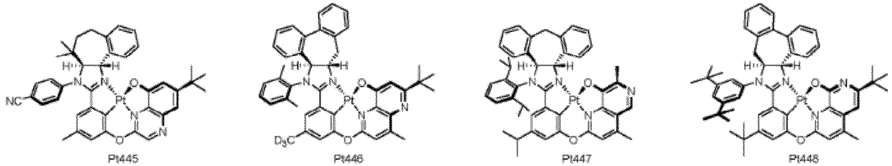

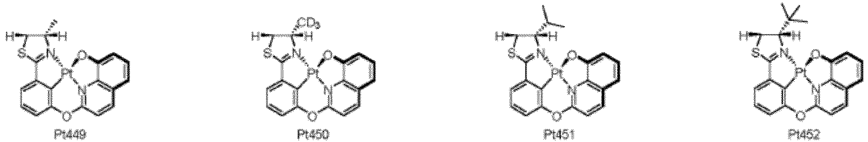

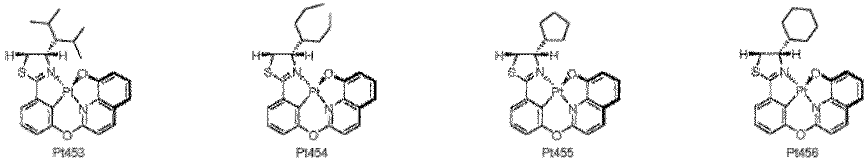

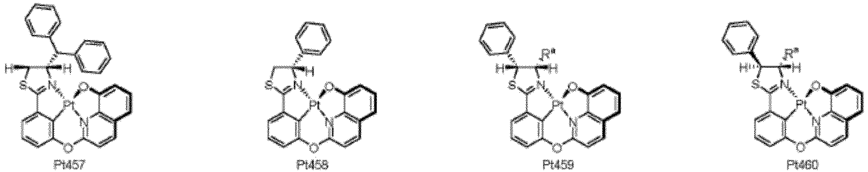

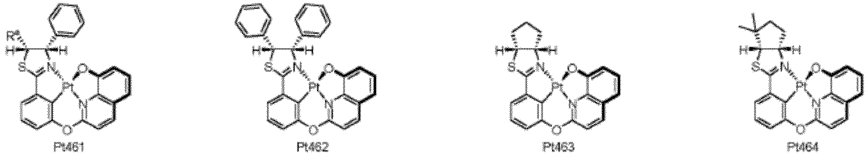

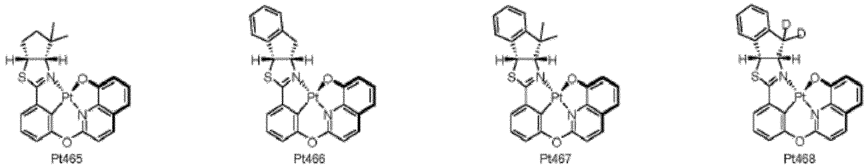

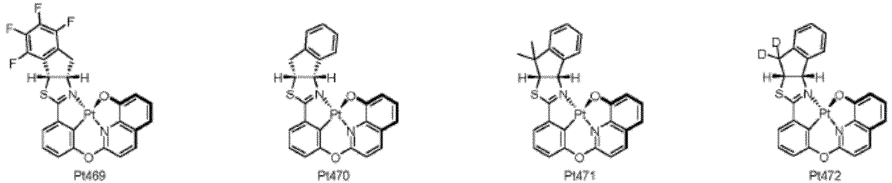

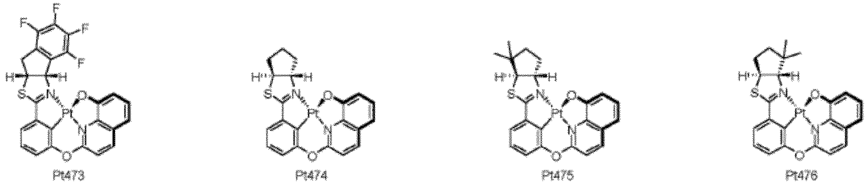

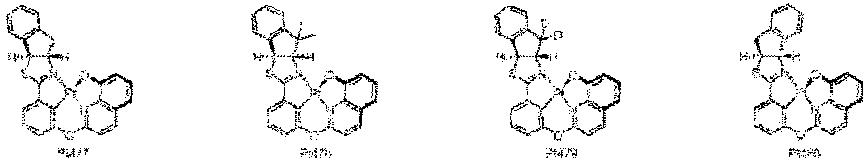

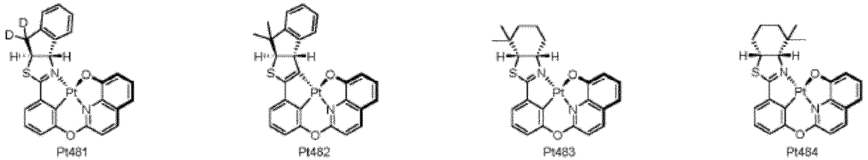

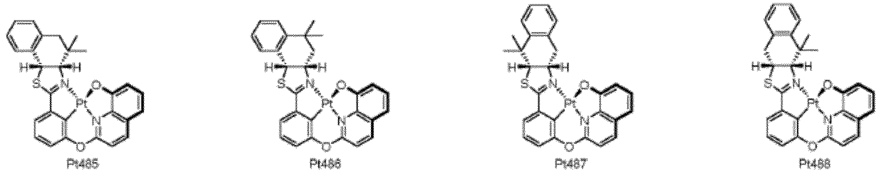

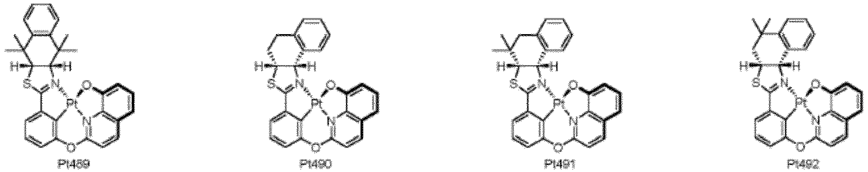

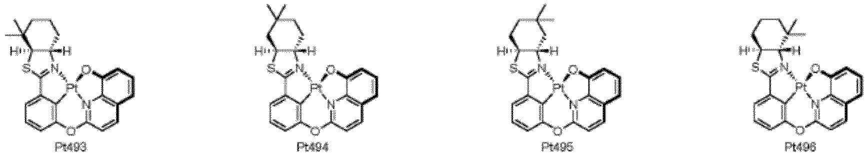

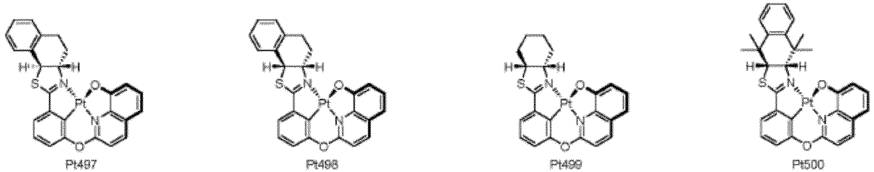

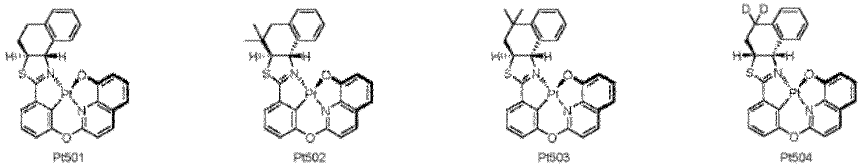

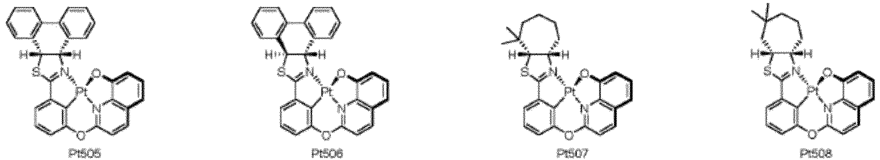

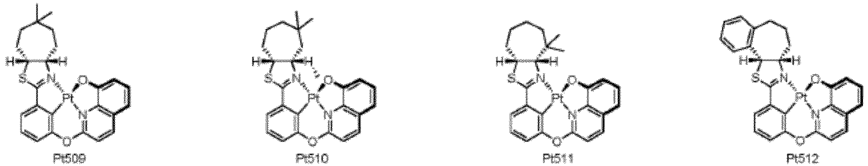

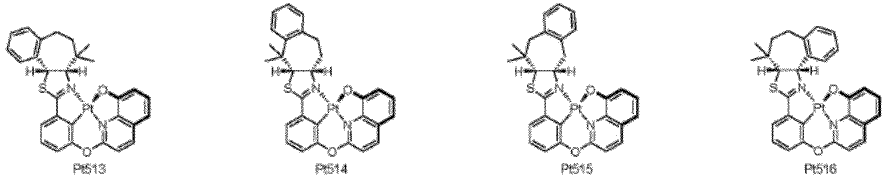

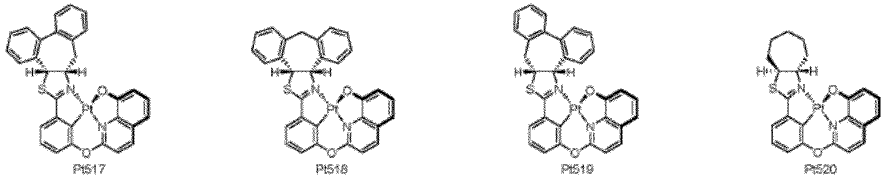

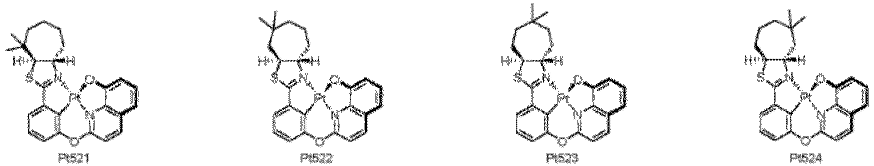

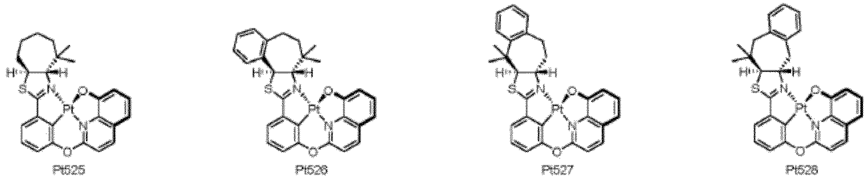

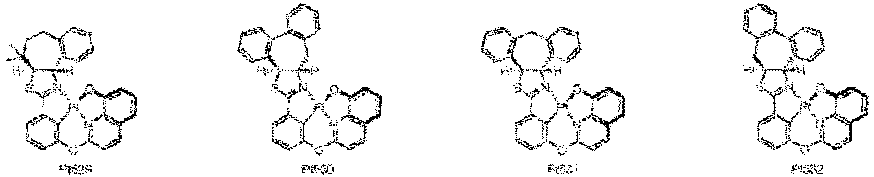

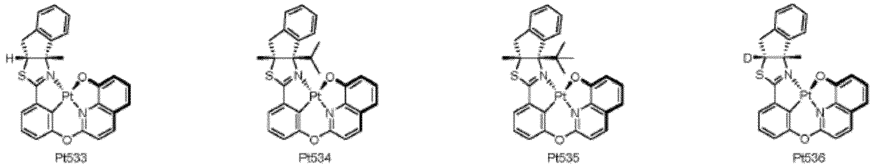

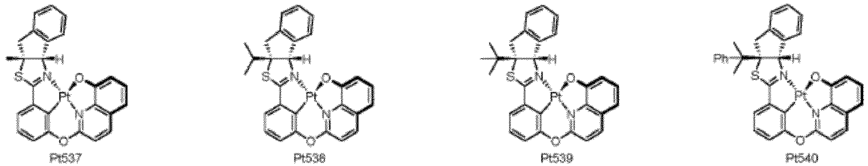

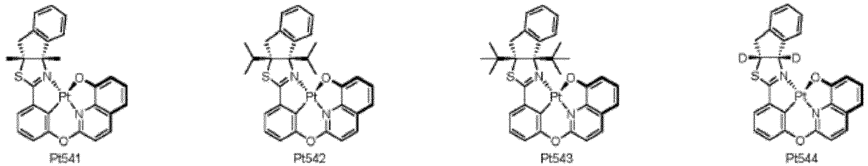

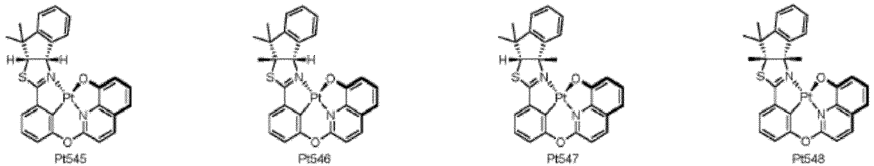

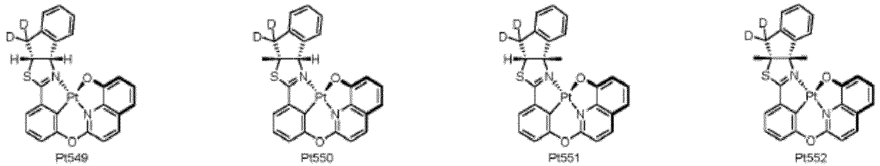

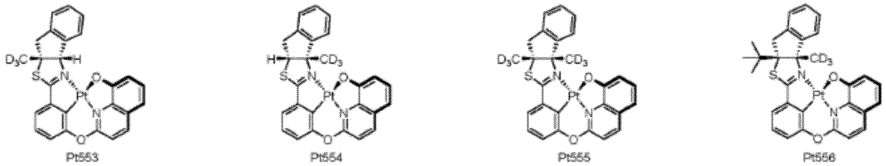

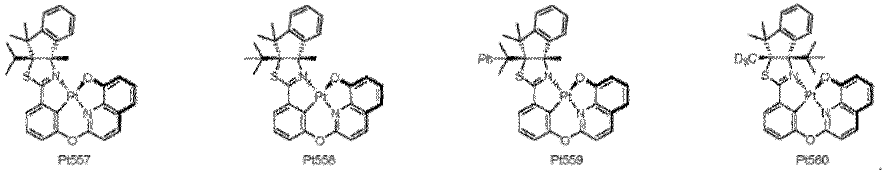

2. Durch eine zentrale Chiralität induzierter helikaler chiraler vierzähniger cyclometallierter Platin(II)-Komplex nach Anspruch 1, wobei der Komplex aus einer der folgenden Strukturen ausgewählt ist:

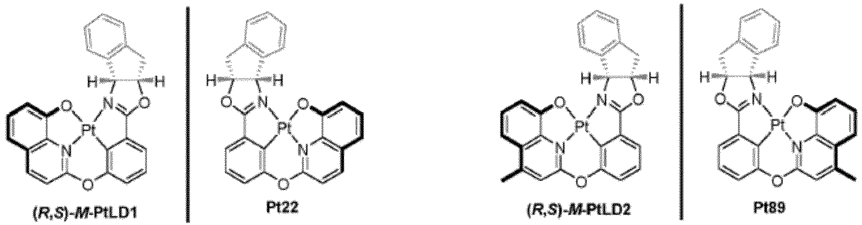

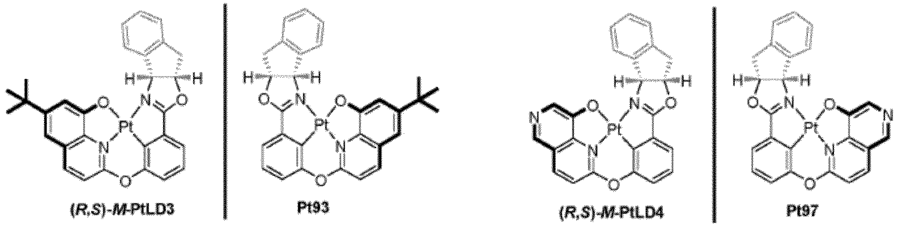

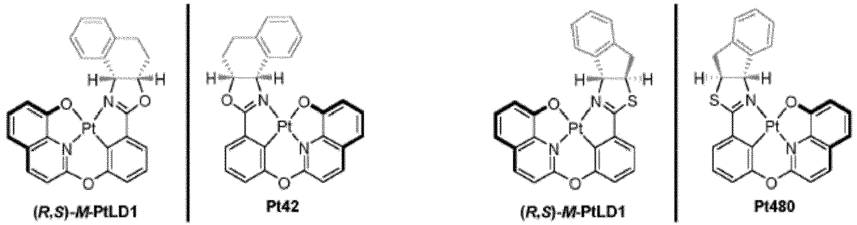

3. Anwendung des Komplexes nach Anspruch 1 oder Anspruch 2 in einer elektronischen Vorrichtung.

4. Anwendung nach Anspruch 3, wobei die elektronische Vorrichtung eine organische Elektrolumineszenzvorrichtung, eine organische Photolumineszenzvorrichtung, eine organische integrierte Schaltung, einen organischen Feldeffekttransistor, einen organischen Dünnschichttransistor, einen organischen lichtemittierenden Transistor, eine organische Solarzelle, einen organischen optischen Detektor, eine organische Field-Quench-Vorrichtung, eine lichtemittierende elektrochemische Zelle oder eine organische Laserdiode umfasst.

5. Elektronische Vorrichtung, umfassend den durch eine zentrale Chiralität induzierten helikalen chiralen vierzähnigen cyclometallierten Platin(II)-Komplex nach Anspruch 1 oder Anspruch 2.

6. Elektronische Vorrichtung nach Anspruch 5, wobei die elektronische Vorrichtung vorzugsweise aus einer organischen Elektrolumineszenzvorrichtung, einer organischen Photolumineszenzvorrichtung, einer organischen integrierten Schaltung, einem organischen Feldeffekttransistor, einem organischen Dünnschichttransistor, einem organischen lichtemittierenden Transistor, einer organischen Solarzelle, einem organischen optischen Detektor, einer organischen Field-Quench-Vorrichtung, einer lichtemittierenden elektrochemischen Zelle oder einer organischen Laserdiode ausgewählt ist.

7. Elektronische Vorrichtung nach Anspruch 5, wobei die elektronische Vorrichtung mindestens eine Kathode, mindestens eine Anode und eine organische Schicht zwischen der mindestens einen Anode und mindestens einer Kathode umfasst, wobei die organische Schicht eine lichtemittierende Schicht umfasst, die sich nur aus einer lichtemittierenden Schicht zusammensetzt oder mehr als eine andere organische Schicht abgesehen von der lichtemittierenden Schicht aufweist; wobei mindestens eine Schicht in der organischen Schicht den durch eine zentrale Chiralität induzierten helikalen chiralen vierzähnigen cyclometallierten Platin(II)-Komplex nach Anspruch 1 oder Anspruch 2 enthält.

8. Elektronische Vorrichtung nach Anspruch 5, wobei die elektronische Vorrichtung eine organische Elektrolumineszenzvorrichtung mit einer lichtemittierenden Schicht, die den durch eine zentrale Chiralität induzierten helikalen chiralen vierzähnigen cyclometallierten Platin(II)-Komplex nach Anspruch 1 oder Anspruch 2 enthält, und einem entsprechenden Wirtsmaterial ist, wobei ein Massenprozentanteil des Komplexes 1 % bis 50 % beträgt.

9. Zusammensetzung, umfassend den durch eine zentrale Chiralität induzierten helikalen chiralen vierzähnigen cyclometallierten Platin(II)-Komplex nach Anspruch 1 oder Anspruch 2.

10. Präparat, umfassend den durch eine zentrale Chiralität induzierten helikalen chiralen vierzähnigen cyclometallierten Platin(II)-Komplex nach Anspruch 1 oder Anspruch 2 oder mindestens eine Zusammensetzung nach Anspruch 9 und mindestens ein Lösungsmittel.

11. Anzeige- oder Beleuchtungsvorrichtung, umfassend eine oder mehrere der elektronischen Vorrichtung nach Anspruch 4.

## Revendications

1. Complexe de platine (II) cyclométalé tétradenté hélicoïdal induit par chiralité centrale, **caractérisé en ce que** le complexe est choisi parmi l'une des structures suivantes ou ses énantiomères :

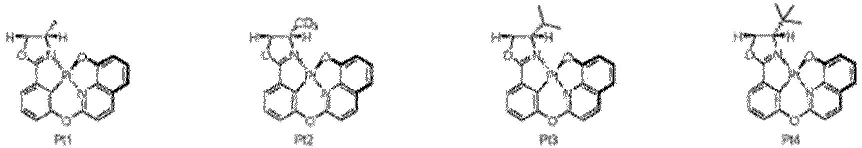

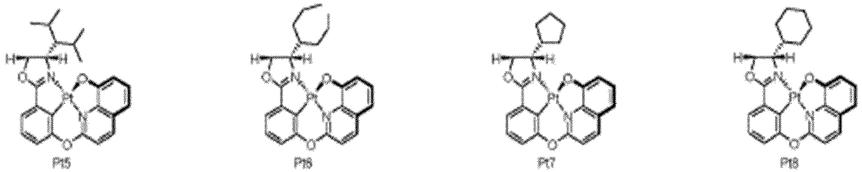

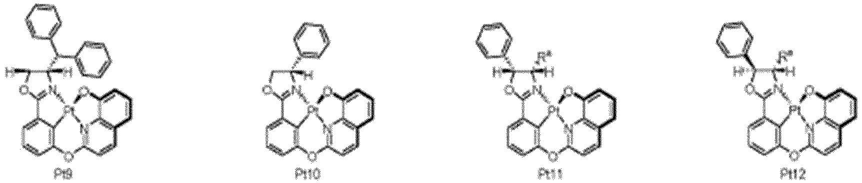

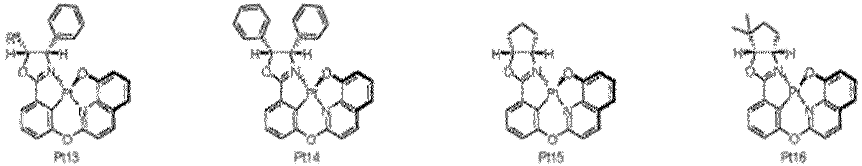

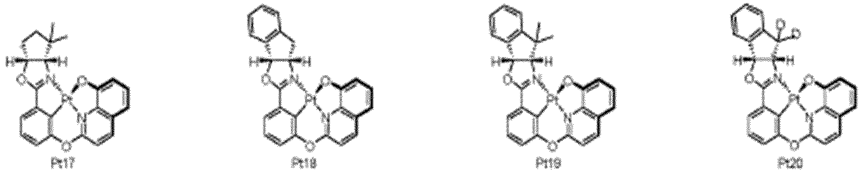

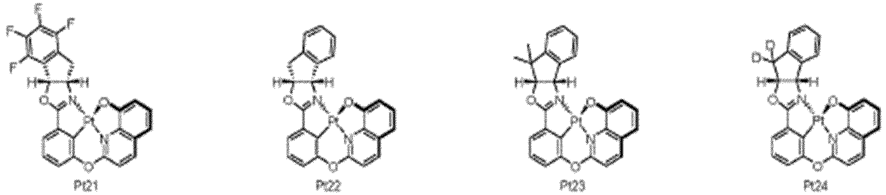

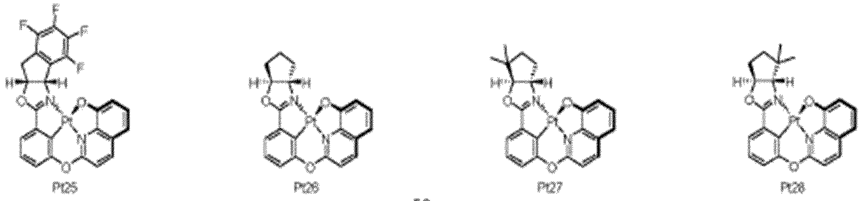

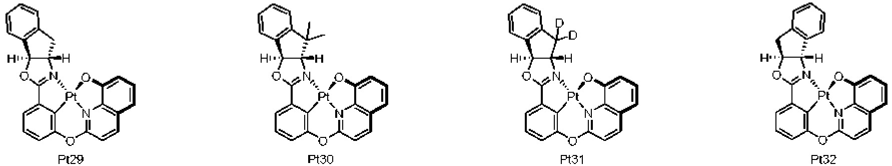

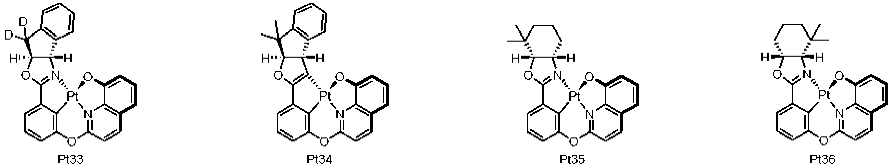

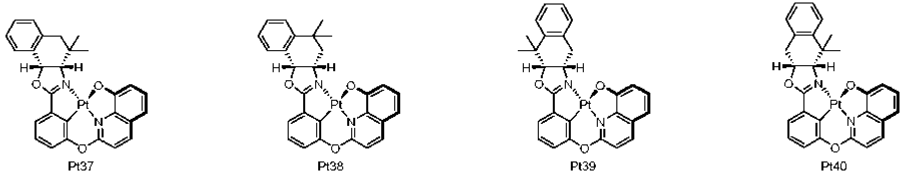

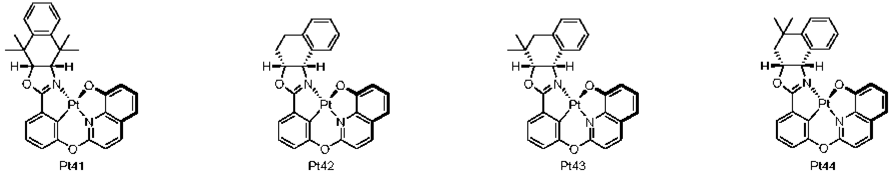

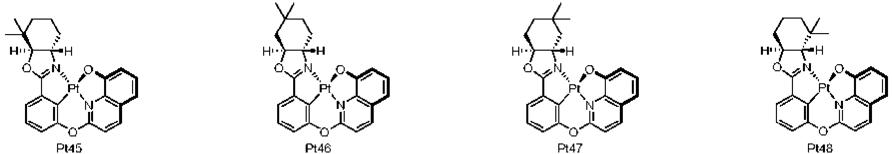

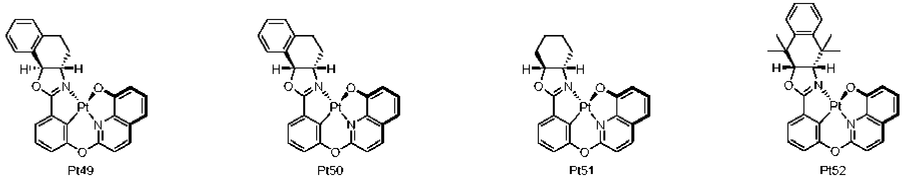

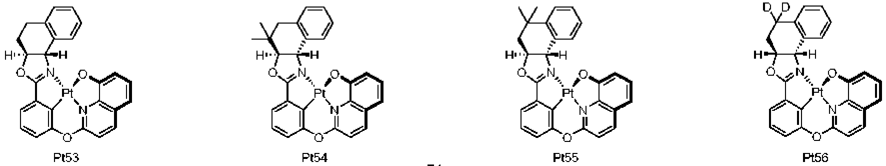

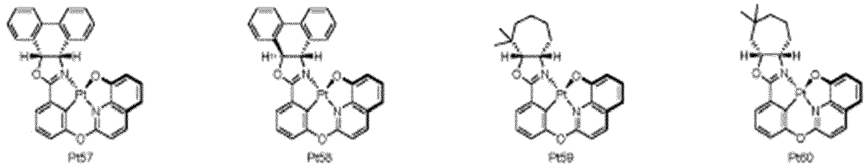

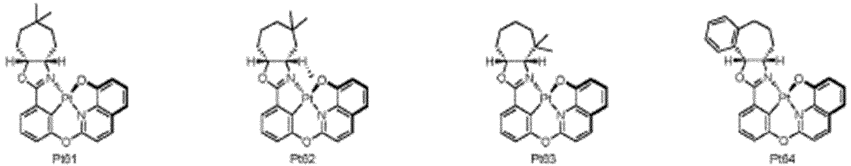

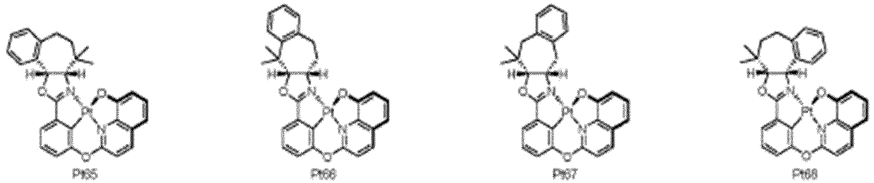

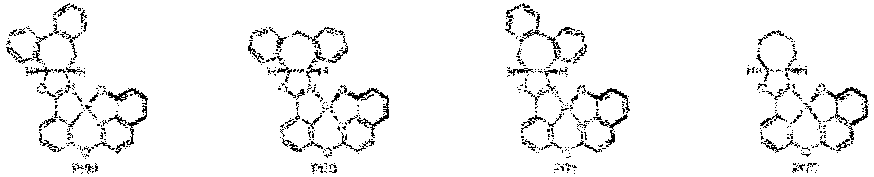

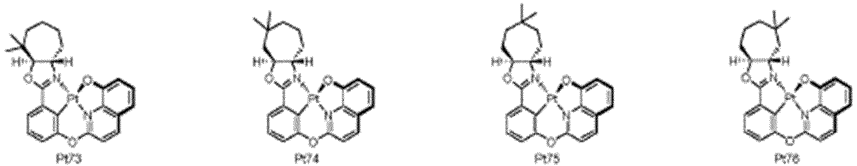

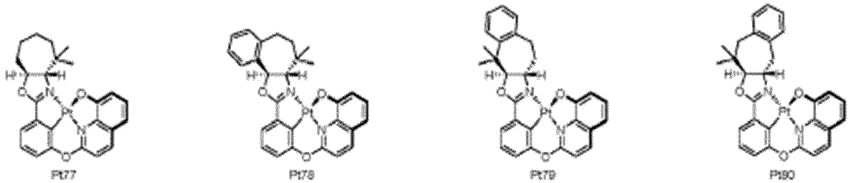

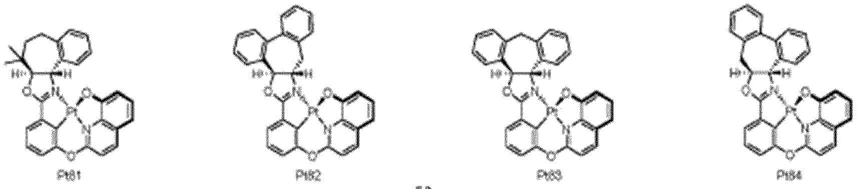

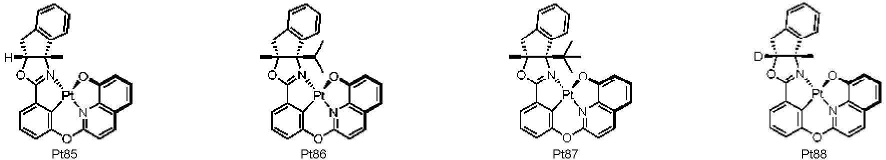

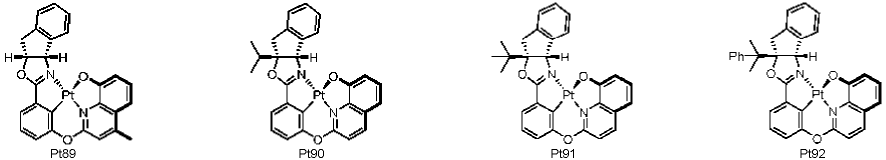

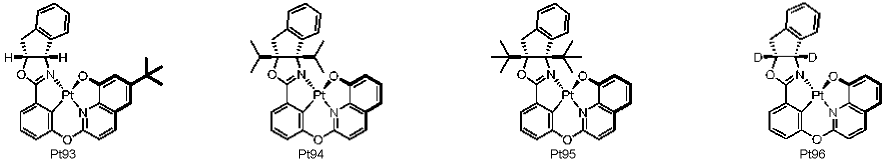

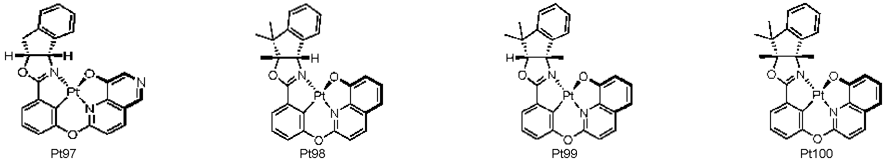

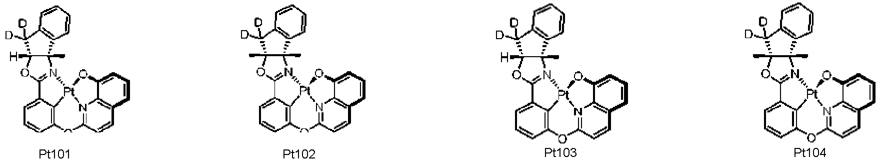

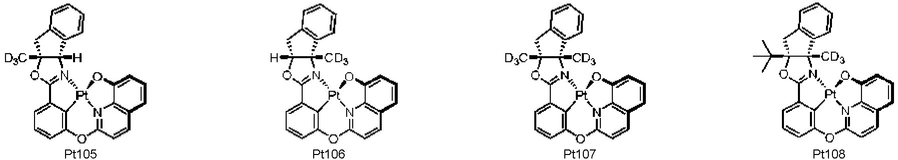

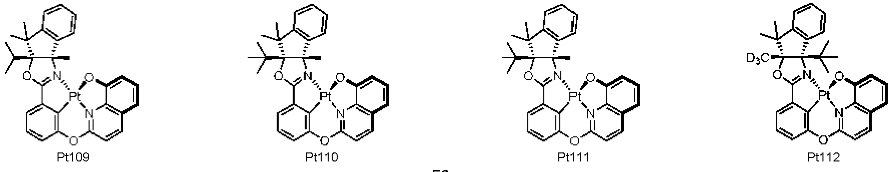

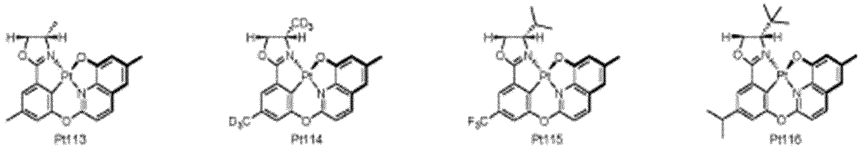

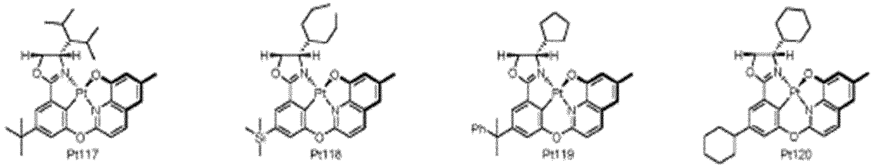

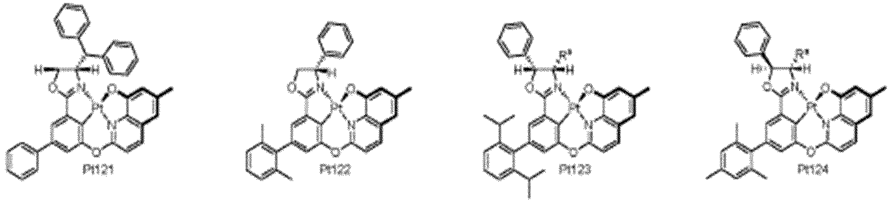

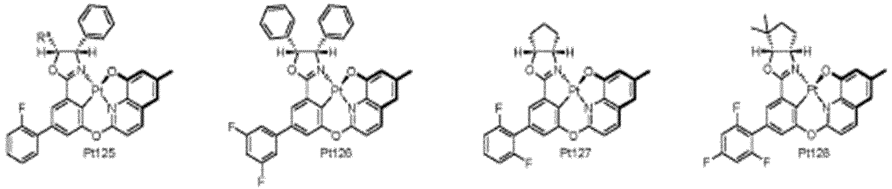

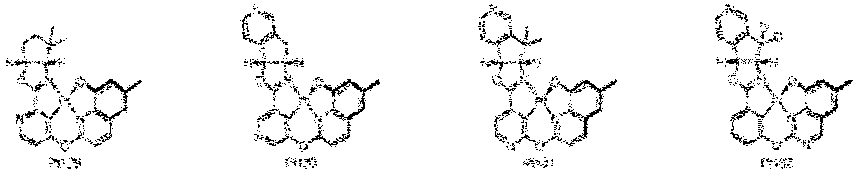

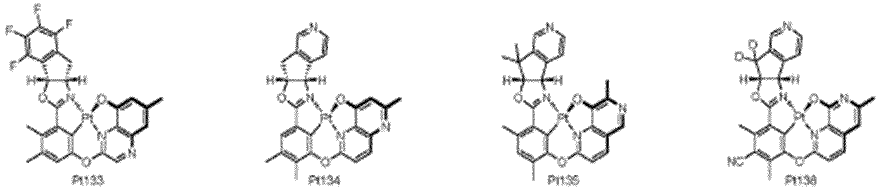

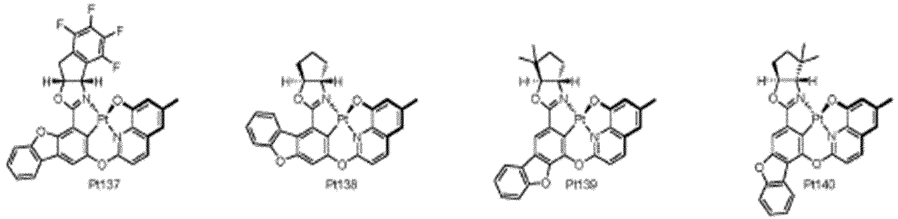

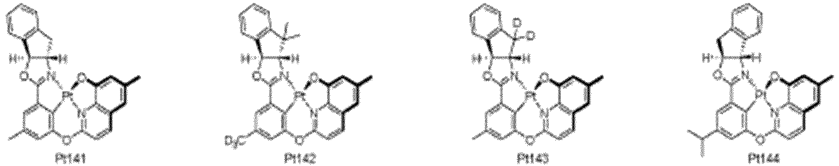

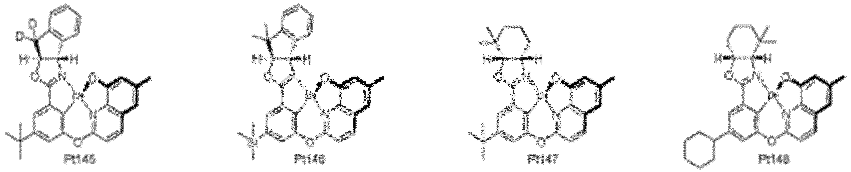

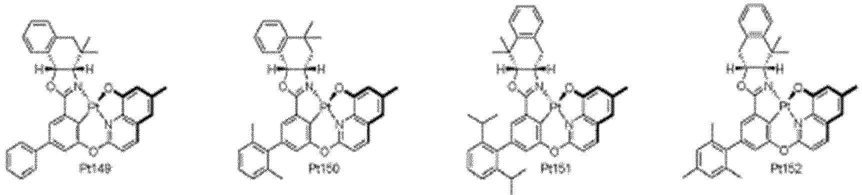

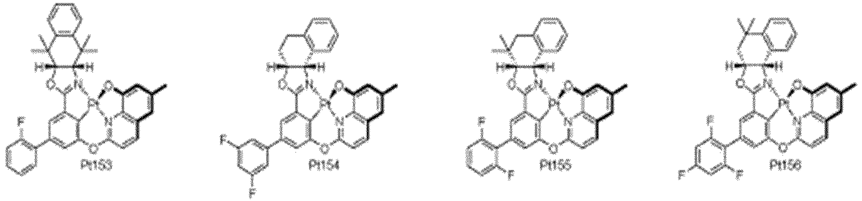

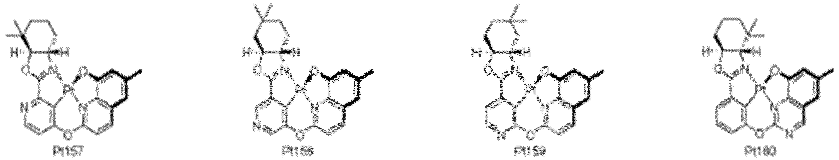

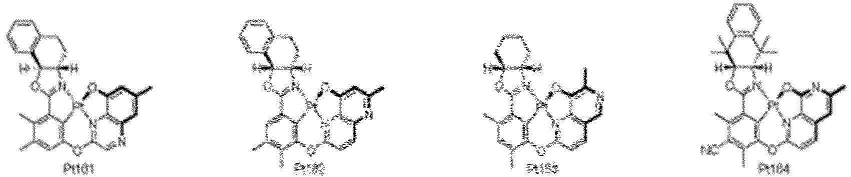

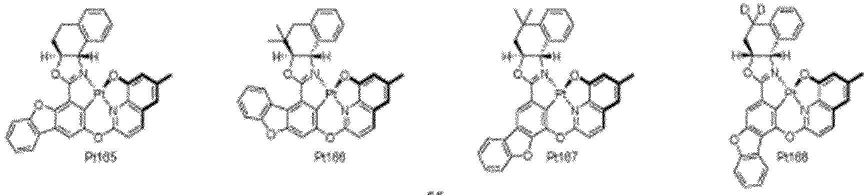

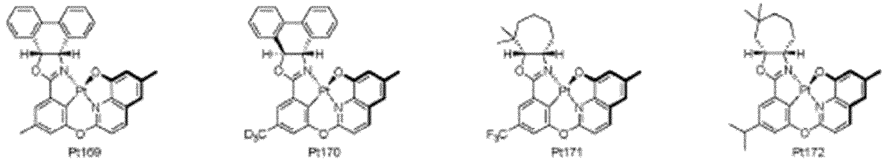

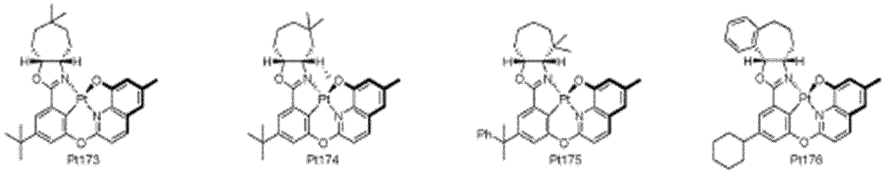

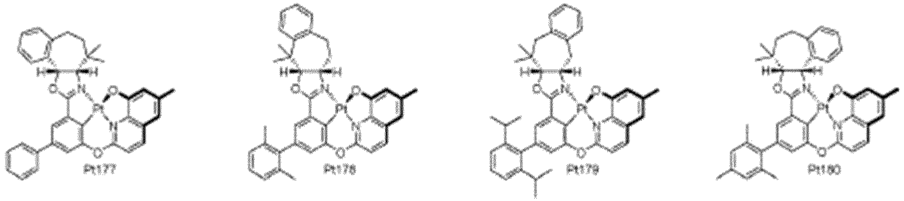

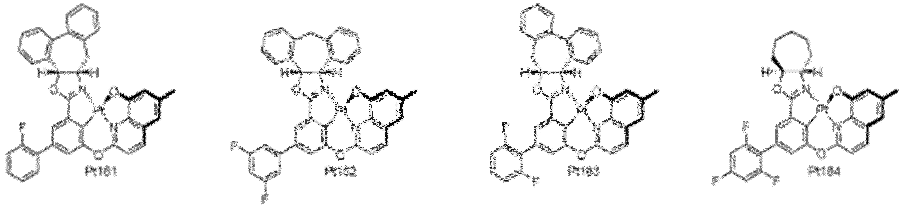

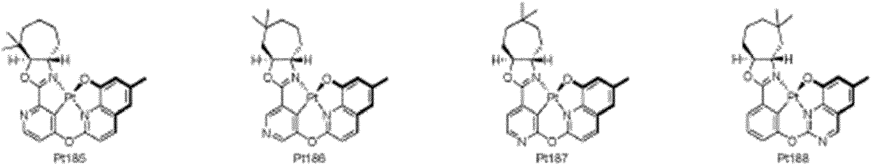

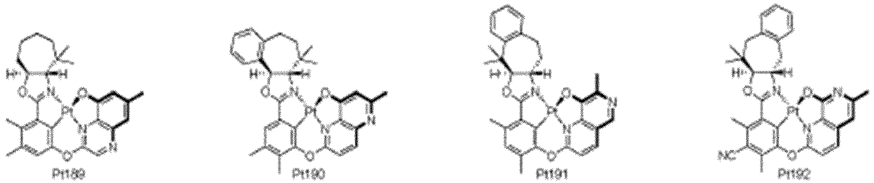

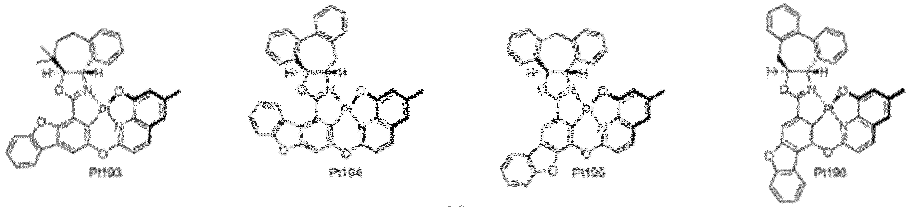

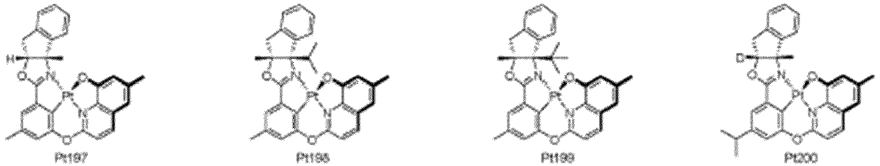

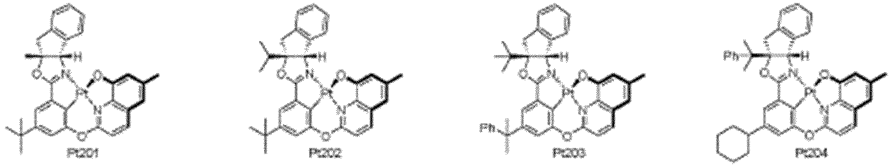

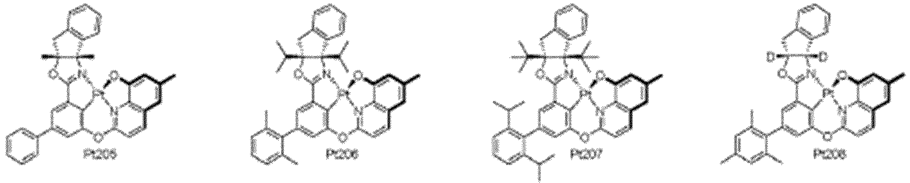

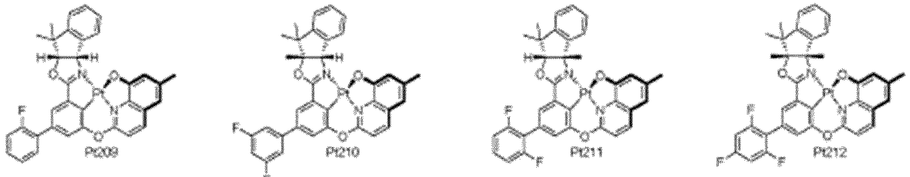

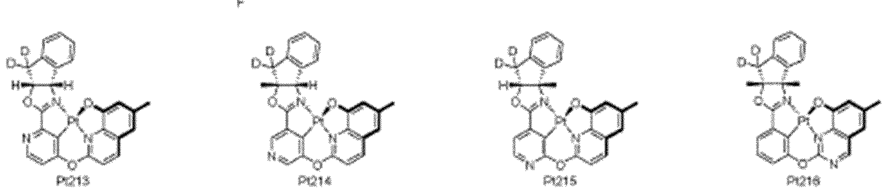

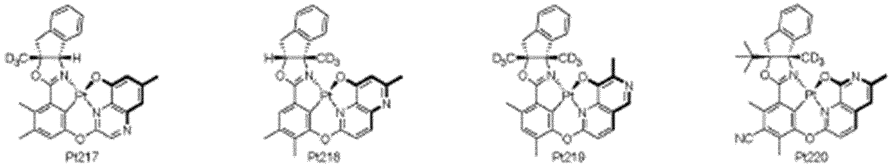

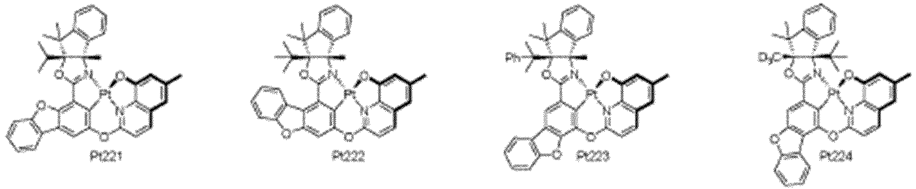

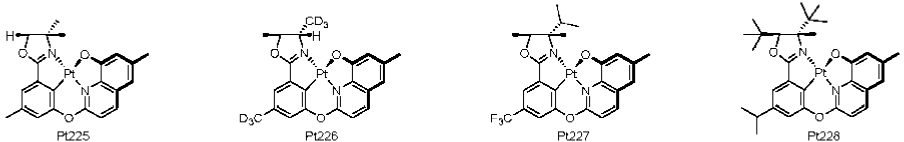

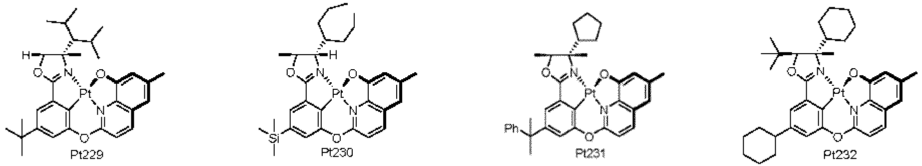

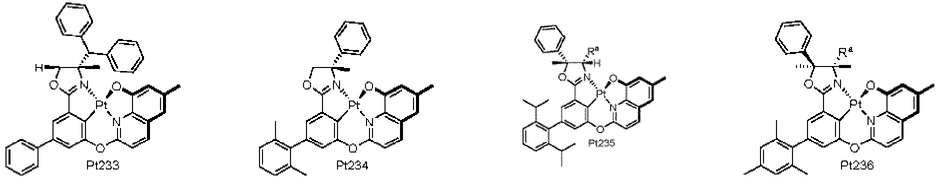

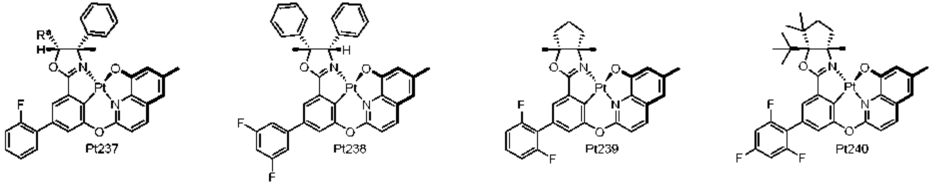

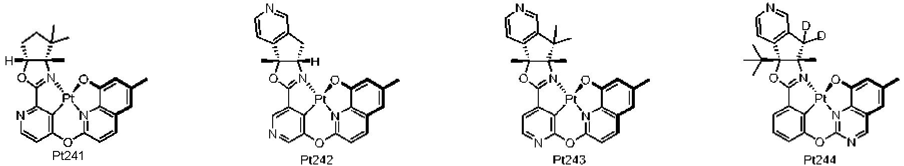

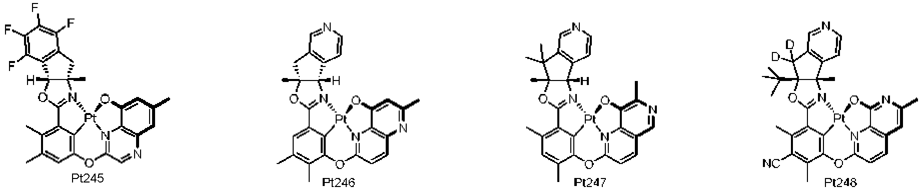

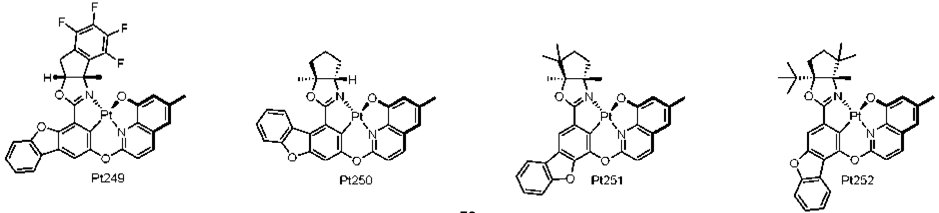

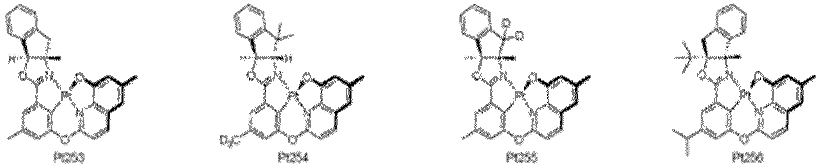

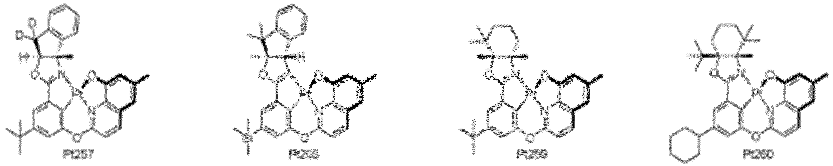

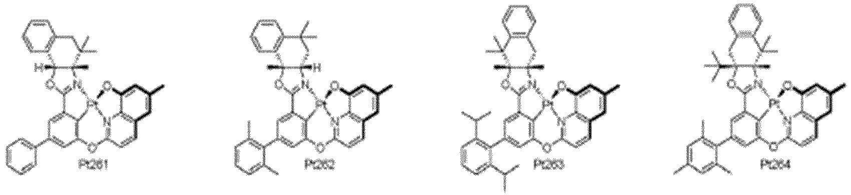

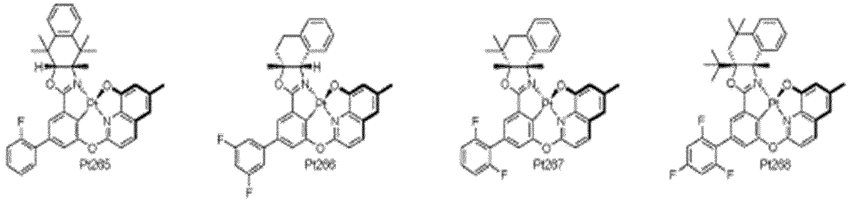

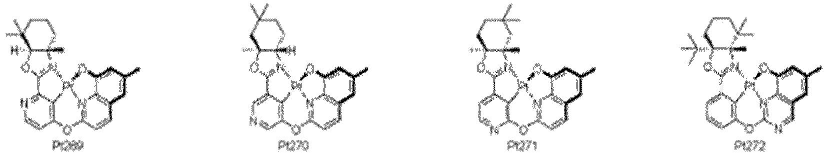

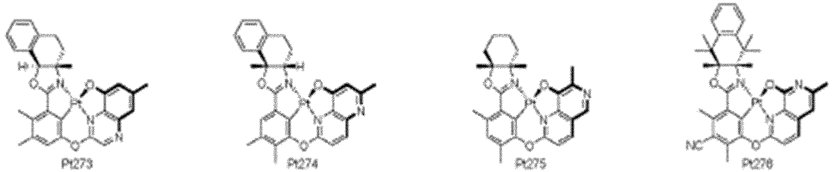

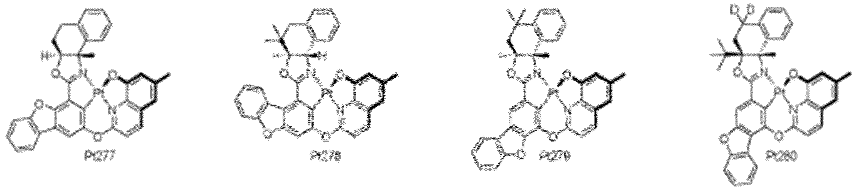

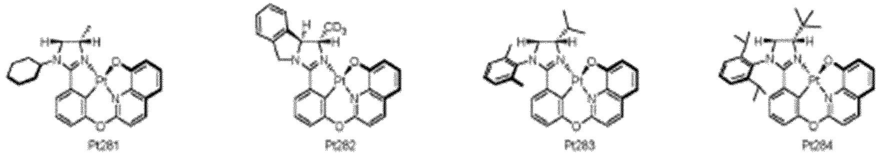

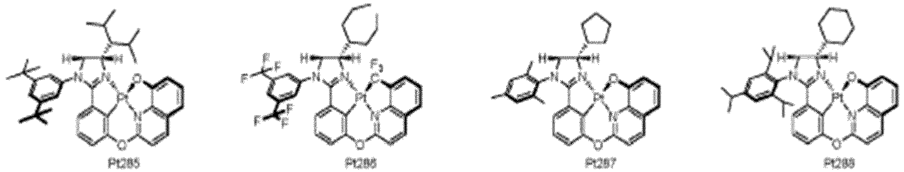

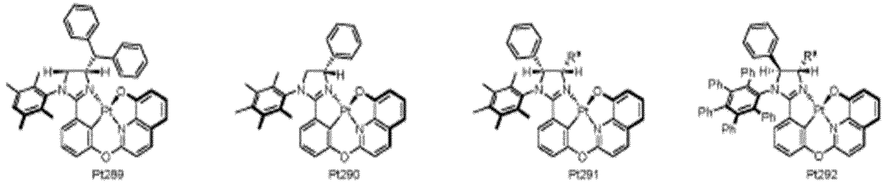

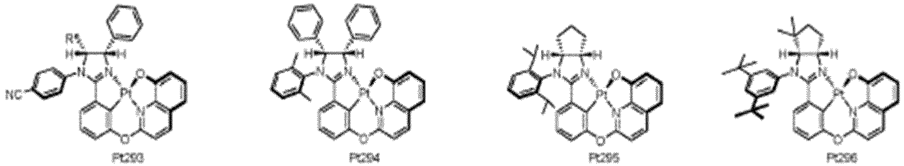

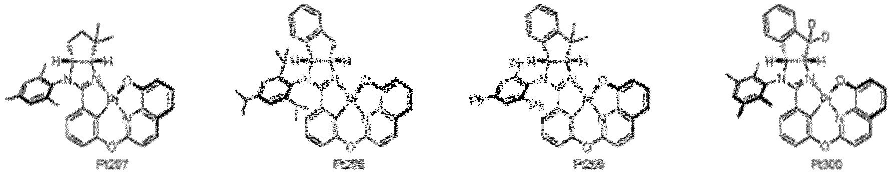

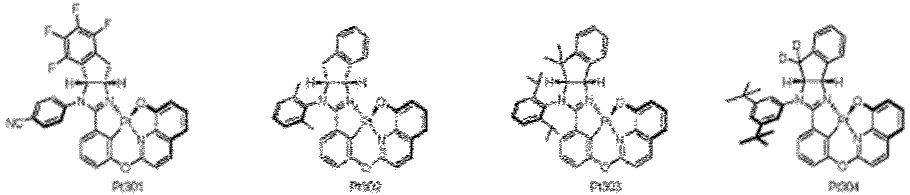

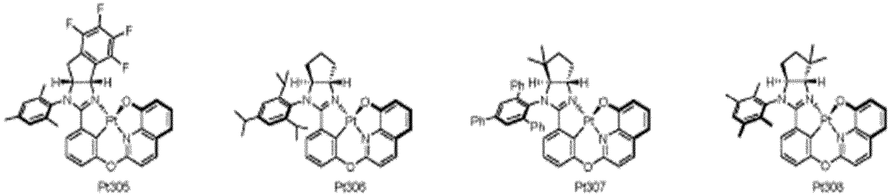

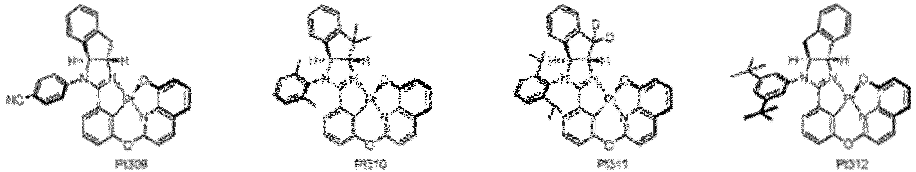

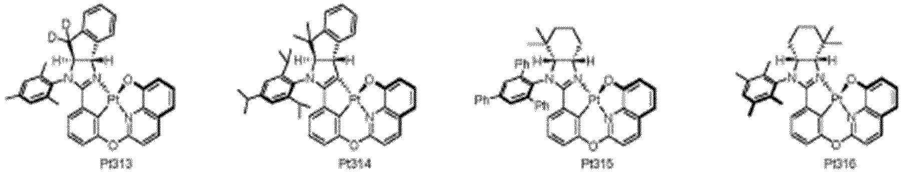

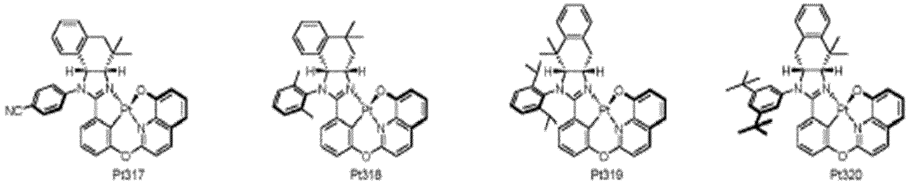

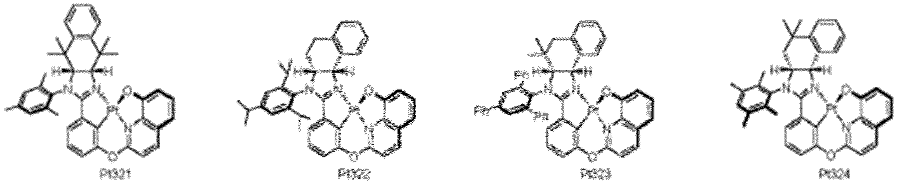

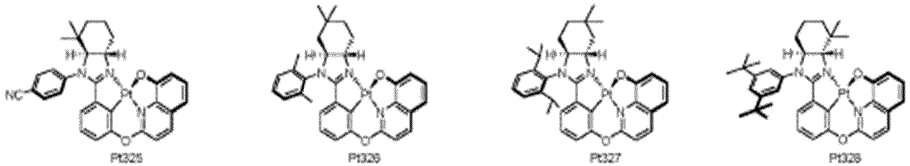

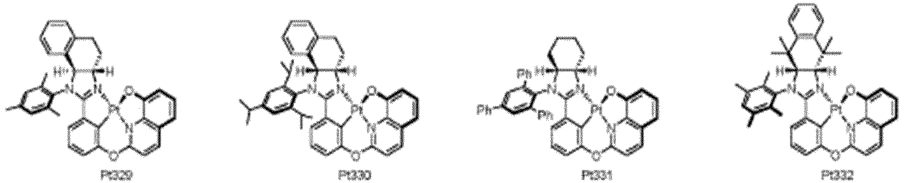

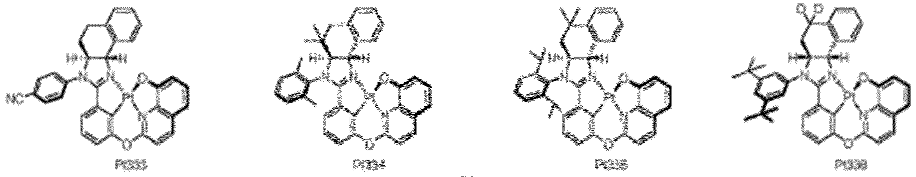

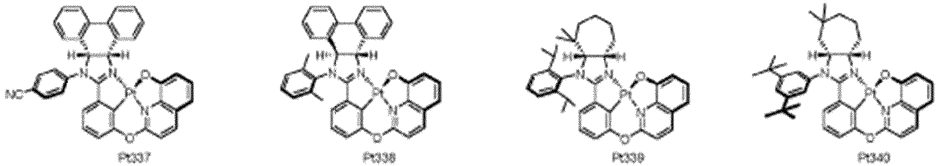

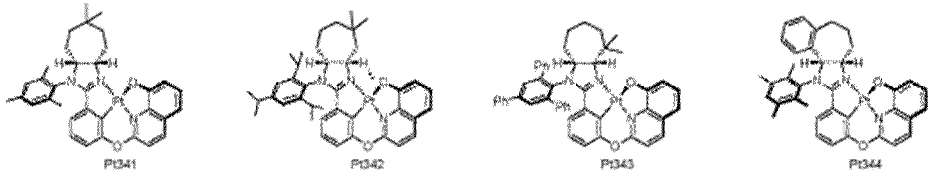

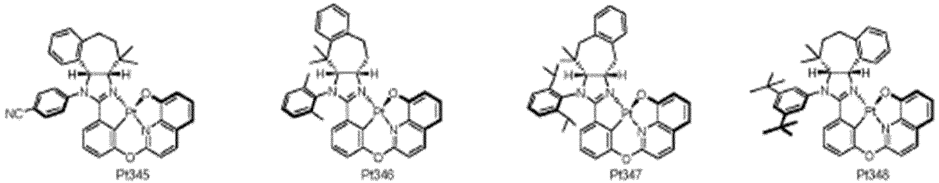

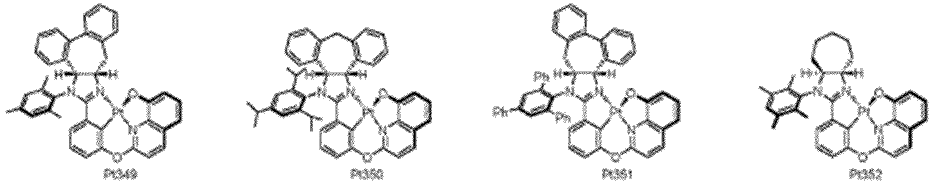

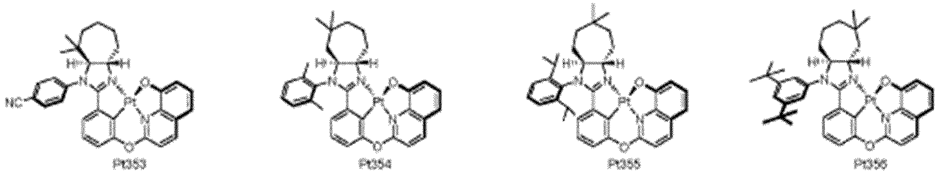

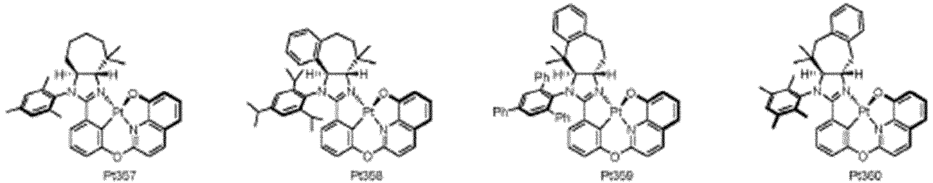

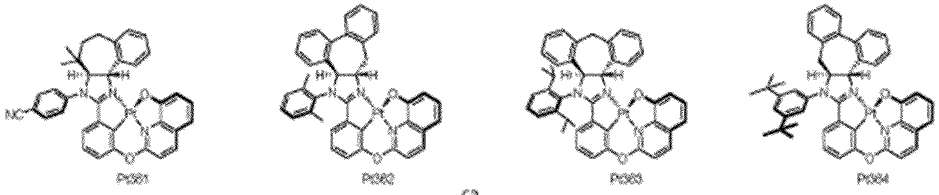

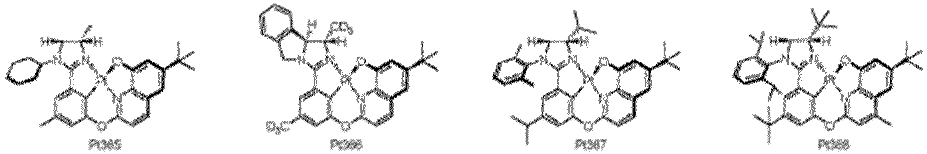

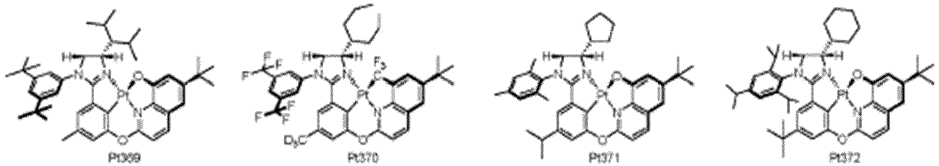

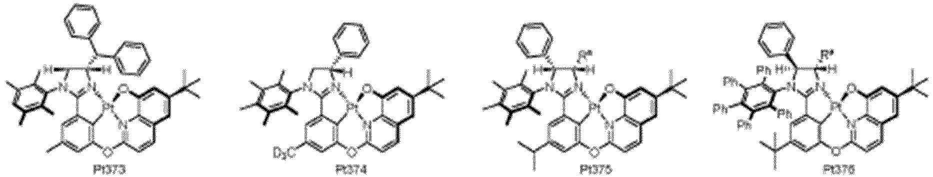

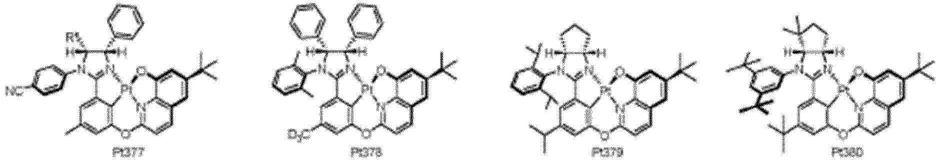

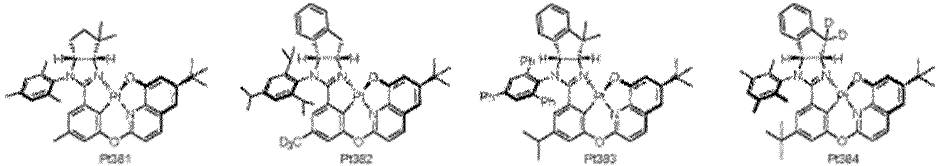

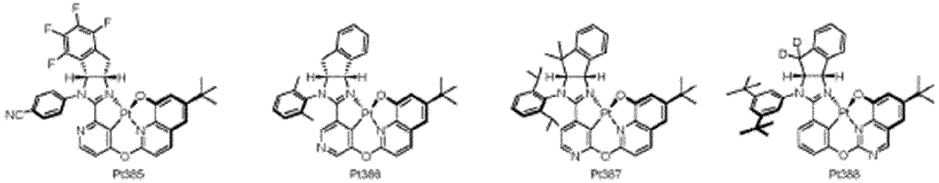

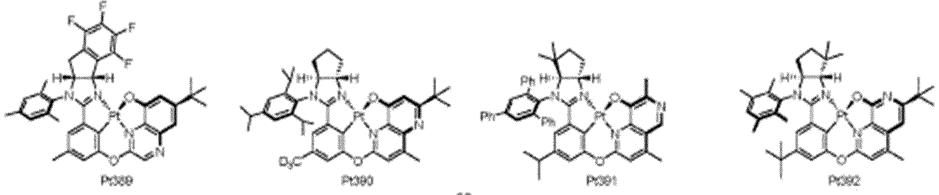

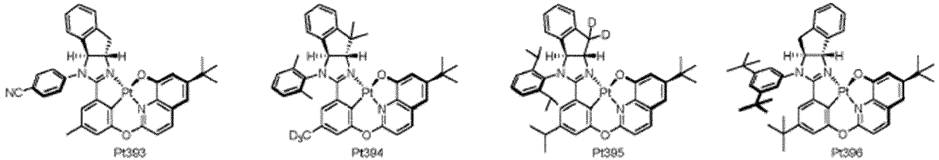

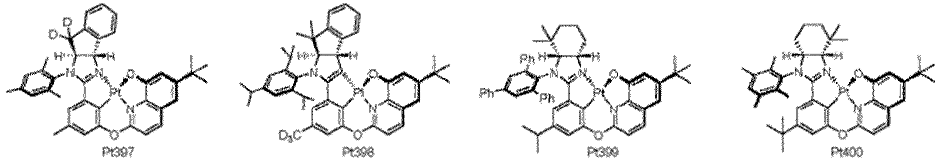

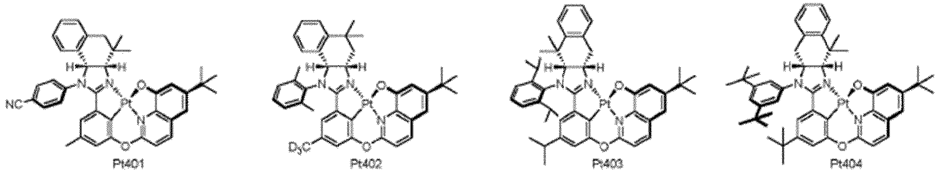

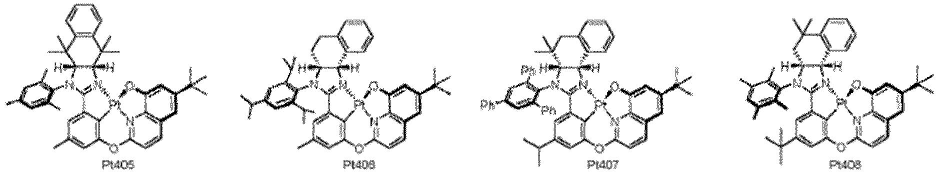

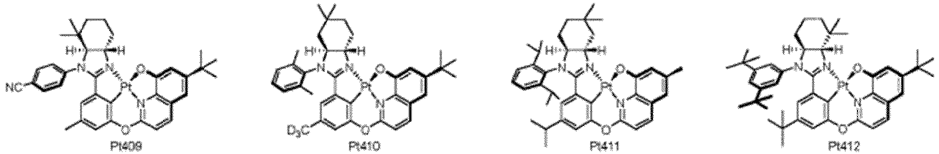

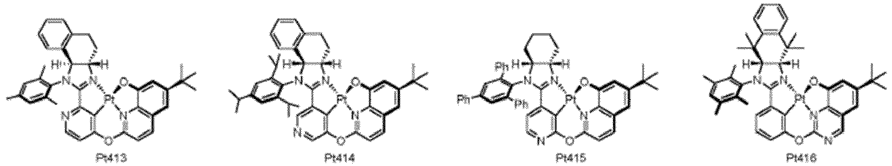

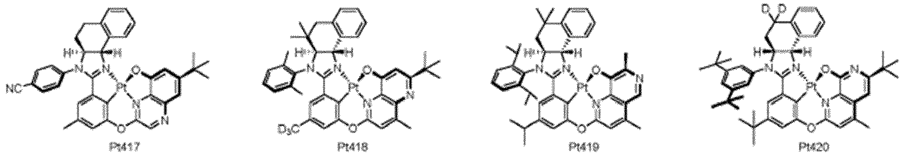

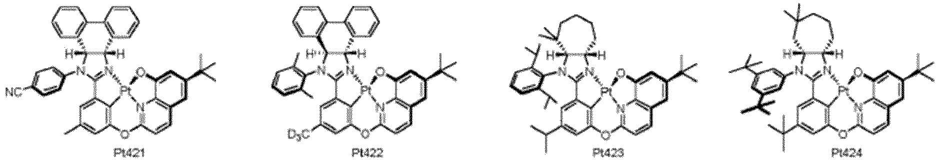

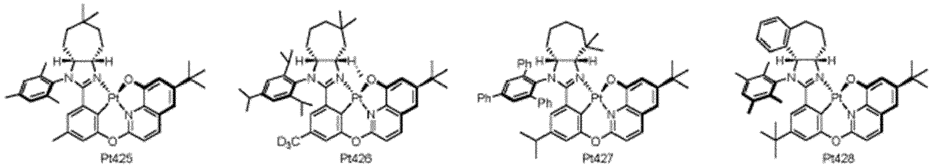

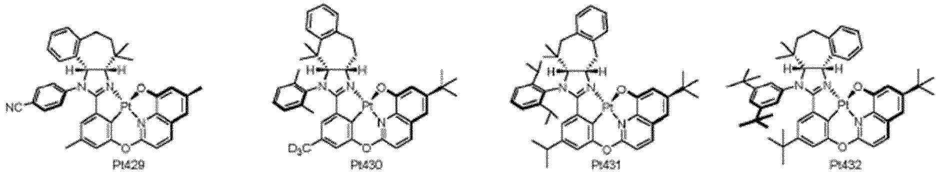

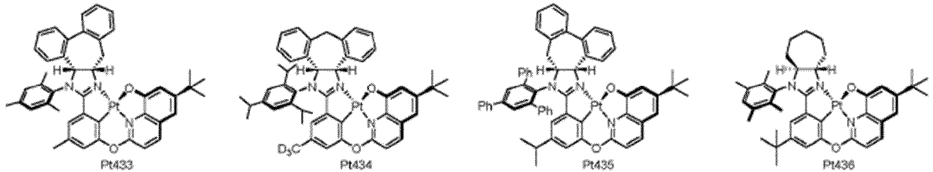

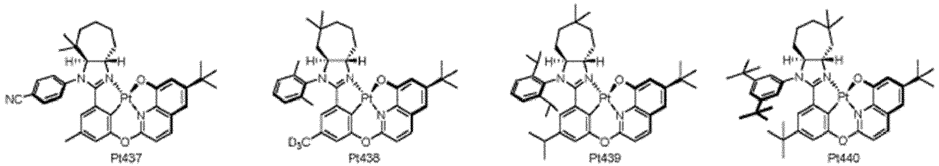

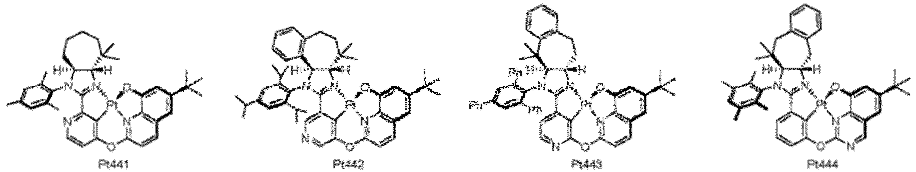

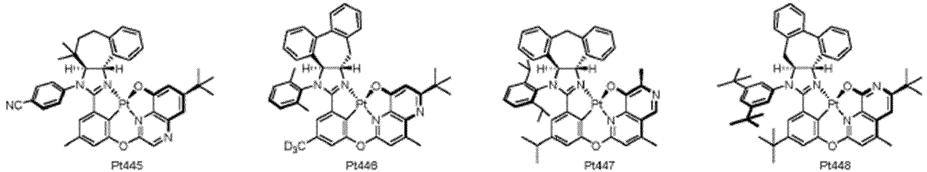

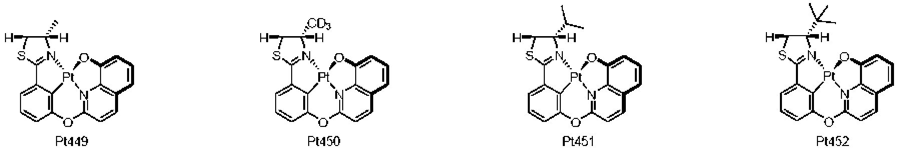

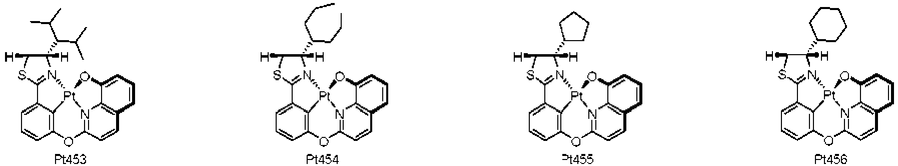

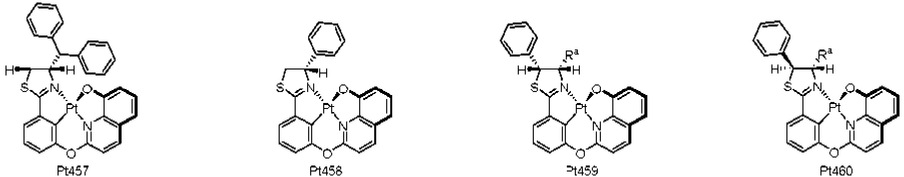

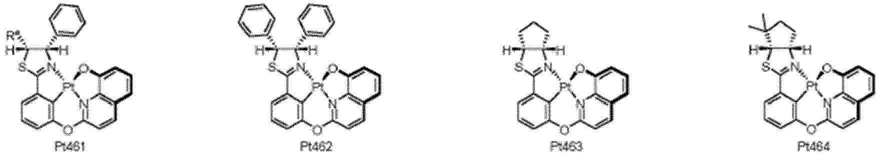

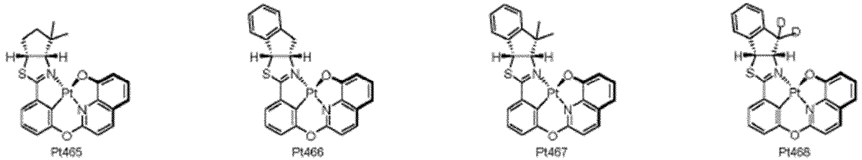

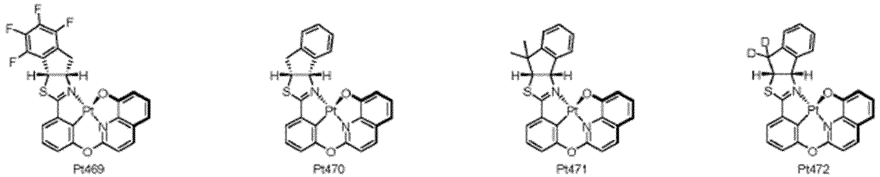

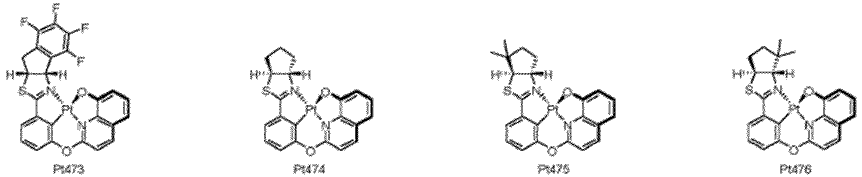

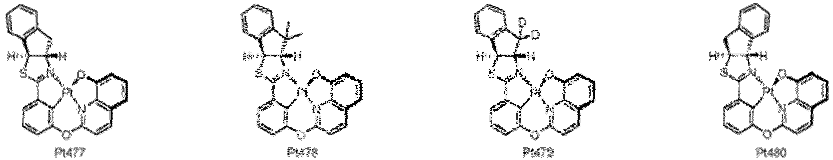

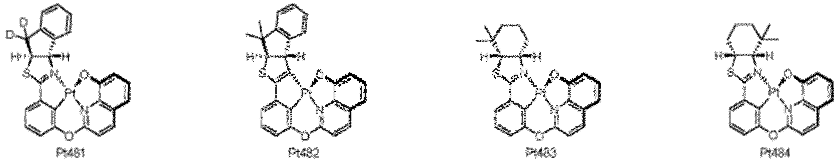

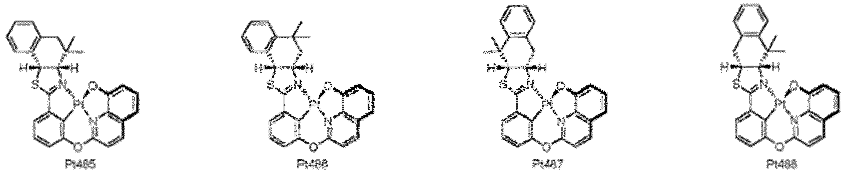

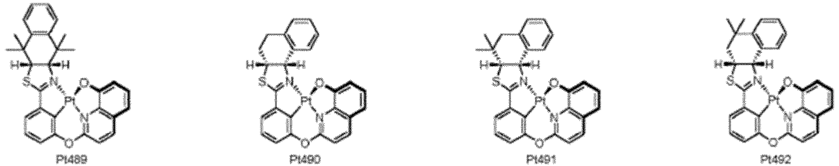

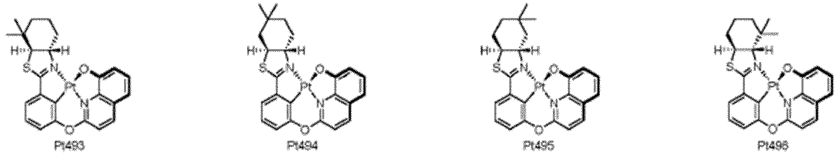

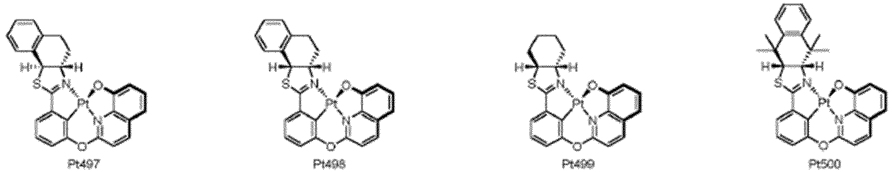

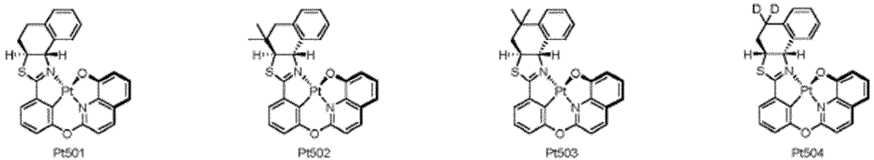

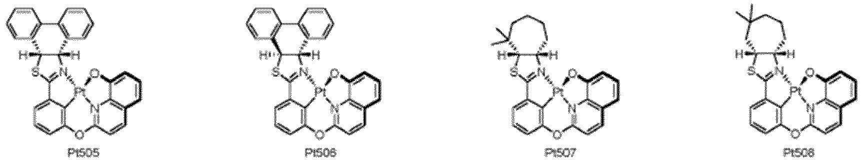

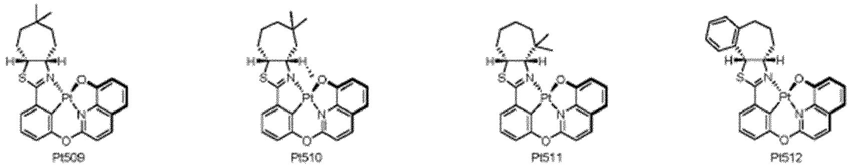

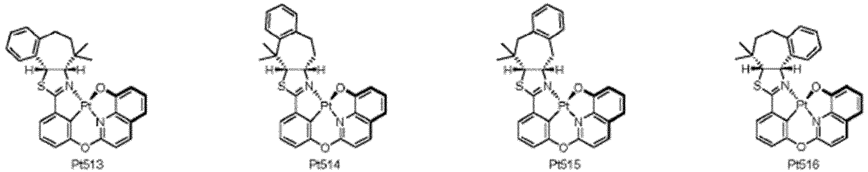

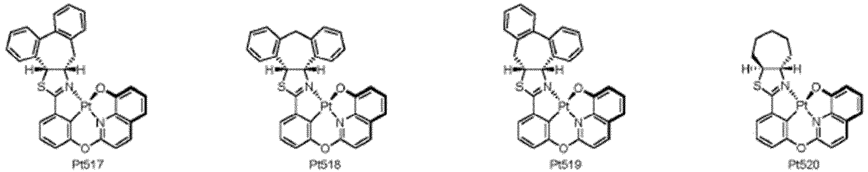

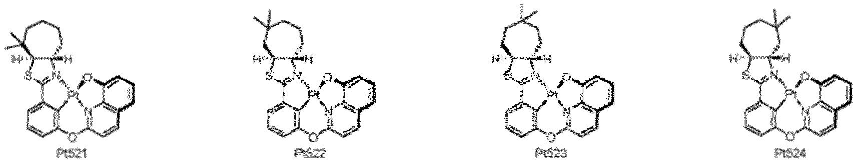

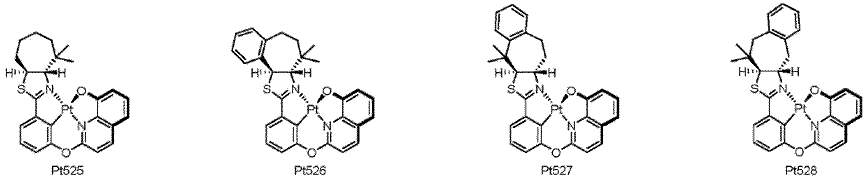

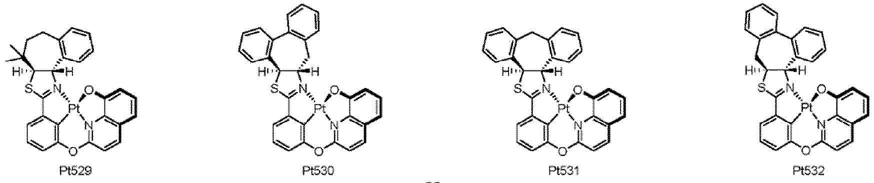

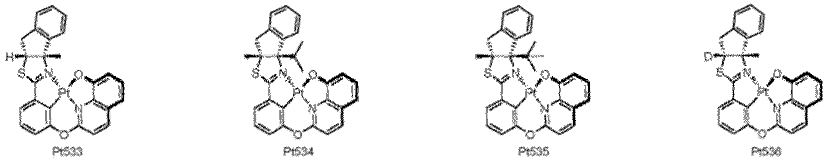

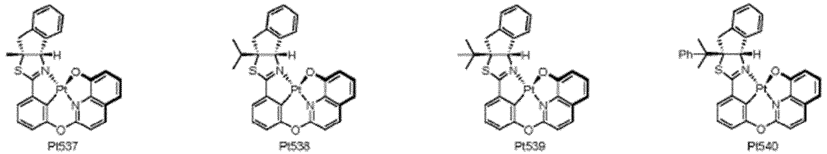

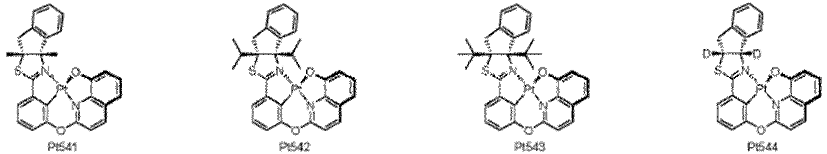

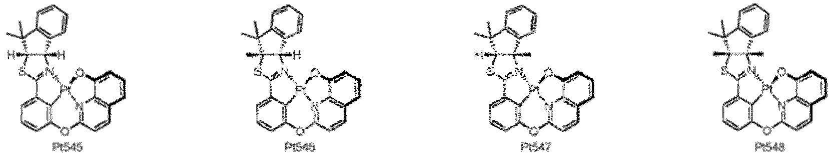

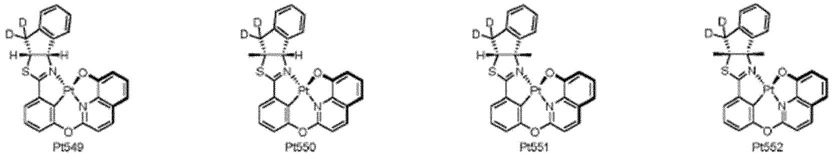

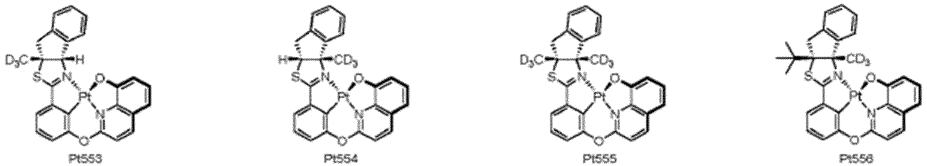

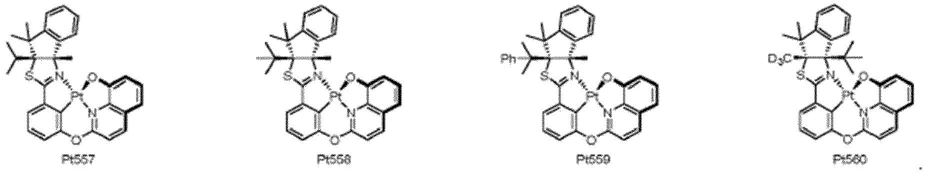

2. Complexe de platine (II) cyclométalé tétradenté hélicoïdal induit par chiralité centrale selon la revendication 1, **caractérisé en ce que** le complexe est choisi parmi l'une des structures suivantes :

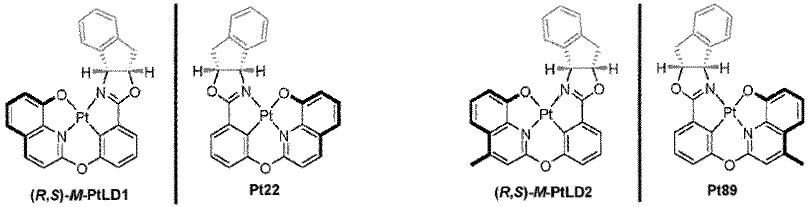

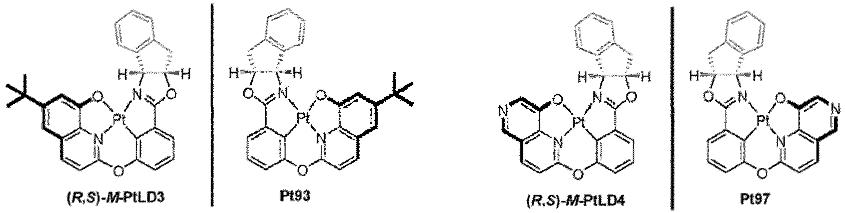

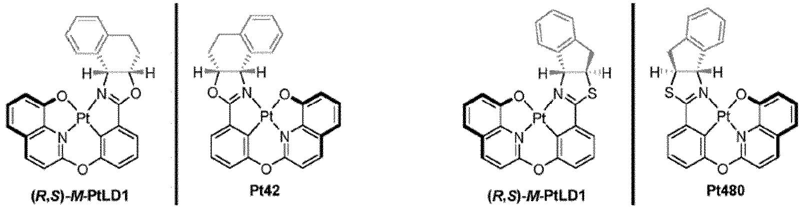

3. Application du complexe selon la revendication 1 ou la revendication 2 dans un dispositif électronique.

4. Application selon la revendication 3, **caractérisée en ce que** le dispositif électronique comprend une substance organique, un dispositif électroluminescent, un dispositif de photoluminescence organique, un circuit intégré organique, un transistor à effet de champ organique, un transistor organique à couches minces, un transistor électroluminescent organique, une cellule solaire organique, un détecteur optique organique, un dispositif d'extinction de champ organique, une cellule électrochimique électroluminescente ou une diode laser organique.

5. Dispositif électronique comprenant le complexe de platine (II) cyclométalé tétradenté chiral hélicoidal induit par chiralité centrale selon la revendication 1 ou la revendication 2.

6. Dispositif électronique selon la revendication 5, **caractérisé en ce que** le dispositif électronique est de préférence choisi parmi un dispositif électroluminescent organique, un dispositif de photoluminescence organique, un circuit intégré organique, un transistor à effet de champ organique, un transistor organique à couches minces, un transistor électroluminescent organique, une cellule solaire organique, un détecteur optique organique, un dispositif d'extinction de champ organique, une cellule électrochimique électroluminescente ou une diode laser organique.

7. Dispositif électronique selon la revendication 5, **caractérisé en ce que** le dispositif électronique comprend au moins une cathode, au moins une anode et une couche organique entre l'anode et au moins une cathode, la couche organique comprenant une couche électroluminescente composée uniquement d'une couche électroluminescente ou comportant plus d'une autre couche organique en plus de la couche électroluminescente ; au moins une couche dans la couche organique comprenant le complexe de platine (II) cyclométalé tétradenté chiral hélicoidal induit par chiralité centrale selon la revendication 1 ou la revendication 2.

8. Dispositif électronique selon la revendication 5, **caractérisé en ce que** le dispositif électronique est un dispositif électroluminescent organique, comportant une couche électroluminescente contenant le complexe de platine (II) tétradenté chiral hélicoïdal induit par chiralité centrale selon la revendication 1 ou la revendication 2 et un matériau hôte correspondant, avec un pourcentage massique du complexe compris entre 1 % et 50 %.

9. Composition comprenant le platine cyclométalé tétradenté chiral hélicoïdal induit par la chiralité centrale (II) complexe selon la revendication 1 ou la revendication 2.

10. Préparation comprenant le complexe de platine (II) cyclométalé tétradenté hélicoïdal induit par chiralité centrale selon la revendication 1 ou la revendication 2 ou au moins une composition selon la revendication 9, et au moins un solvant.

11. Dispositif d'affichage ou d'éclairage, comprenant un ou plusieurs des dispositifs électroniques selon la revendication 4.
